(19) Europäisches Patentamt
European Patent Office
Office européen des brevets

(11) Veröffentlichungsnummer: **0 214 103**
**B1**

(12) **EUROPÄISCHE PATENTSCHRIFT**

(45) Veröffentlichungstag der Patentschrift: **27.06.90**

(51) Int. Cl.$^5$: **G 03 F 7/038**

(21) Anmeldenummer: **86810389.6**

(22) Anmeldetag: **29.08.86**

(54) **Geklebte photostrukturierbare Polyimidfolie.**

(30) Priorität: **04.09.85 CH 3809/85**
**25.10.85 CH 4607/85**

(43) Veröffentlichungstag der Anmeldung:
**11.03.87 Patentblatt 87/11**

(45) Bekanntmachung des Hinweises auf die Patenterteilung:
**27.06.90 Patentblatt 90/26**

(84) Benannte Vertragsstaaten:
**BE CH DE FR GB IT LI NL SE**

(56) Entgegenhaltungen:
**EP-A-0 092 524**
**EP-A-0 100 736**
**EP-A-0 134 752**
**EP-A-0 141 781**
**EP-A-0 182 745**
**EP-A-0 203 393**
**DE-A-2 658 422**
**DE-A-3 007 445**
**FR-A-2 376 447**
**FR-A-2 496 111**
**US-A-4 506 004**

(73) Patentinhaber: **CIBA-GEIGY AG**
**Klybeckstrasse 141**
**CH-4002 Basel (CH)**

(72) Erfinder: **Rohde, Ottmar, Dr.**
**Bärenfelserstrasse 34**
**CH-4057 Basel (CH)**
Erfinder: **Schaffner, Armin**
**Hegenheimerstrasse 106**
**CH-4055 Basel (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 214 103 B1**

Courier Press, Leamington Spa, England.

**Beschreibung**

Die vorliegende Erfindung betrifft ein beschichtetes Material enthaltend auf einem Substrat einen photovernetzbaren thermostabilen Kleber und darauf eine photovernetzbare Polyimidfolie, ein Verfahren zur Herstellung von Reliefabbildungen mittels solcher Beschichtungen, die somit erhaltenen Reliefabbildungen und die Verwendung dieser Abbildungen als Schutz- und Passivierschichten, als Dielektrika, als Lötstopmasken oder als Galvanoresists bei der Fertingung elektronischer Bauteile oder Schaltungen.

Polyimide sind bekannterweise sehr temperaturstabile und chemisch inerte Verbindungen. Sie sind für die Herstellung von elektronischen Bauteilen von grossem Interesse, da einige dieser Fertigungsschritte bei hohen Temperaturen durchgeführt werden müssen.

In jüngerer Zeit wurden in polaren organischen Lösungsmitteln lösliche und gleichzeitig photovernetzbare Polyimide entwickelt. Damit konnten die Anwendungsmöglichkeiten von Polyimiden in der photolithographischen Technik entscheidend erweitert werden. So ist es nun möglich, Substratoberflächen mit Lösungen vollständig imidisierter Polyimide zu behandeln, und diese Beschichtungen mittels üblicher photolithographischer Verfahren direkt in Reliefbilder umzuwandeln.

Solche Polyimide werden in den EP—A 92 524, EP—A 134 752 und EP—A 141 781 beschrieben.

Das dabei verwendete Beschichtungsverfahren lässt aber noch einige Wünsche offen. So werden beispielsweise bei der Herstellung dicker Polymerschichten relativ grosse Mengen an Lösungsmitteln durch Verdampfen friegestzt, was aus gewerbehygienischen Gründen unerwünscht ist. Ausserdem wird beispielsweise bei einer Auftragung durch Spin-Coating oder durch Curtain-Coating die Schichtdicke durch die Viskosität der aufzutragenden Lösung und durch maschinelle Parameter, wie Umdrehungsgeschwindigkeit und Durchlaufgeschwindigkeit, beeinflusst, so dass diese Parameter bei der Beschichtung beachtet werden müssen.

Ausserdem ist es in Abhängigkeit von Grösse un Form des zu beschichtenden Substrates nicht immer möglich eine solche Beschichtung in befriedigender Form oder befriedigender Gleichmässigkeit aufzubringen, wenn die Beschichtung durch Auftrag einer Lösung erfolgt.

Es wäre daher wünschenswert, wenn die Herstellung der eigentlichen Schutzschicht vor der Beschichtung erfolgen könnte, z.B. durch Bereitstellung einer entsprechenden Polyimidfolie. Eine solche Folie könnte dann in einfacher Weise, beispielsweise von einer Rolle, auf das Substrat aufgebracht werden.

Es wurde nun gefunden, dass diese photovernetzbaren Polymide, obwohl sie photoempfindlich sind, in der Tat freitragende Filme von hoher Festigkeit und Formstabilität bilden. Ferner wurde gefunden, dass die Photovernetzung bei bestimmten Polyimiden durch den ganzen Schichtdickenbereich hindurch erfolgt. Damit lassen sich diese Polyimide im Prinzip als Filme in Abbildungsverfahren oder bei der Herstellung von Schutzschichten einsetzen. Aufgrund ihrer hohen chemischen und mechanischen Festigkeit ist eine Verbindung mit dem Substrat, die den Photoprozess nicht beeinträchtigt, jedoch nicht ersichtlich.

Fernerhin ist es notwendig, dass die verwendete Verbindung den für diese Schutzschichten vorgesehenen thermischen Belastungen standhält, womit die Wahlmöglichkeiten für mögliche Kleber stark eingeschränkt werden.

Weiterhin wurde bei der Herstellung von Polyimidschichten aus Lösungen gefunden, dass die so hergestellten Schichten durch den Trocknungsprozess unter einer inhärenten Spannung stehen, die sich nachteilig auf das Haftvermögen auswirken kann, insbesondere bei Schichtstärken grösser 10 µm. Des weiteren besteht insbensondere bei glatten und chemisch inerten Oberflächen generell das Bestreben, die Haftung dieser Polyimide weiter zu verbessern. Eine Beschichtungsfolge Substrat, Klebeschicht, plus Polyimid aus Lösung ist jedoch im allgemeinen nicht möglich, da die für die löslichen Polyimide zu verwendenen Lösungsmittel in der Regel so stark sind, dass sie eine darunterliegende Klebeschicht auflösen oder zumindest stark beeinträchtigen würden.

Es wurde nun gefunden, dass man die genannten Nachteile vermeiden und die gestellten Anforderungen erfüllen kann, wenn man eine selbstragende photovernetzbare Polyimidfolie mit dem Substrat durch einen entsprechenden thermostabilen photovernetzbaren Kleber verbindet.

Thermostabil in diesem Sinne sind insbesondere solche photostrukturierbare Kleber, die, wenn sie allein und ohne weitere Abdeckungen eingesetzt werden, einem normalen Lötbad von 230°C standhalten.

Ferner wurde gefunden, dass man mit diesem Schichtsystem Reliefstruckturen hoher Auflösung und ausgezeichneter Haftung erhält, und dass diese Reliefstrukturen gleichzeitig annähernd dieselben guten chemischen, thermischen und mechanischen Eigenschaften besitzen wie die zugrundeliegenden Folienmaterialien. Ist der photostruckturierbare Kleber in seiner thermischen Beständigkeit etwas geringer als das Folienmaterial, so ist hier zusätzlich von Vorteil, dass die Klebeschicht z.B. gegen den direkten Angriff des oxidierenden Sauerstoffes bei hohen Temperaturen oder gegen den direkten Kontakt z.B. eines Lötbades geschützt ist. Somit kann man innerhalb des möglichen chemischen Rahmens die guten thermischen Eigenschaften des Polyimidfilmes mit den guten Hafteigenschaften des Klebers in idealer Weise verbinden.

Fernerhin wurde überraschenderweise gefunden, dass die Photovernetzung der Folie aus löslichen photovernetzbaren Polyimiden über weite Schichtdickenbereiche hin gleichmässig und mit hoher Trennschärfe erfolgt. Dadurch ist die Möglichkeit gegeben, den darunterliegenden photoempfindlichen Kleber spezifisch zu photostrukturieren. Somit ergibt sich über die ganze Schichtdicke hinweg eine genaue und

gleichmässige Definition der Reliefstrukturen.

Dies ist im Gegensatz zu einer Reihe anderer photostrukturierbarer Systeme, bei denen in den oberen Schichtbereichen eine starke Lichtabsorption erfolgt, so dass die unteren Schichtbereiche nur unvollständig belichtet werden.

So ist es z.B. durch die Erfindung auch möglich, bei der Verwendung einer üblichen Quecksilberlampe, deren Emission im nahen UV-Bereich einschliesslich des kurzwelligen sichtbaren Bereichs hauptsächlich aus den Linien bei 365, 405 und 436 nm besteht, den photostrukturierbaren Kleber so zu sensibilisieren, dass er bei anderen Wellenlängen, wo die Folie z.B. nicht absorbiert, aktiv ist, wodurch man eine zusätzliche und ganz spezifische Härtung des Klebers gegenüber der Folie erzielen kann.

Es wurde nun gefunden, dass die grosse Lichtempfindlichkeit des Polyimidfilmes über grosse Dickenbereiche hinweg auch von Nachteil sein kann, wenn der Film auf einer stark streuenden Oberfläche, beispielsweise auf einem porösen, keramischen Substrat, aufgebracht its. Infolge der starken Lichtstreuung an der Oberfläche kommt es zur Vernetzung in den Schattenbereichen des Polyimidifilms und die Auflösung sinkt ab. Das Problem lässt sich in der Regel auch nicht dadurch lösen, dass man dem Polyimidfilm stark absorbierende Substanzen, beispielsweise Antihalofarbstoffe, zusetzt, da dann die Empfindlichkeit des Films in nicht vertretbarer Weise geschwächt wird. In solchen Fällen sind Abbildungen mit herkömmlich aus der Lösung aufgebrachten Filmen nicht herzustellen. Als Problemlösung bietet sich dann eine mit einem photostrukturierbaren Kleber fixierte Polyimidfolie an. Durch sorgfältige Auswahl des Klebers lässt sich das System so gestalten, dass von der Oberfläche gestreutes Licht innerhalb der dünnen Kleberschicht absorbiert wird und trotzdem eine ausreichende Lichtempfindlichkeit des Klebstoffes gewährleistet wird. Die Polyimidfolie wird also von keinem Steulicht getroffen und auch die gemetrischen Schattenbereiche der Klebschicht bleiben unbelichtet.

Die Herstellung von Reliefbildern durch Auflaminieren photostrukturierbarer Filme, insbesondere sog. "Dry Film Resists" ist Gegenstand zahlreicher Patente, so z.B. US—PS 3 526 504. Sie bestehen im allgemeinen aus einer Trägerfolie (z.B. Polyester), einer photostrukturierbaren Schicht und einer Deckschicht (z.B. Polyethylen). Das Aufbringen auf das Substrat erfolgt durch Abziehen der Deckfolie, gegebenenfalls auch der Trägerfolie und Auflaminieren unter Andrücken oder unter Anwendung von Vakuum, gegebenenfalls bei erhöhten Temperaturen.

Entsprechende Verfahren sind z.B. aus der US—PS 4 127 436 bekannt.

Ueber einen "Dry Film Resist" auf Polyimid-Basis ist bisher nichts bekannt geworden, insbesondere auch nicht über einen photoempfindlichen Polyimidfilm, der vor der Photostrukturierung stark genug ist, sich selbst, zu tragen. Die Bereistellung eines "Dry Film Resist-Systems", das noch wesentlich höheren Temperaturen als die bisher bekannten Systeme ausgesetzt werden kann, ist äusserst wünschenswert.

Photostrukturierbare Systeme, die aus mehr als einer photostrukturierbaren Schicht bestehen, sind bekannt; auch sind photostrukturierbare Kleber, die eine darüberliegende Schicht festhalten und der Herstellung von Reliefabbildungen dienen, vorbekannt.

So sind z.B. in US 4 506 004, DE—OS 2 658 422 und JP-Kokai 58—68,740 Systeme beschrieben, die aus zwei verschiedenen photostrukturierbaren Schichten bestehen, wobei die untere Schicht durch ihre Struktur bzw. durch chemische Zusätze der verbesserten Haftung dient. In JP-Kokai 56—23'150 ist eine lithographische Platte beschrieben, die aus einem Träger, einem photostrukturierbaren Kleber und einer darüberliegenden Silikonkautschukschicht besteht.

In allen diesen Fällen handelt es sich jedoch bei der aufgeklebten Folie um Materialien, die im Vergleich zu Polyimiden als nichtthermostabil zu bezeichnen sind, und die in ihren Verarbeitungseigenschaften nicht mit Polyimiden verglichen werden können. Dies drückt sich z.B. darin aus, dass die aufzubringenden Schichten in jedem Fall eine Trägerfolie benötigen, da sie vor dem Belichten nicht die guten mechanischen Eigenschaften der Polyimidfolie besitzen.

Weiter beschreiben die EP—A 100 736 und die FR—A 2 376 447 photostrukturierbare Schichtsysteme zur Herstellung von gedruckten Schaltungen enthaltend Polyimidfilme.

Bei den bisher üblichen "Dry Film Resists" handelt es sich vor der Belichtung um relativ weiche bzw. um thermoplastische Beschichtungsmaterialien, so dass eine Haftung mit einem Substrat, bzw. einer Klebeschicht wesentlich leichter erreicht werden kann.

Die Polyimidfolien hingegen zeichnen sich z.T. durch sehr hohe Glasumwandlungstemperaturen aus, teilweise bis über 400°C, und sie bilden auch vor der Belichtung äusserst winderstandsfähige chemisch inerte Folien.

Diese sind nicht selbstklebend, so dass sie z.B. direkt und ohne Verwendung von Trennfolien auf eine Rolle aufgewickelt werden können.

Auf der anderen Seite sind die photovernetzbaren Polyimidfolien immer noch in gewissen Lösungsmitteln auflösbar.

Aus den genannten Veröffentlichungen kann daher kein Schluss darüber gezogen werden, ob und mit welchen Klebematerialien eine photostrukturierbare Polyimidfolie nun geklebt werden kann, so dass beim Auflaminieren und Trocknen keine Blasenbildung erfolgt und auch der Film nicht zerstört wird, dass eine gute gegenseitige Verklebung selbst bei hohen Temperaturen (200—400°C) gewährleister wird, und dass sichergestellt werden kann, dass alle nichtbelichteten Beschichtungsanteile völlig frei, scharf und ohne Rückstände ausentwickelbar sind.

Die vorliegende Erfindung betrifft ein beschichtetes Material enthaltend in aufeinanderfolgender Reihenfolge

a) ein Substrat, das gegebenenfalls ein Reliefbild auf der Oberfläche trägt und/oder gegebenenfalls durchbrochen ist,

b) einen photostrukturierbaren negativ arbeitenden themostabilen Kleber und

c) einen selbsttragenden photovernetzbaren Polyimidfilm, der eine Dicke von 3—300 μm, bevorzugt von 5—50 μm, besonders bevorzugt von 10—50 μm, besitzt und im wesentlichen aus einem Homo- oder Copolyimid besteht, das 5 bis 100 Mol%, bezogen auf das Gesamtmolekül, mindestens eines Strukturelementes der Formel Ia und 95—0 Mol% mindestens eines Strukturelementes der Formel Ib aufweist, wobei die enzelnen Strukturelement Ia und Ib innerhalb eines gegebenen Polymermoleküls unterschiedlich sein können

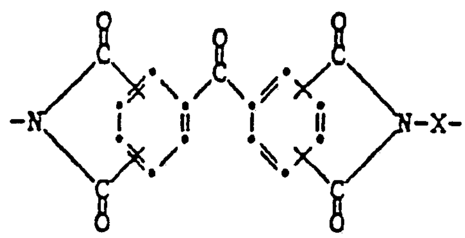 (Ia), 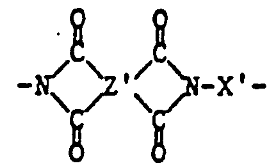 (Ib),

wobei die Carbonylgruppen in der Formel Ia jeweils paarweise in Orthostellung zueinander stehen, vorzugsweise jedoch in 3,3',4,4'-Position des Benzophenonsystems, X den zweiwertigen Rest eines aromatischen Diamines darstellt, Z' ein vierwertiger Benzophenonrest oder ein anderer unsubstituierter oder substituierter vierwertiger aromatischer Rest ist, an den je zwei Carbonylgruppen in Ortho- oder Peristellung gebunden sind, und X' die gleiche Bedeutung wie X besitzt, oder der zweiwertige, von X verschiedene Rest eines organischen Diamines ist, dadurch gekennzeichnet, dass der aromatische Rest von X in beiden Orthostellungen zu mindestens einem N-Atom oder in mindestens einer Orthostellung zu beiden N-Atomen durch Alkyl, Alkoxy, Alkoxyalkyl oder Aralkyl substituiert ist, oder dass zwei benachbarte C-Atome des aromatischen Restes X durch Alkylen substituiert sind, wobei, wenn Z' ein vierwertiger Benzophenonrest ist, X und X' verschieden sind.

Polyimide mit den Strukturelementen Ia und Ib sind in der EP—A 132,221 beschrieben.

Unter dem Begriff "selbsttragender Polyimidfilm" wird ein Film verstanden, der, im Gegensatz zu herkömmlichen Dry-Film Resists auf Acrylatbasis, ohne ein zusätzliches Trägermaterial hergestellt und verarbeitet werden kann. Die Mindeststärke eines solchen Filmes hängt im allgemeinen vom jeweiligen Filmmaterial und vom beabsichtigten Verarbeitungsverfahren ab. Sie kann vom Fachmann anhand von Routineversuchen ermittelt werden. In der Regel sind Polyimidfilme von mehr als 3 μm Dicke genügend stabil, um im erfindungsgemässen Material bzw, im Verfahren zur Herstellung dieses Materials als Folie eingesetzt werden können.

Besonders bevorzugt photovernetzbare Polyimidfilme c) bestehen im wesentlichen aus einem Homo- oder Copolyimid, wie oben definiert, worin mindestens 50 Mol% des Polymeren, bezogen auf das Gesamtmolekül, aus Strukturelementen der Formel Ia bestehen, der Rest Z' des Strukturelements der Formel Ib ausgewählt wird aus der Gruppe bestehend aus

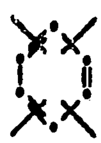 , 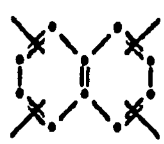 , 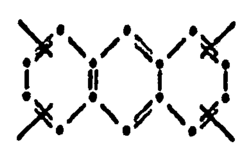

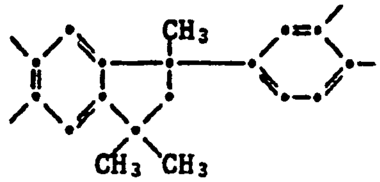 , 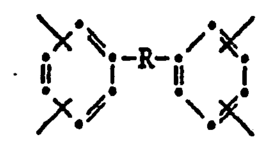

wobei die Reste Z' innerhalb eines gegebenen Moleküls unterschiedliche Bedeutung annehmen können, worin R eine direkte Bindung oder eine Brückengruppe der Formeln

$-O-$, $-S-$, $-SO_2-$, 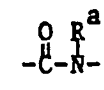 , 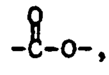, 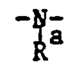 , 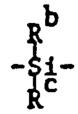 , 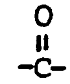 ,

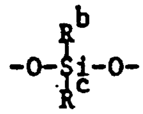 , 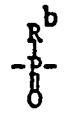 , 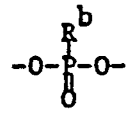 , $-N{=}N-$, 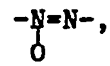,

$-NH-$, 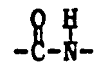 , $-CH_2-$, $-CH_2CH_2-$, 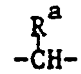, 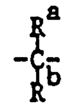 oder 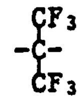

ist, worin $R^a$, $R^b$ und $R^c$ Alkyl mit 1 bis 6 C-Atomen, Phenyl oder Benzyl und $R^b$ und $R^c$ auch Alkoxy mit 1 bis 6 C-Atomen, Phenyloxy oder Benzyloxy sind, worin der Rest X des Strukturelementes Ia ausgewählt wird aus der Gruppe folgender Strukturen, die innerhalb eines gegebenen Moleküls auch unterschiedlich sein können

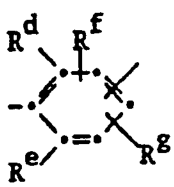 (Ic) 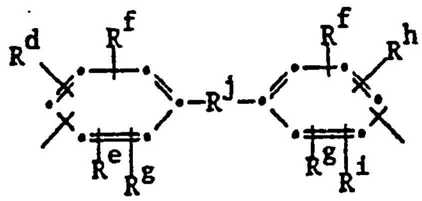 (Id)

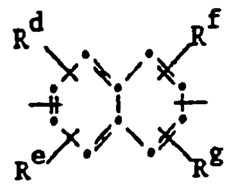 (Ie)

worin in Formel Ic die freien Bindungen in Meta- oder Parastellung zueinander stehen, in Formel Id die freien Bindungen bevorzugt in Meta- oder Parastellung zur $R^j$-Gruppe stehen und $R^d$ und $R^e$ in den beiden Orthostellungen der freien Bindung gebunden sind, und, in formel Ie die freien Bindungen in 2-, 3-, 6- und 7-Stellung gebunden sind und $R^d$ und $R^e$ sich in den beiden Orthostellungen der freien Bindungen befinden $R^j$ für eine direkte Bindung, —O—, —S—, —SS—, —SO—, —$SO_2$—, —CO—, —COO—, —NH—, —N-Alkyl mit 1 bis 6 C-Atomen im Alkyl, —N-Phenyl, —N-Benzyl, —CONH—, —CON-Alkyl- mit 1 bis 6 C-Atomen im Alkyl, —CON-Phenyl-, —CON-Benzyl,

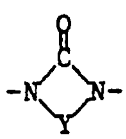 , worin Y für 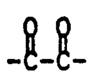 , 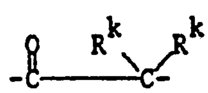 oder 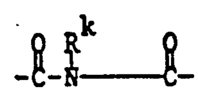 steht,

$R^k$ ein Wasserstoffatom, $C_1$—$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe

$R^1SiR^m$,

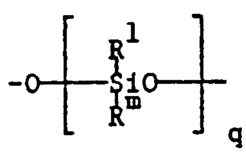 oder 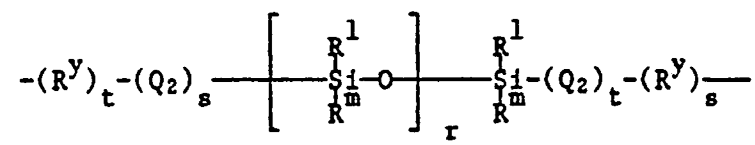

steht, worin $R^l$ und $R^m$ Alkyl oder Alkoxy mit 1 bis 6 C-Atomen, Phenyl, Benzyl, Phenyloxy oder Benzyloxy sind, r eine Zahl von 1 bis 10, t 0 oder 1 und s 0 oder 1 ist, und $R^y$ —O— oder —S— und $Q_2$ $C_1$—$C_6$-Alkylen bedeuten, und q für eine Zahl von 1 bis 100 steht, $R^d$ und $R^e$ Alkyl oder Alkoxy, mit 1 bis 12 C-Atomen, Alkoxyalkyl mit 2 bis 12 C-Atomen, Cyclopentyl, Cyclohexyl oder Benzyl sind oder in den Formeln Ic oder Id, $R^d$ und $R^f$ in Nachbarstellung sind und zusammen Trimethylen oder Tetramethylen bedeuten, wobei $R^e$ auch ein Wasserstoffatom sein kann, $R^f$ und $R^g$ ein Wasserstoffatom sind oder unabhängig die Bedeutung von $R^d$ und $R^e$ haben, und $R^h$ und $R^i$ ein Wasserstoffatom sind, unabhängig die Bedeutung von $R^d$ und $R^e$ haben oder $R^f$ und $R^h$ in Formel Id zusammen Trimethylen oder Tetramethylen sind, und worin der Rest X' des Strukturelementes Ib die Bedeutung von X besitzt oder ausgewählt wird aus der Gruppe Strukturen, die innerhalb eines gegebenen Moleküls auch unterschiedlich sein können, $C_2$—$C_{30}$Alkylen, $C_5$—$C_8$Cycloalkylen, $C_7$—$C_{30}$Aralkylen, $C_6$—$C_{22}$Arylen oder Polysiloxan.

Insbesondere bevorzugt als photovernetzbare selbsttragende Polyimidfilme c) werden Filme mit einer Dicke von 3—300 µm bestehend im wesentlichen aus einem Homo- oder Copolyimid, wie oben definiert, worin mindestens 50 Mol%, bezogen auf das Gesamtmolekül, aus Strukturelementen der Formel Ia bestehen, Z' ein Rest der Formel

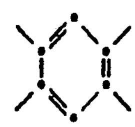 oder 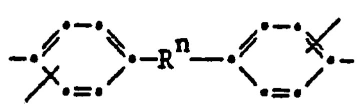

ist, der innerhalb eines gegebenen Moleküls auch unterschiedlich sein kann, worin $R^n$ eine direkte Bindung, —O—, —$SO_2$—, —$CH_2$—, —$C(CF_3)_2$— und insbesondere —CO— ist, worin der Rest X ausgewählt wird aus der Gruppe bestehend aus

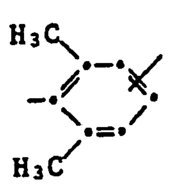 , 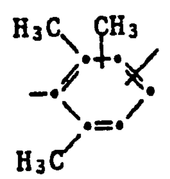 , 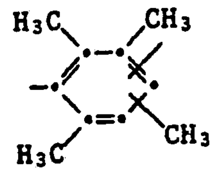

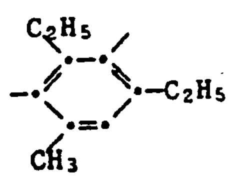 ,

worin die freien Bindungen in Meta- oder Parastellung zueinander stehen, oder der Formel

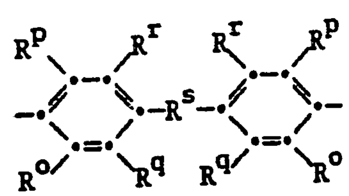

wobei diese Reste innerhalb eines gegebenen Moleküls unterschiedliche Bedeutungen annehmen können, worin $R^o$ und $R^p$ unabhängig Methyl, Ethyl, n-Propyl oder Isopropyl und $R^q$ und $R^r$ ein Wasserstoffatom sind oder die Bedeutung von $R^o$ haben oder $R^o$ und $R^q$ zusammen Tri- oder Tetramethylen bedeuten und $R^p$ und $R^r$ ein Wasserstoffatom sind, und $R^s$ eine direkte Bindung, —$CH_2$—, —$C(CF_3)_2$—, 2,2-Propyliden oder —CO— ist, und worin der Rest X' die Bedeutung von X besitzt oder ausgewählt wird aus der Gruppe bestehend aus

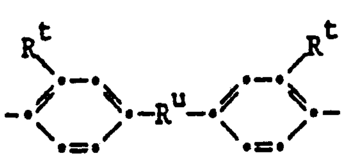 , 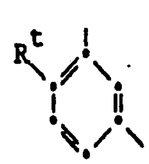 und 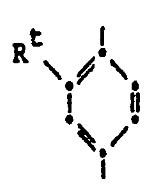 ,

wobei diese Reste innerhalb eines gegebenen Moleküls unterschiedliche Bedeutungen annehmen können, worin $R^u$ für eine direkte Bindung, —O—, —CO—, —$C(CF_3)_2$— oder —$CH_2$— steht und $R^t$ Methyl, Ethyl, Isopropyl, Methoxy, Ethoxy oder ein Wasserstoffatom bedeutet.

Auch werden als Folienmaterialien photoovernetzbare selbsttragende Polyimidfilme einer Dicke von 3—300 µm, insbesondere von 5—50 µm, und ganz besonders von 10—50 µm, bevorzugt, die im wesentlichen aus Homo- oder Copolyimiden mit einem mittleren Molekulargewicht von mindestens 2000 bestehen, die mindestens 5 Mol-%, bezogen auf das Polymer, mindestens eines Strukturelements der Formeln IX oder X enthalten,

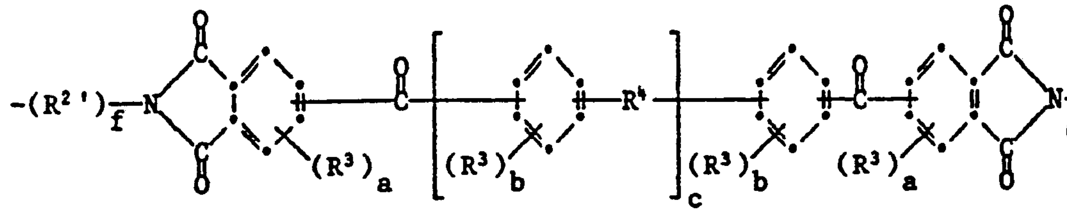

(IX)

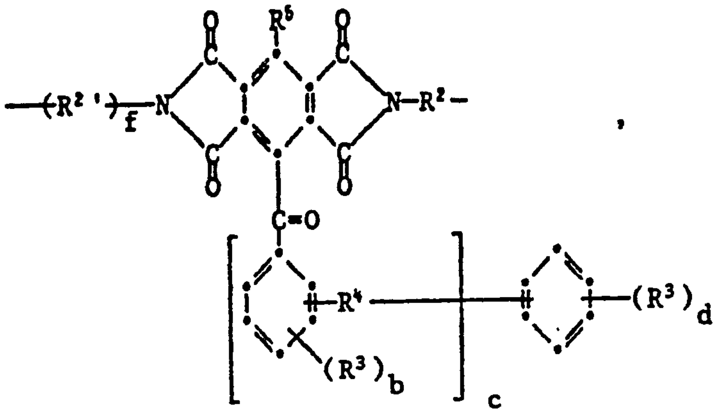

, (X)

worin

$R^3$ für Halogen, Nitro, $C_1$—$C_6$-Alkyl, $C_1$—$C_6$-Alkoxy, $C_1$—$C_6$-Alkylthio, das durch Phenyl substituiert sein kann, Phenyl, Phenoxy oder Phenylthio steht,

$R^4$ eine direkte Bindung oder eine Brückengruppe bedeutet

$R^5$ für ein Wasserstoffatom oder Aroyl steht oder die gleiche Bedeutung wie $R^3$ hat,

a für 0, 1, 2 oder 3, b für 0, 1, 2, 3 oder 4, c und d für 0, 1, 2, 3, 4 oder 5 stehen, f für 0 oder 1 steht, wobei, wenn a, b und d 2 sind, beide $R^3$ zusammen auch in o-Stellung gebundenes —CH=CH—CH=CH— bedeuten können, und

$R^2$ und $R^{2'}$ ein unsubstituierter oder substituierter cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkylthiogruppe, Alkylthioalkylgruppe, Aralkylgruppe oder an zwei benachbarten C-Atomen des aromatischen Restes durch eine Alkylengruppe substituierter aromatischer Rest sind, wobei $R^2$ ein aromatischer Rest ist, der in beiden Orthostellungen mindestens eines N-Atoms substituiert ist, wenn f = 0 ist.

Polyimide mit den Strukturelementen IX und X sind in der EP—A 162,017 beschrieben.

Ferner interessieren als Folienmaterialien photovernetzbare selbsttragende Polyimidfilme einer Dicke von 3—100 µm, insbesondere von 5—50 µm, ganz besonders von 10—50 µm, die im wesentlichen aus Homo- oder Copolyimiden bestehen, die Strukturelemente von aromatischen Aminodicarbonsäuren enthalten, mit einer inhärenten Viskosität von mindestens 0,1 dl/g, gemessen bei 25°C in einer Lösung von 0,5 Gew.-% Polymid in N-Methylpyrrolidon, dadurch gekennzeichnet, dass sie wiederkehrende Struckturelemente der Formel XI enthalten,

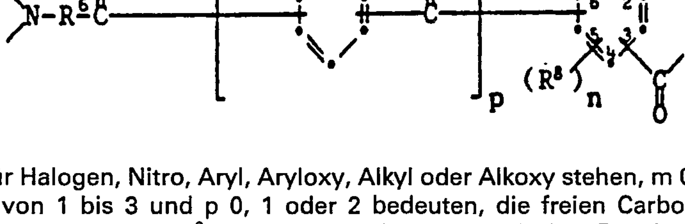

(XI)

worin

$R^7$ und $R^8$ für Halogen, Nitro, Aryl, Aryloxy, Alkyl oder Alkoxy stehen, m 0 oder eine Zahl von 1—4, n 0 oder eine Zahl von 1 bis 3 und p 0, 1 oder 2 bedeuten, die freien Carbonylgruppen in Orthostellung zueinander gebunden sind und $R^6$ einen zweiwertigen aromatischen Rest bedeutet, der durch mindestens eine Alkylgruppe oder Aralkylgruppe substituiert ist.

Polyimide dieses Typs sind in der EP—A 182,745 beschrieben.

Wahl, Komposition und Dicke des thermostabilen photovernetzbaren Klebers b) richten sich nach den Eigenschaften der aufzuklebenden Polyimidfolie, insbesondere aber auch nach den jeweiligen Anforderungen an die Beschichtung. Parameter des Anforderungsprofils zind z.B. Art und Beschaffenheit der Oberfläche (wie Material, Rauhigkeit, Topologie), Beschichtungsverfahren für den Kleber, (wie Aufbringen auf das Substrat oder auf die aufzuklebende Folie), und vorgesehene thermische, chemische und mechanische Beanspruchungen (wie vorgesehene Temperaturen, Langzeit- oder Kurzzeitbeanspruchung, thermische Beanspruchung unter oxidativen (Luft) oder nichtoxidativen Bedingungen, mechanische Beanspruchung bei erhöhten Temperaturen oder nach der Temperaturbehandlung, thermische Beanspruchung unter gleichzeitiger Einwirkung von agressiven Chemikalien).

Die thermostabile photovernetzbare Klebschicht hat im ausgehärteten Zustand zweckmässig eine Dicke von weniger als 25 µm, bevorzugt von 0,01 bis 25 µm.

Die Dicke der Klebschicht ist im allgemeinen deutlich geringer als die Dicke der aufzubringenden Polyimidfolie und beträgt bevorzugt im ausgehärteten Zustand nicht mehr als ein Viertel der gesamten Schichtdicke; dies gilt besonders dann, wenn der themostabile Kleber aus einem Material besteht, das weniger stabil als die darüberliegende Polyimidfolie ist.

Besteht der themostabile Kleber aus einem Material, das gleich stabil wie oder stabiler als die darüberligende Polyimidfolie ist, so kann die Dicke der Klebeschicht auch vergleichbar mit der Dicke der Polyimidfolie sein.

Gegebenenfalls enthält der Kleber ein Lösungsmittel, das man nach dem Beschichtungsvorgang verdampft. Dies kann bei erhöhter Temperatur erfolgen.

Es wurde fernerhin gefunden, dass die vorliegenden Polyimide, insbesondere durch die Wahl geeigneter Diamine oder Diaminmischungen, in ihrem Löslichkeitsverhalten so abgestuft werden können, dass Komponenten, insbesondere auch Lösungsmittel für den Kleber bereitgestellt werden können, so dass die Oberfläche der Polyimid-Folie nur leicht angelöst wird, das aber die Folie selbst während des Auflaminierens nicht zerstört werden kann. Dadurch kann insbesondere auch eine innige Verbindung zwischender Folie und der Klebeschicht entstehen.

Auch gelingt es, die Löslichkeitsverhältnisse so absustimmen, dass flüchtige Komponenten der Klebeschicht, wie, z.B. das Lösungsmittel, bei geeigneten Trocknungsbedingungen durch die darüberliegende Polyimidschicht hindurchdiffundieren könen, ohne dass dadurch die Güte der gesamten Beschichtung beeinträchtigt wird.

Bevorzugt werden weiterhin solche photostrukturierbaren negativ arbeitenden thermostabilen Kleber, die nach der Belichtung schon bei einer Temperatur von weniger als 70°C an den belichteten Stellen eine feste Verbindung mit der darüberliegenden belichteten Folie eingehen.

Bevorzugt setzt man als Kleber b) ein:

b1) in organischen Lösungsmitteln lösliche photovernetzbare Polyimide, die gegebenenfalls in Kombination mit organischen chromophoren Polyaziden vorliegen können: und/oder

b2) photovernetzbare Polyamidsäuren oder deren Ester; und/oder

b3) photovernetzbare Organopolysilsesquioxane; und/oder

b4) photovernetzbare Polyamidimide; und/oder

b5) photovernetzbare Epoxidsysteme; und/oder

b6) photovernetzbare Systeme enthaltend Verbindungen mit radikalisch polymerisierbaren ethylenisch ungesättigten Gruppen.

Besonders bevorzugt werden die Kleber der Typen b1), b3), b5) und b6).

Unter Berücksichtigung der Verträglichkeit und der unterschiedlichen Mechanismen der Photoreaktion können auch Mischungen dieser unterschiedlichen Kleber eingesetzt werden.

Besonders bevorzugt verwendet man als Kleber b1) eine Lösung von Polyimiden oder eine Mischung von Polyimiden, wie sie bereits weiter oben als Materialien für die Herstellung der photovernetzbaren selbsttragenden Folie beschrieben wurden.

Zusätzlich zu den bereits beschriebenen Verbindungen kann man hier auch stark lichtabsorbierende, photovernetzbare Polyimide einsetzen. Eine Verwendung dieser Verbindungen als Folienmaterialien ist, je nach Dicke der Folie, weniger bevorzugt, da wegen der starken Lichtabsorption in den oberen Bereichen der Folie mit Problemen bei der Photovernetzung in den tieferen Bereichen zu rechnen ist. Als Klebermaterial, das bevorzugt in dünneren Schichten aufgetragen wird, eignen sich diese Verbindungen allerdings bevorzugt.

Zu diesem Typ zählen photovernetzbare Polyimide die im wesentlichen aus einem Homo- oder Copolymer bestehen, das sich von mindestens einer aromatischen Tetracarbonsäure und mindestens einem Diamin ableitet und im wesentlichen 0,1 bis 100 Mol-% mindestens eines Strukturelementes der Formel II

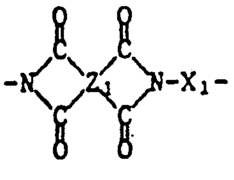 (II)

und 99,9 bis 0 Mol-% mindestens eines Strukturelementes der Formeln III und/oder IV enthält

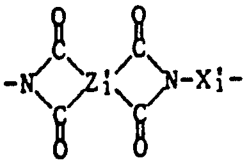

(III)

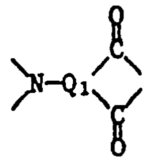

(IV),

worin

$Z_1$ für mindestens einen vierwertigen Rest der Formeln V, VI, VII oder VIII

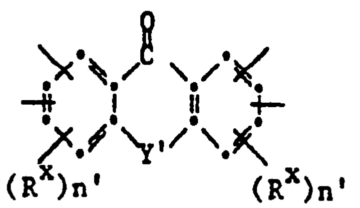

(V)

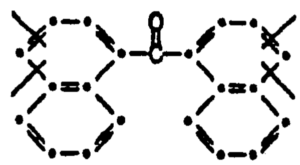

(VI)

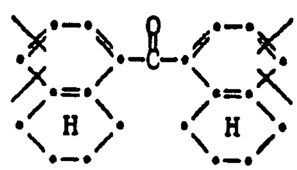

(VII)

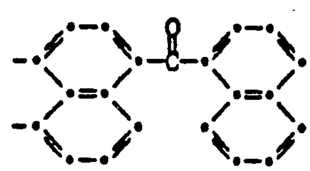

(VIII)

steht, in denen die freien Bindungen in Orthostellung zueinander gebunden sind und Y' eine direkte Bindung, $—CH_2—$, $—(CH_2)_2—$, —O—, —S—, —SO—, $—SO_2—$, —CO—, $—NR^v—$ oder $—CR^vR^w—$ bedeutet, wobei $R^v$ ein Wasserstoffatom, $C_1—C_{10}$-Alkyl, Phenyl, Naphthyl oder Phenyl$(C_eH_{2e})$— mit e = 1 bis 4 ist und $R^w$ die Bedeutung von $R^v$ mit Ausnahme der Bedeutung eines Wasserstoffatomes hat, $R^x$ für $C_1—C_{10}$-Alkyl, Halogen, —CN, $—NO_2$, $C_1—C_{12}$-Alkoxy, Phenoxy, Naphthoxy oder Phenyl-$(C_eH_{2e})$— mit e = 1—4 steht, n' = O, 1 oder 2 ist,

$X_1$ ein unsubstituierter oder substituierter heterocyclischer, cycloaliphatischer oder araliphatischer Rest, ein aromatischer Rest, bei dem zwei Arylkerne über eine aliphatische Gruppe veknüpft sind, oder ein durch mindestens eine Alkylgruppe, Cycloalkylgruppe, Alkoxygruppe, Alkoxyalkylgruppe, Alkylthiogruppe, Alkylthioalkylgruppe, Hydroxyalkylgruppe, Hydroxyalkoxygruppe, Hydroxyalkylthiogruppe, Aralkylgruppe, oder an zwei benachbarten C-Atomen des aromatischen Restes durch eine Alkylengruppe substituierter aromatischer Rest ist, $Q_1$ ein dreiwertiger aromatischer Rest ist,

$Z_1'$ die gleiche Bedeutung wie $Z_1$ hat, oder ein von $Z_1$ verschiedener vierwertiger organischer Rest ist, und

$X_1'$ der zweiwertige, von $X_1$ verschiedene Rest eines organischen Diamines ist, wobei $Z_1$ in Formel II auch vierwertige Benzophenonreste darstellen kann, wenn Strukturelemente der Formel IV enthalten sind.

Solche Verbindungen wurden in der EP—A 181,837 beschrieben.

Ein weiterer Typ bevorzugt einsetzbarer photovernetzbarer themostabiler Kleber b1) ist eine Mischung, die neben gegebenenfalls anwesenden üblichen Zusätzen enthält

a) ein in organischen Lösungsmitteln lösliches Homo- oder Copolyimid aus aromatischen Tetracarbonsäuren und aromatischen Diaminen oder aromatischen und aliphatischen Diaminen, wobei an mindestens einen Teil der Tetracarbonsäurereste, der aromatischen Diaminreste oder beider Reste mindestens eine aliphatische Gruppe direkt oder über eine Brückengruppe gebunden ist und/oder mindestens ein Teil dieser Reste als aliphatische Brückengruppe Alkylen, Alkyliden, Cycloalkyliden ode $Si(Alkyl)_2$ enthält, und

b) mindestens 0,1 Gew.%, bezogen auf die Polyimidkomponente, mindestens eines organischen chromophoren Polyazids, in dem die Azidgruppen direkt oder über eine $So_2$-Gruppe an aromatische Kohlenwasserstoffreste gebunden sind.

Solche Mischungen sind in der EP—A 92,524 beschrieben.

Besonders bevorzugt wird als photovernetzbarer, thermostabiler Kleber b1) eine Mischung, die neben gegebenenfalls anwesenden üblichen Zusätzen enthält

a) ein in einem organischen Lösungsmittel lösliches Homo- oder Copolyimid, worin das Polymere im wesentlichen aus 50 bis 100 Mol.% wiederkehrenden Strukturelementen der Formeln XVII und/oder XVIII

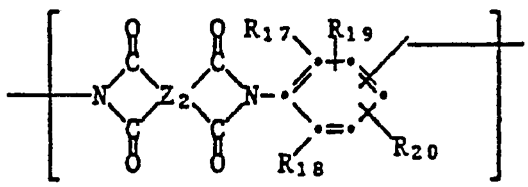

(XVII),

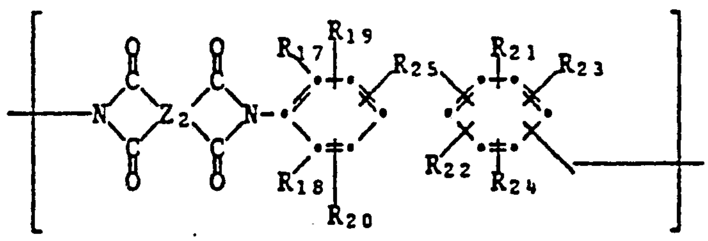

(XVIII)

und 50 bis 0 Mol.% wiederkehrenden Strukturelementen der Formel XIX

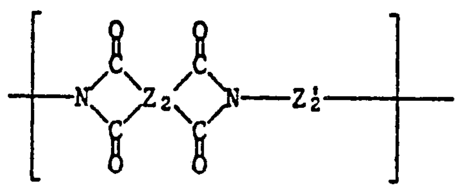

(XIX)

besteht, wobei in den Formeln XVII, XVIII und XIX die vier Carbonylgruppen an verschiedene Kohlenstoffatome gebunden sind und je zwei Carbonylgruppen in ortho- oder peri-Stellung zueinander stehen, $Z_2$ einen vierwertigen Rest bedeutet, der mindestens einen aromatischen Ring enthält,

$Z_2'$ einen von den Gruppen

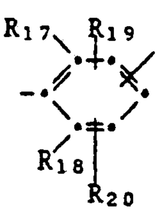

oder

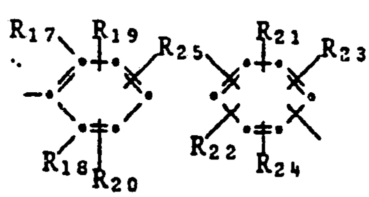

verschiedenen zweiwertigen organischen Rest darstellt, ausgewählt unter aromatischen, alkylaromatischen, aliphatischen, cycloaliphatischen und heterocyclischen Resten, Kombinationen davon und Resten mit Sauerstoff, Schwefel, Stickstoff, Silicium oder Phosphor enthaltenden Brückengruppen,

$R_{17}$ und $R_{18}$ unabhängig voneinander Alkyl mit 1—4 C-Atomen,

$R_{19}$, $R_{20}$, $R_{21}$, $R_{22}$, $R_{23}$ und $R_{24}$ unabhängig voneinander Wasserstoff oder Alkyl mit 1—4 C-Atomen und

$R_{25}$ die direkte Bindung, —O—, —S—, —SO—, —$SO_2$—, —CO—, —$CH_2$—, —$C(CF_3)_2$—, Cycloalkyliden mit 5—6 Ringkohlenstoffatomen, Phenylen,

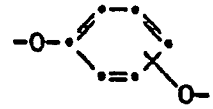

oder eine Gruppe

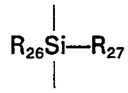

bedeuten, worin $R_{26}$ und $R_{27}$ Alkyl oder Alkoxy mit je 1—6 C-Atomen, Phenyl, Benzyl, Phenyloxy oder Benzyloxy dastellen und

b) mindestens 0,1 Gew.%, bezogen auf die Polyimidkomponente, mindestes eines organischen chromophoren Polyazids, in dem die Azidgruppen direkt oder über eine $SO_2$-Gruppe an aromatische Kohlenwasserstoffreste gebunden sind.

Solche Mischungen sind in der EP—A 141,781 beschrieben.

Weitere nützliche photostrukturierbaren Polyimide, die als Kleber b1) verwendet werden können, sind in den JP—PS 84—108,031 und JP-Kokai 57—143,329 beschrieben.

Polyamidsäuren auf der Basis von aliphatischen oder bevorzugt alicyclischen Tetracarbonsäuren oder deren Anhydriden und Diaminverbindungen, die in Kombination von Verbindungen, die unter dem Einfluss aktinischer Strahlung Vernetzungsreaktionen eingehen können, und die ebenfalls bevorzugt als Kleber b2) eingesetzt werden können, sind in der JP-Kokai 59—100,135 beschrieben.

Organopolysilsesquioxane, die bevorzugt als Kleber des Typs b3) eingesetzt werden, sind Leiterpolymere mit dem wiederkehrenden Strukturelement der Formel XXXI

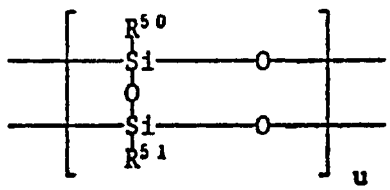 (XXXI),

worin $R^{50}$ und $R^{51}$ einwertige Kohlenwasserstoffreste darstellen und u eine positive ganze Zahl, bevorzugt grösser als 30, ist. Organiopolysilsesquioxane der Formel XXXI, worin der Reste $R^{50}$ und $R^{51}$ Niederalkyl bedeuten und zumindest einige dieser Reste ethylenisch ungesättigt sind, werden in der EP—A 76,656 beschrieben. Ferner werden dort Gemische dieser Verbindungen mit einem Vernetzungsmittel, beispielsweise einer Azidverbindung, beschrieben und deren Verwendung als hoch temperaturbeständige photovernetzbare Oberflächenbeschichtungsmittel zur Erzeugung von Reliefbildern.

Die Dicke der Kleberschichten vom Type b3) beträgt in der Regel nicht mehr als 5 µm.

In der JP—PS 83—96,654 werden photovernetzbare Gemische aus einem Organopolysilsesquioxan und einem aromatischen Azid oder Sulfonylazid beschrieben. Die organischen Reste in diesen Siloxanen brauchen keine ungesättigten Gruppen aufzuweisen.

Die Herstellung von Organopolysilsesquioxanen wird z.B. in der EP—A 46,695 beschrieben.

Im Rahmen der vorliegenden Erfindung setzt man als temperaturbeständige photovernetzbare Kleber b3) vorzugsweise Gemische aus

a) einem Polyorganosilesquisiloxan XXXI, worin $R^{50}$ und $R^{51}$ unabhängig voneinander erinwertige Kohlenwasserstoffreste, bevorzugt Alkylreste, besonders bevorzugt $C_1$—$C_4$Alkyl, oder gegebenenfalls mit $C_1$—$C_4$Alkyl substituierte aromatische Reste bedeuten, und u eine ganze Zahl grösser als 30 ist, und

b) einem aromatischen Azid oder Sulfonylazid ein.

Eine weitere Gruppe er als Kleber b4) bevorzugt einsetzbaren Verbindungen sind lineare gesättigte Homo- und Copolykondensate aus der Gruppe der Polyamidimide mit Benzophenontricarbonsäureresten mit midestens einem wiederkehrenden Strukturelement der Formel XII

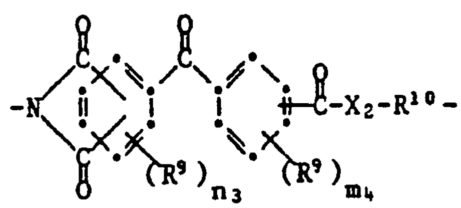 (XII)

und im Fall von Copolykondensaten zusätzlich wiederkehrenden Strukturelementen der Formeln XIII und/ oder XIV

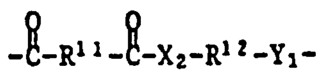 (XIII) 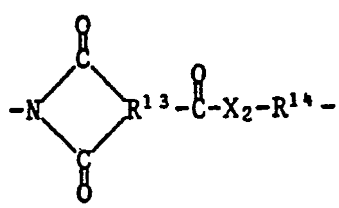 (XIV),

worin die Imidgruppe im Strukturelement XII an zwei benachbarte C-Atome gebunden ist, $m_4$ für O oder ene Zahl von 1 bis 4 und $n_3$ für 0 oder eine Zahl 1 bis 3 steht, $X_2$ für —S—, —O— oder —$NR^{15}$— steht und $Y_1$ unabhängig die gleiche Bedeutung wie $X_2$ hat, $R^9$ Alkyl oder Alkoxy mit weniger als 6 C-Atomen, Aryl mit 6 bis 10 C-Atomen, Aralkyl mit 7 bis 10 C-Atomen oder Halogen bedeutet, $R^{12}$ einen unsubstituierten oder

substituierten zweiwertigen aliphatischen, cycloaliphatischen, araliphatischen oder aromatischen Rest bedeutet, und falls $X_2$ und $Y_1$ die Gruppe —B$R^{15}$— sind, $R^{12}$ und eines der $R^{15}$ zusammen Alkylen mit 5 bis 7 C-Atomen, an das die zweite —N$R^{15}$-Gruppe gebunden ist, oder $R^{12}$ Methylen, Ethylen oder Propylen und die beiden

$R^{15}$ der N$R^{15}$-Gruppen zusammen Ethylen oder Propylen oder $X_2$ oder $Y_1$ —S— oder —O— und das andere —N$R^{15}$— sind, $R^{12}$ und $R^{15}$ zusammen Alkylen mit 5—7 C-Atomen bedeuten, and das die Gruppen —O— oder —S— gebunden ist,

$R^{10}$ einen unsubstituierten oder substituierten zweiwertigen aliphatischen oder aromatischen Kohlenwasserstoffrest bedeutet,

$R^{14}$ unabhängig die gleiche Bedeutung wie $R^{10}$ hat,

$R^{11}$ ein zweiwertiger gesättigter aliphatischer oder aromatischer Rest ist,

$R^{13}$ für einen dreiwertigen gesättigten aliphatischen oder aromatischen Rest steht, in dem die Imidgruppe an zwei benachbarte C-Atome gebunden ist, und

$R^{15}$ ein Wasserstoffatom, Alkyl, Cycloalkyl, Aryl, Aralkyl oder Alkaralkyl bedeutet, wobei die Copolykondensate die Strukturelemente der Formel XII zu mindestens 10 Mol% enthalten, bezogen auf das Copolykondensat.

Die Mono- und Copolyamidimide dieser Gruppe sind in der EP—A 138,768 beschrieben. Ebenfalls als Kleber b4) eignen sich Gemische aus Polyamidimiden mit ungesättigten Gruppen und einem Photosensibilisator, die in der US—PS 4,180,404 beschrieben sind.

Ebenfalls als Kleber b5) von Interesse sind photovernetzbare Epoxidharze oder Mischungen solcher Harze.

Solche Klebstoffmischungen enthalten bevorzugt

(a) eine mindestens eine 1,2-Epoxidgruppe enthaltende aromatische, cycloaliphatische oder araliphatische Verbindung oder ein Gemisch solcher Verbindungen,

(b) mindestens einen für die Photovernetzung von Epoxidharzen geeigneten Photoinitiator, gegebenenfalls in Kombination mit einem Photobeschleuniger und gegebenenfalls

(c) mindestens eine als latenten Heisshärter verwendbare aromatische, cycloaliphtische oder araliphatische Verbindung.

Als für die zur Vernetzung der Epoxidharze geeignete strahlungsaktivierbare Photoinitiatoren sind eine Vielzahl unterschiedlicher kationischer Verbindungen bekannt geworden, und beispielsweise im Brit. Polymer J. *15*, Seiten 24 ff (1983) und J. Macromol. Sci. Macromol. Rev. C21, Seiten 187 ff (1981) beschrieben.

Als besonders geeignet haben sich Oniumsalze erwiesen, besonders solche mit wenig nukleophilen Anionen. Solche Anionen sind z.B. die Halogenkomplexanionen von zweiwertigen bis siebenwertigen Metallen oder Nichtmetallen, z.B. Sb, Sn, Fe, Bi, Al, Ga, In, Ti, Zr, Sc, V, Cr, Hf und Cu sowie B, P und As. Das Halogen ist bevorzugt F. Beispiele sind $BF_4^-$, $PF_6^-$, $AsF_6^-$, $SbF_6^-$.

Als Oniumsalze sind z.B. Aryldiazoniumsalze und Oniumsalze der Gruppen Va, VIa und VIIa des Periodsystems geeignet, z.B. Haloniumsalze, besonders aromatische Iodonium- und Iodoxoniumsalze, quaternäre Ammonium-, Phosphonium- und Arsoniumsalze, aromatische Sulfoniumsalze und Sulfoxoniumsalze bzw. Selenoniumsalze (vergl. EP—A 153,904).

Unter den Haloniumsalzen sind solcher der Formel XXXIII bevorzugt,

$$\left[R^{41}R^{42}X^{a}\right]^{+}_{q_4}\left[L_2Q^{a}_{m_4}\right]^{-q_4} \qquad \text{XXXIII}$$

worin $R^{41}$ und $R^{42}$ unabhängig voneinander ein carbocyclischer oder heterocyclischer aromatischer Rest mit 6 bis 20 C-Atomen oder $R^{41}$ und $R^{42}$ zusammen ein zweiwertiger carbocyclischer oder heterocyclischer aromatischer Rest sind, $X^a$ für ein Halogenatom steht, $m_4$ eine Zahl ist, die der Summe der Wertigkeit von $L_2$ und $q_4$ entspricht, $L_2$ ein zweiwertiges bis siebenwertiges Metall oder Nichtmetall und $Q^a$ ein Halogenatom darstellen, und $q_4$ eine Zahl von 1 bis 3 bedeutet.

Eine weitere bevorzugte Gruppe von Oniumsalzen sind Iodosylsalze der Formel XXXIV

$$\left[R^{43}R^{44}I{=}O\right]^{+}_{q_5}\left[L_3Q^{b}_{m_5}\right]^{-q_5} \qquad \text{XXXIV},$$

worin $R^{43}$ und $R^{44}$ ein carbocyclischer oder heterocyclischer aromatischer rest mit 6 bis 20 C-Atomen sind, $m_5$ eine Zahl ist, die der Summe der Wertigkeit von $L_3$ und $q_5$ entspricht, $L_3$ ein zweiwertiges bis

siebenwertiges Metall oder Nichtmetall und $Q^b$ ein Halogenatom darstellen, und $q_5$ eine Zahl von 1 bis 3 bedeutet.

Eine weitere bevorzugte Gruppe von Oniumsalzen sind Sulfoniumsalze der Formel XXXV

$$\left[ R^{45}R^{46}R^{47}S \right]^{+}_{q_6} \quad \left[ L_4Q^{c}_{m_6} \right]^{-q_6} \qquad XXXV,$$

worin $R^{45}$, $R^{46}$ und $R^{47}$ unabhängig voneinander einen carbocyclischen oder heterocyclischen aromatischen Rest mit 6 bis 20 C-Atomen oder eines von $R^{45}$, $R^{46}$ und $R^{47}$ diesen aromatischen Rest und die beiden anderen zusammen einen zweiwertigen carbocyclischen oder heterocyclischen aromatischen Rest bedeuten, $m_6$ eine Zahl ist, die der Summe der Wertigkeit von $L_4$ und $q_6$ entspricht, $L_4$ein zweiwertiges bis siebenwertiges Metall oder Nichtmetall und $Q^c$ ein Halogenatom darstellen, und $q_6$ eine Zahl von 1 bis 3 bedeutet.

Die Iodoniumsalze sind z.B. in der DE—A—2 518 639 oder der EP—A 104,143 beschrieben. Besonders bevorzugt ist Diphenyliodoniumhexafluorphosphat.

Geeignete Sulfoxoniumsalze sind z.B. in den US Patenten 4 383 025, 4 398 014 und 4 299 938 oder der EP—A 35,969 beschrieben.

Weitere geeignete Photoinitiatoren sind Metallcarbonylverbindungen, Metallocene und Metallocencarbonylkomplexe.

Zu den besonders bevorzugten Gruppen geeigneter kationischer Photoinitiatoren für die Photovernetzung von Epoxidharzen zählen I) Salze der Formel XXXVIII

$$\left[ Y_3 - Q - (CO)_{a_1} \right]^{+} \quad MX_{4\,n_1}^{-} \qquad (XXVIII),$$

worin $Y_3$ eine Arengruppe oder Dienyliumgruppe bedeutet, Q ein Atom eines unter Titan, Vanadium, Chrom, Mangan, Eisen, Kobalt, Nickel, Kupfer, Niob, Molybdän, Ruthenium, Rhodium, Palladium, Silber, Tantal, Wolfram, Rhenium, Osmium, Iridium, Platin und Gold ausgewählten Uebergangsmetalls darstellt, $a_1$ eine solche positive ganze Zahl ist, dass das Atom Q eine geschlossene Elektronenschalenkonfiguration aufweist, M ein Atom eines Metalls oder Nichtmetalls darstellt, $n_1$ 4, 5 oder 6 und um eins grösser als die Wertigkeit von M ist und $X_4$ für ein Fluor- oder Chloratom steht, mit der Massgabe, dass, wenn M Antimon darstellt, $n_1$ 6 ist und fünf der Symbole $X_4$ für Fluor stehen, eines auch eine Hydroxogruppe bedeuten kann; oder (II) Salze der Formel XXIX

$$\left[(R^{48})(R^{49}Me)_{a_2}\right]^{+a_2n_2} \quad \frac{a_2n_2}{q_2} \quad \left[LQ'_{m_2}\right]^{-q_2} \qquad (XXIX),$$

worin

$a_2$ 1 oder 2 sowie $n_2$ und $q_2$ unabhängig voneinander je eine ganze Zahl von 1 bis 3 sind, Me das Kation eines einwertigen bis dreiwertigen Metalls aus der Gruppe IVb bis VIIb, VIII oder Ib des Periodensystems darstellt, $m_2$ eine der Wertigkeit von L und $q_2$ entsprechende ganze Zahl ist und Q′ ein Halogenatom, L ein zweiwertiges bis siebenwertiges Metall oder Nichtmetall, $R^{48}$ ein π-Aren und $R^{49}$ ein π-Aren oder das Anion eines π-Arens bedeuten. Insbesondere die Salze der Formel XXIX werden als Photoinitiatoren eingesetzt.

Eine besonders bevorzugte Ausführungsform der Photoinitiatoren XXIX sind Eisenverbindungen der Formel XXX

$$\left[ (R^{32})(R^{33}Fe^{II})_{a_3} \right]^{+a_3} \quad \frac{a_3}{q_3} \quad (L_1Q''_{m_3})^{-q_3} \qquad (XXX)$$

worin

$a_3$ 1 oder 2 und $q_3$ 1, 2 oder 3 sind,

$L_1$ ein zweiwertiges bis siebenwertiges Metall oder Nichtmetall bedeutet,

Q″ für ein Halogenatom steht,

$m_3$ eine ganze Zahl ist, die der Summe der Wertigkeit von $L_1$ und $q_3$ entspricht,

$R^{32}$ ein π-Aren und $R^{33}$ das Anion eines π-Arens bedeuten. Die Verbindungen der Formel XXX werden in der Regel zusammen mit mindestens einem Elektronenacceptor als Oxidationsmittel, und/oder gegebenenfalls mit einem Sensibilisator für die Verbindung der Formel XXX eingesetzt.

Durch die Kombination von Photoinitiatoren der Formel XXX mit geeigneten Oxidationsmitteln lassen sich Strahlungshärter für Epoxidverbindungen formulieren, die bereits bei Bestrahlung mit aktinischer Strahlung zu einer ausreichenden Härtung des Harzes führen und die keine thermische Nachhärtung verlangen.

Die Epoxidkleber enthaltend Photoinitiatoren der Formeln XXVIII und XXIX werden in EP—A 94,914, und 94,915 beschrieben. Epoxidkleber enthaltend Photinitiatoren der Formel XXX in Kombination mit Oxidationsmitteln bzw. mit Sensibilisatoren werden in den EP—A 126,712 bzw. 152,377 beschrieben. Die in diesen Patentanmeldungen erwähnten bevorzugten Ausführungsformen der Photoinitiatoren lassen sich

auch im Rahmen dieser Erfindung bevorzugt in den Klebern b) einsetzen.

Besonders bevorzugt als Kleber b5) werden Epoxidharze, die als Photoinitiator eine Kombination von Eisenverbindungen der Formel XXX mit Oxidationsmitteln enthalten.

Zu den geeigneten mindestens eine 1,2-Epoxidgruppe enthaltenden aromatischen, cycloaliphatischen oder araliphatischen Verbindungen, die als Komponente (a) in den Klebern der erfindungsgemässen Beschichtungen eingesetzt werden können, zählen beispielsweise Glycidylether einwertiger cycloaliphatischer oder araliphatischer Alkohole oder Phenole, wie Phenylglycidylether, und Glycidylester von cycloaliphatischen, aromatischen oder araliphatischen Monocarbonsäuren.

Vorzugsweise ist (a) ein Epoxidharz mit mindestens einer mittelständigen Epoxidgruppe oder ein cycloaliphatisches, aromatisches oder araliphatisches Epoxidharz, das durchschnittlich mehr als eine 1,2-Epoxidgruppe pro Molekül enthält und das als 1,2-Epoxidgruppe mehr als eine endständige, direkt an ein Sauerstoffatom oder Stickstoffatom, vorzugsweise jedoch Sauerstoffatom, gebundene Gruppe der Formel

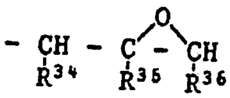

XXXII

enthält, worin entweder $R^{34}$ und $R^{36}$ je für ein Wasserstoffatom stehen, wobei $R^{35}$ dann ein Wasserstoffatom oder eine Methylgruppe bedeutet, oder $R^{34}$ und $R^{36}$ zusammen $—CH_2CH_2—$ darstellen, wobei $R^{35}$ dann ein Wasserstoffatom bedeutet.

Als Beispiele für solche Harze seien Polyglycidyl- und Poly-(β-methylglycidyl)-ester genannt, die durch Umsetzung einer zwei oder mehr Carbonsäuregruppen pro Molekül enthaltenden cycloaliphatischen, aromatischen oder araliphatischen verbindung mit Epichlorhydrin, Glycerindichlorhydrin oder β-Methylepichlorhydrin in Gegenwart von Alkali erhältlich sind. Solche Polyglycidylester können sich von cycloaliphatischen Polycarbonsäuren, wie Tetrahydrophthalsäure, 4-Methyltetrahydrophthalsäure, Hexahydrophthalsäure und 4-Methylhexahydrophthalsäure, sowie von aromatischen Polycarbonsäuren, wie Phthalsäure, Isophthalsäure und Terephthalsäure, ableiten.

Weitere Beispiele sind Polyglycidyl- und Poly-(β-methylglycidyl)-ether, die durch Umsetzung einer mindestens zwie freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung, erhältlich sind. Diese Ether lassen sich aus cycloaliphatischen Alkoholen, wie 1,3- und 1,4-Cyclohexandiol, Bis-(4-hydroxycyclohexyl)-methan, 2,2-Bis-(4-hydroxycyclohexyl)-propan und 1,1-Bis-(hydroxymethyl)-cyclohex-3-en, und aus Alkoholen mit aromatischen Kernen, wie N,N-Bis-(2-hydroxyethyl)-anilin und p,p'-Bis-(2-hydroxyethylamino)-diphenylmethan, herstellen. Man kann sie ferner aus einkernigen Phenolen, wie Resorcin und Hydrochinon, und mehrkernigen Phenolen, wie Bis-(4-hydroxyphenyl)-methan (sonst als Bisphenol F bekannt), 4,4'-Dihydroxydiphenyl, Bis-(4-hydroxyphenyl)-sulfon, Bis-(4'-hydroxyphenyl)-bis-trifluormethyl-methan, 1,1,2,2-Tetrakis-(4-hydroxyphenyl)-ethan, 2,2-Bis-(4-hydroxyphenyl)-propan (sonst als Bisphenol A bekannt), 2,2-Bis-(3,5-dibrom-4-hydroxyphenyl)-propan oder tetrachloriertem oder -bromiertem Bisphenol A sowie aus Aldehyden, wie Formaldehyd, Acetaldehyd, Chloral und Furfural mit Phenol selbst bzw. durch Chloratome oder Alkylgruppen mit jeweils bis zu 9 Kohlenstoffatomen ringsubstituiertem Phenol, wie 4-Chlorphenol, 2-Methylphenol und 4-tert.-Butylphenol, gebildeten Novolaken herstellen.

Poly-(N-glycidyl)-verbindungen kommen ebenfalls in Betracht, z.B. die N-Glycidylderivate von cycloaliphatischen, aromatischen Aminen, wie Anilin, Bis-(4-aminophenyl)-methan und Bis-(4-methylaminophenyl)-methan, Triglycidylisocyanurat und N,N'-Diglycidylderivate von Hydantoinen wie 5,5'-Dimethylhydantoin.

Beispiele für Epoxidharze mit Gruppen der Formel XXXII, worin $R^{34}$ und $R^{36}$ zusammen eine $—CH_2CH_2$-Gruppe darstellen, sind Bis-(2,3-epoxicyclopentyl)-ether, 2,3-Epoxicyclopentylglycidylether und 1,2-Bis-(2,3-epoxicyclopentyloxy)-ethan.

Ebenfalls in Betracht kommen Epoxidharze, in denen einige oder sämtliche Epoxidgruppen mittelständig sind, wie Vinylcyclohexendioxyd, Limonendioxyd, Dicyclopentadiendioxyd, 4-Oxatetracyclo[6.2.1.$0^{2,7}$.$0.^{3,5}$]undec-9-ylglycidylether, 1,2-Bis(4-oxatetracyclo[6.2.1.$0^{2,7}$.$0.^{3,5}$]undec-9-yloxy)-ethan, der 3,4-Epoxicyclohexylmethylester der 3',4'-Epoxicyclohexancarbonsäure sowie dessen 6,6'-Dimethylderivat, der Bis-(3,4-epoxicyclohexancarbonsäureester) des Ethylenglykols, der Bis-adipinsäureester des 3,4-Epoxi-6-methylcyclohexanmethylols oder 3-(3,4-Epoxicyclohexyl)-8,9-epoxi-2,4-dioxaspiro-[5.5]undecan.

Gewünschtenfalls kann man Epoxidharzgemische einsetzen.

Als Epoxidharzkomponente in den Klebern b5) der erfindungsgemässen beschichteten Materialien bevorzugt man insbesondere Diglycidylether zweiwertiger Phenole, die gegebenenfalls vorverlängert sein können und die sich beispielsweise von 2,2-Bis-(4-hydroxyphenyl)-propan oder von Bis-(4-hydroxyphenyl)-methan ableiten.

Hierbei kann es sich um Monomere, Oligomere oder bevorzugt niedermolekulare Polymere mit einem mittleren Molekulargewicht $\overline{M}\omega$ von etwa 1000 bis 10 000 handeln. Bevorzugt ist das Molekulargewicht 1000 bis 6000.

Ganz besonders geeignet sind auch solche Epoxidkompositionen die sich einfach von einem Träger auf ein Substat übertragen lassen.

Dies sind z.B. Glycidylether von Novolaken aus gegebenenfalls substituierten Phenolen, wie z.B. Xylenol, Kresol, Resorcin, und besonders Phenol und Aldehyden, wie z.B. Acetaldehyd und besonders Formaldehyd.

Den Epoxidklebern b5) können weitere übliche Zusatzmittel einverleibt werden, z.B. Füllstoffe, Haftvermittler, Flammhemmer, Farbstoffe, insbesondere Antihalofarbstoffe, die die Wirkung der Initiatoren nicht negativ beeinflussen, und Sensibilisatoren. Beispiele für Sensibilisatoren sind:

1-Chloranthracen, 2-Methylanthracen, Anthracen, Pyren, Benzil, Thioxanthon, 2-Isopropylthioxanthon, 2-Chlorthioxanthon, 3-Thiophenylphthalimid, N-Methyl-4-thiophenylphthalimid, Benzyldimethylketal oder Benzildiethylketal.

Bevorzugt sind Thioxanthone, Phthalimidthioether und besonders Anthracene. Diese werden bevorzugt in einer Menge von 0,1—10 Gew.%, vorzugsweise 0,1—5 Gew.% zugegeben, bezogen auf das Epoxidharz.

Bedeutet $Y_3$ im Photoinitiator der Formel XXVIII eine Arengruppe, so wird es normalerweise notwendig sein, sowohl Hitze als auch aktinische Strahlung zur Härtung einwirken zu lassen, falls die Epoxidgruppen in (a) der Formel XXXII entsprechen; bei solchen Salzen wird die Verwendung von Epoxidharzen mit direkt an cycloaliphatische Kohlenstoffatome gebundenen 1,2-Epoxidgruppen bevorzugt.

In einer weiteren bevorzugten Ausführungsform enthält der photostrukturierbare Epoxidkleber b5) eine härtende Menge eines latenten Heisshärters für das Epoxidharz zur Bildung eines B-Stufenproduktes. Die Aushärtung der Klebstoffzusammensetzung erfolgt dann durch Erhitzen.

Zu geeigneten hitzeaktivierbaren Vernetzungsmitteln für die Epoxidharzzusammensetzungen zählen insbesondere Polycarbonsäureanhydride, wie Phthalsäureanhydrid, Hexahydrophthalsäureanhydrid oder auch veretherte Phenolharze.

Die zur Heisshärtung erforderliche Temperatur und Erhitzungsdauer, sowie die Antiele an hitzeaktivierbarem Härter, lassen sich leicht durch Serienversuche feststellen und sind ohne weiteres aus den wohlbekannten Tatsachen über die Heisshärtung von Epoxidharzen herleitbar.

Schliesslich können den photostrukturierbaren thermostabilen Klebern b5) auf Epoxidbasis auch noch Reaktivverdünner zugegeben werden. Beispiele dafür sind Diallylphthalat, Diallylcarbonat, Triallylisocyanat, Triallylcyanurat oder o-Kresylglycidylether.

Ebenfalls bevorzugt als Kleber b5) lässt sich ein photovernetzbares und anschliessend noch härtbares Epoxidharz auf der Basis von Bisphenoldiglycidylethern einsetzen, das neben freien Epoxidgruppen noch photovernetzbare Reste

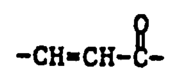 , 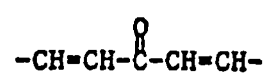 oder 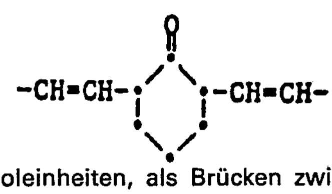

enthält, die zu mindestens 10 Mol%, bezogen auf die Bisphenoleinheiten, als Brücken zwischen den aromatischen Kernen des Bisphenols anwesend sind.

Solche Verbindungen sind beispielsweise von R. Darms in Chimia *38*, 13 (1984) beschrieben worden. Varfahren zur Herstellung von Verbindungen dieses Typs sind in der DE—OS 2,947,734 angegeben.

Die geeigneten Kleber b6) aus der Gruppe der Verbindungen mit radikalisch polymerisierbaren ethylenisch ungesättigten Gruppen, wie oben definiert, lassen sich in drei Klassen einteilen.

So kann man

A) Gemische einsetzen, die

a) mindestens eine ethylenisch ungesättigte radikalisch polymerisierbare Verbindung mit einem bei Normaldruck über 100°C liegenden Siedepunkt,

b) mindestens einen organischen, anorganischen oder metallorganischen Photoinitiator, der bei Bestrahlung Radikale bildet, und

c) ein polymeres Bindemittel enthalten; oder man kann

B) Gemische einsetzen, die

a) Verbindungen oder Mischungen von Verbindungen mit sowohl mindestens einer mittelständigen Epoxidgruppe und/oder mindestens einem Strukturelement der Formel XXXII, vorzugsweise mindestens einem Strukturelement der Formel XXXII

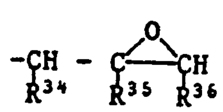 (XXXII),

das endständig direkt an ein Sauerstoffatom oder Stickstoffatom, vorzugsweise jedoch Sauerstoffatom, gebunden ist, worin $R^{34}$ und $R^{36}$ je ein Wasserstoffatom bedeuten, wobei $R^{35}$ dann ein Wasserstoffatom oder eine Mehylgruppe ist, oder $R^{34}$ und $R^{36}$ zusammen $—CH_2—CH_2—$ darstellen, wobei $R^{35}$ dann ein Wasserstoffatom bedeutet, als auch mit mindestens einer ethylenisch ungesättigten Doppelbindung in einem Molekül,

b) mindestens einen Photoinitiator, der bei Bestrahlung Radikale bildet, und

c) gegebenenfalls polymere Bindemittel und/oder ein hitzeaktivierbares Polymerisationsmittel für 1,2-Epoxidharze und/oder Photosensilbilisatoren oder -initiatoren für die Epoxidpolymerisation enthalten; oder man kann

C) Gemische einsetzen, die

a) ein Epoxidharz mit mindestens einer mittelständigen Epoxidgruppe und/oder mindestens einer Epoxidgruppe der Formel XXXII, wie oben definiert,

b) eine radikalisch photopolymerisierbare Verbindung, und gegebenenfalls

c) einen hitzeaktivierbaren Härter für das Epoxidharz enthalten.

Das polymere Bindemittel der Gemische des Typs A) macht in der Regel mindestens 20 Gew.% der Gesamtmasse aus und bestimmt im wesentlichen die thermischen und mechanischen Eigenschaften der Klebstoffbeschichtungen.

Gemische dieses Typs sind bekannt und finden vor allem als Lötstopmasken Anwendung. Solche Systeme und deren Verwendung als Photoresists sind beispielsweise in den US—PSS 3,469,982, 4,195,997 und 4,278,752 beschrieben.

Die Mischungen der Typen A), B) und C) können gegebenenfalls noch weitere an sich übliche Zusätze enthalten, wie z.B. Haftvermittler, Füllstoffe, Reaktionsbeschleuniger, niedermolekulare oder polymere Vernetzer oder Flammhemmer wie beispielsweise $Sb_2O_3$. Die Mischungen der Typen B) und C) können darüber hinaus noch Katalysatoren der thermischen Härtung, beispielsweise Diazabicyclooctan, enthalten.

Als radikalisch polymerisierbare ethylenisch ungesättigte Verbindungen können in den Gemischen des Typs A) insbesondere Allylverbindungen, Acrylate und ganz besonders Methacrylate eingesetzt werden.

Beispiele dafür sind N,N-Diethylaminoethylacrylat, Ethylenglycoldiacrylat, 1,4-Butandioldiacrylat, Diethylenglycoldiacrylat, 1,3-Propandioldiacrylat, Decamethylenglycoldiacrylat, Decamethylenglycoldimethacrylat, 1,4-Cyclohexandioldiacrylat, 2,2-Dimethylolpropandiacrylat, Glycerindiacrylat, Tripropylenglycoldiacrylat, Glycerintriacrylat, Trimethylolpropantriacrylat, Pentaerythrittriacrylat, 2,2-Di-(p-hydroxyphenyl)-propandiacrylat, Pentaerythrittetraacrylat, 2,2-Di-(p-hydroxyphenyl)-propandimethacrylat, Triethylenglycoldiacrylat, Polyoxyethyl-2,2-di-(p-hydroxyphenyl)-propandimethacrylat, Di-(3-methacryloxy-2-hydroxypropyl)-ether von Bisphenol-A, Di-(2-methacryloxyethyl)-ether von Bisphenol-A, Di-(3-acryloxy-2-hydroxypropyl)-ether von Bisphenol-A, Di-(2-acryloxyethyl) ether von Bisphenol-A, Di-(3-methacryloxy-2-hydroxypropyl)-ether von Tetrachlobisphenol-A, Di-(2-methacryloxyethyl)-ether von Tetrachlorbisphenol-A, Di-(3-methacryloxy-2-hydroxypropyl)-ether von Tetrabrombisphenol-A, Di-(2-methacryloxyethyl)-ether von Tetrabrombisphenol-A, Di-(3-methacryloxy-2-hydroxypropyl)-ether von 1,4-Butandiol, Di-(3-methacryloxy-2-hydroxypropyl)-ether von 4,4'-Di-hydroxybiphenyl, Triethylenglycoldimethacrylat, Polyoxypropyltrimethylolpropantriacrylat, Ethylenglycoldimethacrylat, Butylenglycoldimethyacrylat, 1,3-Propandioldimethyacrylat, 1,2,4-Butantrioltrimethacrylat, 2,2,4-Trimethyl-1,3-pentandioldimethacrylat, Pentaerythrittrimethacrylat, 1-Phenylethylen-1,2-dimethacrylat, Pentaerythrittetramethacrylat, Trimethylolpropantrimethacrylat, 1,5-Pentandioldimethacrylat, Diallyfumarat, Styrol, 1,4-Benzoldioldimethacrylat, 1,4-Diisopropenylbenzol, 1,3,5-Triisopropenylbenzol, sowie insbesondere die Verbindungen der Formel

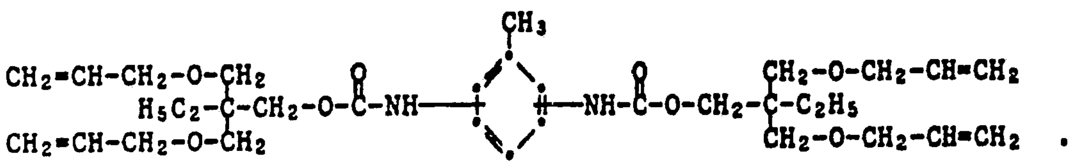

Als polymere Bindemittel für die Gemische des Typs A) sind inbesondere Celluloseacetatbutyratpolymere, wie in der US—PS 4,195,997 beschrieben, Polymere mit wenigstens 5% Acrylnitril und wenigstens 5% aromatisch gebundenen Chlors, wie in der US—PS 4,278,752 beschrieben, Poly-(diallyl-ortho-phthalate), wie in der US—PS 3,824,104 beschrieben, oder polymere saure Bindemittel in Kombination mit einem Aldehyd-Kondensationsharz Präpolymeren, wie in der EP—A 115,354 beschrieben, geeignet.

Das polymere Bindemittel kann auch selbst in End-, Mittel- oder Seitenstellung ethylenisch ungesättigte Gruppen tragen.

Als Photoinitiatoren, die bei Bestrahlung Radikale bilden, setzt man in den Gemischen des Typs A) an sich bekannte Verbindungen ein. Beispielsweise eignen sich als Photoinitiatoren Substanzen aus folgenden Verbindungsklassen:

i) mehrkernige Chinone, wie z.B. 2-tert.Butylanthrachinon,

ii) Benzoinether, wie z.B. $C_6H_5$—CO—$C(CH_3)(OCH_3)$—$C_6H_5$.

iii) Hexarylimidazol-Dimere, wie z.B. 2-o-Chlorphenyl-4,5-diphenylimidazol-Dimer, insbesondere in Kombination mit photoreduzierbaren Farbstoffen,

iv) aromatische Ketone, wie z.B. Michler's Keton, insbesondere in Kombination mit aromatischen Aminen,

v) Thioxanthone, wie z.B. 2-Chlorthioxanthon, insbesondere in Kombination mit aromatischen Aminen,

vi) Acylphosphinoxid- oder Acylphosphinsulfidverbindungen, wie z.B.

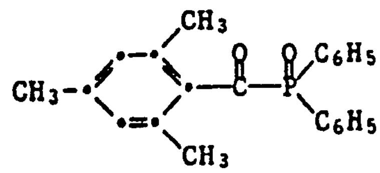

oder

vii) Titanocene, wie z.B. $(C_5H_5)_2Ti(C_6F_5)_2$; Verbindungen dieses Typs sind in der EP—A 119,162 beschrieben.

Weitere geeignete Photoinitiatoren der radikalischen Polymerisation sind in der US—PS 3,469,982 beschrieben.

Als Kleber b6) eignen sich generell bekannte Gemische des Typs A), die im allgemeinen als Lötstopmasken für Temperaturen bis zu 270°C verwendet werden.

Diese Gemische enthalten insbesondere

i) Polyurethane mit terminalen ethylenisch ungesättigten Resten und mit terminalen Carboxylgruppen; oder

ii) Mischungen von festen Polymeren mit wenigstens 2 reaktiven C—C-Doppelbindungen pro Molekül und flüssigen Polythiolen mit wenigstens 2 Thiolgruppen pro Molekül, wobei die festen Polyene gewonnen werden durch Umsetzung eines Copolymeren auf Styrol-Allyl-alkoholbasis mit einer ungesättigten Monocarbonsäure; oder

iii) Mischungen von festen Polyenen mit wenigstens 2 reaktiven C—C-Doppelbindungen pro Molekül und flüssigen Polythiolen mit wenigstens 2 Thiolgruppen pro Molekül, wobei die festen Polyene gewonnen werden durch Umsetzung eines Copolymeren auf Styrol-Allyl-alkoholbasis und wenigstens einem reaktiven ungesättigten Monoisocyanat; oder

iv) Mischungen aus einem Polythiol mit mindestens 2 Thiolgruppen pro Molekül, einem Poly-(diallyl-ortho-phthalat) und einem flüssigen Polyen, das sich ableitet von der Umsetzung von Toluoldiisocyanat mit dem Diallylether des Trimethylolpropans; oder

v) Mischungen von flüssigen Polyenen auf der Basis von Trimethylolpropandiallylether und Toluoldiisocyanaten, Polythiolen und Siliconöl.

Die Mischungen i) bis v) sind in den US—PSS 4,442,198, 4,045,516, 3,925,320, 3,824,104 und 3,752,720 beschrieben.

Ist der Kleber b6) ein Gemisch B) von Verbindungen mit mindestens einer Epoxidgruppe und einer ethylenisch ungesättigten Doppelbindung in einem Molekül und aus einem radikalbildenden Photoinitiator, wie oben definiert, so werden als photopolymerisierbare Komponenten beispielsweise die Verbindungen eingesetzt, die in den US—PSS 3,450,613 und 4,220,513 oder in der EP—A 119,959 beschrieben sind.

Als bevorzugte Beispiele von photopolymerisierbaren Verbindungen dieses Typs, die in den Gemischen B) Verwendung finden, seien genannt

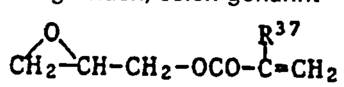

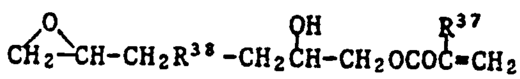 oder

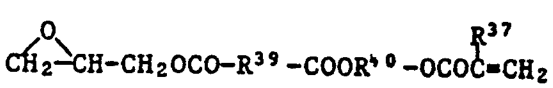 ,

worin $R^{37}$ Wasserstoff, Chlor, Brom oder $C_1$—$C_4$Alkyl, insbesondere Wasserstoff oder Methyl, bedeutet, $R^{38}$ den Rest einer Di- oder Polyglycidylverbindung nach Entfernung von zwei Glycidylresten, —OOC$R^{39}$COO— den Rest einer Di- oder Polycarbonsäure und $R^{40}$ eine $C_1$—$C_6$-Alkylengruppe bedeuten; $R^{38}$ steht vorzugsweise für den Rest eines zweiwertigen Phenols, insbesondere eines Bisphenols, nach Entfernung der beiden phenolischen H-Atome, oder eines Hydantoins nach Entfernung der beiden amidischen H-Atome; —OOC$R^{39}$COO— steht vorzugsweise für den Rest einer aromatischen, cycloaliphatischen oder araliphatischen Dicarbonsäure, oder einer aromatischen Tri- oder Tetracarbonsäure, beispielsweise der Phthal-, Trimellit-, oder Pyromellitsäure.

$R^{40}$ steht vorzugsweise für einen Ethylen-, Propylen-, oder Butylenrest.

Spezifische Beispiele für Verbindungen dieses Typs sind: 2-(4-(Glycidyloxyphenyl)-2-(4-(3-acryloyloxy-2 - hydroxypropoxy) - phenyl) - propan, 2 - (4 - (Glycidyloxyphenyl)-2-(4-(2-hydroxy-3-methacryloyloxy)-propoxy)-phenyl)-propan, 1-(2-Methacryloyloxyethoxycarbonyl)-2,4- und -2,5-bis-(glycidyloxycarbonyl)-benzol, 1-(2-Acryloyloxyethoxycarbonyl)-2,4- und -2,5-bis(glycidyloxycarbonyl)-benzol, 1-Glycidyl-3-(3-acryloyloxy-2-hydroxypropyl)-5,5-dimethylhydantoin, 1-Glycidyl-3-(2-hydroxy-3-methacryloyloxypropyl)-5,5-dimethylhydantoin und das Reaktionsprodukt von 3,4-Epoxycyclohexylmethyl-3',4'-epoxycyclohexancarboxylat mit 1 Aequivalent Acryl- oder Methacrylsäure.

Gemische des Typs C), die ebenfalls als Kleber b6) in den erfindungsgemässen Beschichtungen eingesetzt werden können, bei denen die Epoxyfunktion und die ethylenisch ungesättigte C-C-Doppelbindung in verschiedenen Molekülen auftreten, sind beispielsweise in der DE—OS 2,803,881 oder in der US—PS 4,090,936 beschrieben.

Enthalten kleberformulierungen b5) Epoxidverbindungen, so sind hier solche Verbindungen bevorzugt, die sich im wesentlichen von aromatischen, cycloaliphatischen oder araliphatischen Verbindungen ableiten. Es können jedoch auch kleinere Anteile an aliphatischen Verbindungen zugegeben werden.

Die Reste Z', X und X' der Formeln Ia und Ib besitzen die Bedeutung, wie in der EP—A 132,221 definiert. Der Rest $Z_1$' in Formel III bestizt die Bedeutung wie für den Rest Z' definiert.

Die Reste $X_1$ und $X_1$' in den Formeln II und III besitzen die Bedeutung, wie in der EP—A 134,752 für den Rest R definiert.

Die Reste $Z_1$' und $X_1$' in den Formeln II und III sind vorzugsweise aromatische Reste.

$X_1$ in der Formel II ist bevorzugt ein aromatischer Rest, ein cycloaliphatischer Rest oder ein Siloxanrest.

Die Reste $X_1$ in Formel II und $R^2$ in Formel IX besitzen vorzugsweise die Strukturen der Formeln Ic, Id oder Ie, wie bereits weiter oben für den Rest X in Formel Ia als bevorzugt definiert.

Ganz besonders entsprechen diese Reste $X_1$ und $R^2$ den Formeln

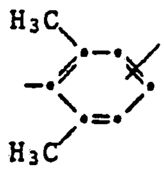 , 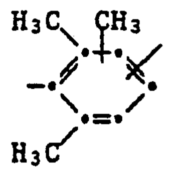 , 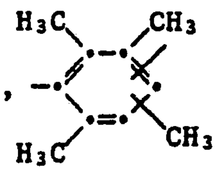 , 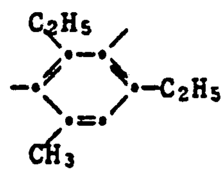 ,

worin die freien Bindungen in Meta- oder Parastellung zueinander stehen, oder der Formel

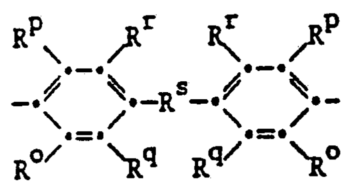

und worin die Reste $R^o$, $R^p$, $R^q$, $R^r$ und $R^s$ die bereits weiter oben definierte Bedeutung besitzen.

Unter den zweikernigen Resten sind insbesondere solche bevorzugt, in denen $R^o$, $R^p$, $R^q$ und $R^r$ für Methyl stehen.

Copolyimide, die mindestens 2 verschiedene Reste dieser Formeln enthalten, werden bevorzugt im Rahmen dieser Erfindung eingesetzt.

Diamine mit diesen Gruppen $X_1$ sind in der US—PS 4,030,948 beschrieben.

Steht X, $X_1$ oder $R^2$ für einen Siloxanrest, so handelt es sich dabei bevorzugt um einen Rest der Formel $-(CH_2)_3-Si(CH_3)_2-O-Si(CH_3)_2-(CH_2)_3-$.

Weitere geeignete Diamine mit einer Siloxangruppen enthaltenden Gruppe X, $X_1$ oder $R^2$ sind in der US—PS 3,435,002 und in der EP—A 54,426 beschrieben.

Beispiele für bevorzugte Diaminreste $X_1$' in Formel III, $R^2$, in Formel IX oder $Z_2$' in Formel sind die Gruppen

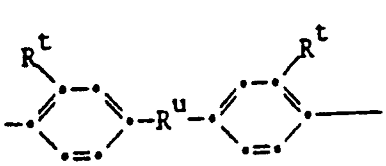 , 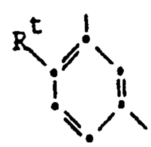 und

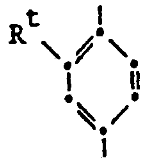 ,

wie sie bereits weiter oben als für X' in Formel Ib bevorzugt definiert wurden.

Die Reste Z' in Formel Ib und $Z_1$' in Formel III sind vorzugsweise aromatisch.

Bei den bevorzugten Resten Z′ in Formel Ib, $Z_1'$ in Formel III oder $Z_2$ in Formeln XVII, XVIII und XIX handelt es sich um

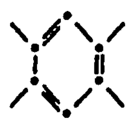 , 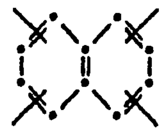 , 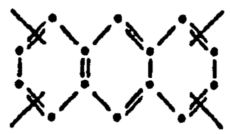 ,

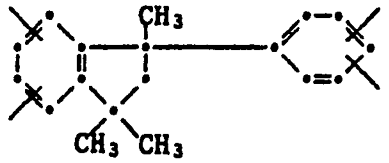 und 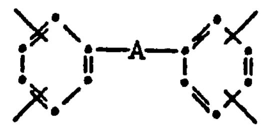

worin A eine direkte Bindung oder eine Brükengruppe der Formel —O, —$SO_2$—, —$CH_2$—, —$C(CF_3)_2$—, —$Si(CH_3)_2$— und besonders —CO— ist. Soll das betreffende Polyimid als Kleber eingesetzt werden, so bedeutet die Brückengruppe A vorzugsweise auch —CH(OH)—.

Die Polyimide, die als Folien- oder Klebematerialien im Rahmen dieser Erfindung engesetzt werden, können nach an sich bekannten Kondensationsverfahren aus Carbonsäureanhydriden und Diaminen erhalten werden; diese Herstellungsverfahren sind in den oben erwähnten Patentanmeldungen beschrieben. Zum Einsatz für die Beschichtung dieser Erfindung eignen sich insbesondere Homopolyimide, wie oben definiert, oder Copolyimide, die durch Copolykondensation der oben erwähnten Homopolyimidbausteine mit folgenden Carbonsäuredianhydriden und Diaminen oder deren Mischungen erhältlich sind:

a) Tetracarbonsäuredianhydride:
Pyromellitsäuredianhydrid,
3,3′,4,4′-Benzophenontetracarbonsäuredianhydrid,
2,2′,3,3′-Benzophenontetracarbonsäuredianhydrid,
3,3′,4,4′-Biphenyltetracarbonsäuredianhydrid,
2,2′,3,3′-Biphenyltetracarbonsäuredianhydrid,
3,3′-Isopropylidendiphthalsäureanhydrid,
Hexafluor-2,2-bis-(3,4-dicarboanhydrido-phenyl)-propan, und bei Verwendung des Polymids als Kleber auch noch
4,4′-Hydroxymethylendiphthalsäureanhydrid, und

b) Diamine:
3,3′- und 4,4′-Diaminodiphenylsulfon,
Bis-(4-aminophenyl)-bis-(trifluormethyl)-methan,
Bis-(3-aminophenyl)-bis-(trifluormethyl)-methan,
Bis-(3-amino-4-methylphenyl)-bis-(trifluormethyl)-methan,
4,4′-Diaminobenzophenon,
Bis-(4-aminophenyl)-dimethylsilan,
4,4′-Methylen-bis-(3-methylanilin),
4,4′-Methylen-bis-(2-ethylanilin),
4,4′-Methylen-bis-(2-methoxyanilin),
4,4′-Methylen-bis-(2-methylanilin),
4,4′-Sulfonyl-bis-(2-methylanilin),
3,3′-Dimethyl-4,4′-diaminobenzophenon,
4,4′-Oxydianilin,
4,4′-Isopropylidenanilin,
Diaminotoluol,
4,4′-Methylen-bis-(3-carboxyanilin) und dessen Ester, sowie
5-Amino-(4-aminophenyl)-1,3,3-trimethylindan.

$R^x$ in Formel V kann als Alkyl oder Alkoxy linear oder verzweigt sein und enthält vorzugsweise 1 bis 4 C-Atome. Beispiele sind Methyl, Methocy, Ethyl, Ethoxy, n-Propyl, n-Propoxy, Isopropyl, Isopropoxy, Butyl und Butoxy. $R^x$ als Halogen ist bevorzugt Chlor und in der —$C_eH_{2e}$-Gruppe ist e bevorzugt 1 oder 2. In Formel V steht n′ bevorzugt für 0.

$R^v$ bzw. $R^w$ als Alkyl enthalten bevorzugt 1 bis 4 C-Atome. Das Alkyl kann linear oder verzweigt sein. Beispiele sind Methyl, Ethyl, n-Propyl, Isopropyl und Butyl. In der —$C(C_eH_{2e})$-Gruppe ist e bevorzugt 1 oder 2.

Y′ in Formel V ist bevorzugt eine direkte Bindung, —O—, —S—, —$CH_2$— oder —CO—.

$Q_1$ in Formel IV ist der dreiwertige aromatische Rest einer Aminodicarbonsäure. Bei den aromatischen Resten handelt es sich vorzugsweise um ein- oder zweikernige Phenylreste, wie z.B. Phenyl, Naphthyl oder Bisphenylene. Die Reste können durch Halogen, z.B. Chlor, oder Cyano oder Nitro substituiert sein.

Wenn die Polyimide einen Rest der Formel IV enthalten, kann $Z_1$ in Formel II auch nur der vierwertige Rest einer Benzophenontetracarbonsäure sein, z.B. solche der Formeln

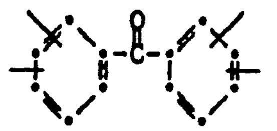

,

worin die freien Bindungen in Orthostellung gebunden sind.

Die Strukturelemente der Formel II sind bevorzugt in einer Menge von 5—100 Mol-%, bevorzugter 30—100 Mol-%, besonders 60—100 Mol-% und insbesondere 80—100 Mol-% und die Strukturelemente der Formel III bevorzugt in einer Menge von 95—0 Mol-%, bevorzugter 70 bis 0 Mol-%, besonders 60 bis 0 Mol-% und insbesondere 20 bis 0 Mol-% enthalten.

Die freien Bindungen in den Resten der Formeln V bis VII sind bevorzugt in Meta- und Parastellung zur CO-Gruppe gebunden.

Die Reste $R^{2'}$, $R^2$, $R^3$, $R^4$ und $R^5$ der Struckturelemente der Formeln IX und X besitzen beispielsweise folgende Bedeutung:

$R^3$ is als Halogen bevorzugt F oder Cl. Beispiele für $R^3$ als Alkyl, Alkoxy und Alkylthio sind Methyl, Ethyl, Propyl, i-Propyl, Butyl, Pentyl, Hexyl, Methoxy, Ethoxy, Propoxy, Methylthio, Ethylthio und Benzylthio.

Bei der Brückengruppe $R^4$ kann es sich zu Beispiel um Reste wie —O—, —S—, —SO—, —$SO_2$—, —CO—, Ethyliden, 2,2-Propyliden, —$CH_2$— oder —$C(CF_3)_2$— handeln.

$R^5$ ist als Aroyl besonders Benzoyl. Bevorzugt ist $R^5$ ein Wasserstoffatom.

Als Beispiele für $R^2$ und $R^{2''}$ als cycloaliphatische, araliphatische oder aromatische Reste lassen sich diejenigen Gruppen nennen, die bereits für die Diaminreste R und R′ in der EP—A 134,752 beispielhaft erwähnt wurden.

Die im Rahmen dieser Erfindung eingesetzten Polyimide weisen mittlere Molekulargewichte (Zahlenmittel) von vorzugsweise mindestens 5 000 auf. Die obere Grenze richtet sich im wesentlichen nach den Eigenschaften, die die Verarbeitbarkeit bestimmen, wie z.B. deren Löslichkeit. Sie kann bis zu 500 000, vorzugsweise bis zu 100 000 und besonders bis zu 60 000 betragen. Es kann sich ferner um statistische Polymere oder um Blockpolymere handeln.

Die Menge an Strukturelementen der Formeln Ia, IX, X, XI und XII richtet sich im wesentlichen nach der gewünschten Lichtempfindlichkeit der Homo- oder Copolymeren und nach deren Aufbau. Die Menge kann 5 bis 100 Mol-%, vorzugsweise 20 bis 100 Mol-%, besonders 40 bis 100 Mol.-% insbesondere 50 bis 100 Mol.-% betragen, bezogen auf das Polymer.

Die Reste $R^6$, $R^7$ und $R^8$ des Strukturelementes der Formel XI haben beispielsweise die folgende Bedeutung:

$R^7$und $R^8$ sind als Halogen beispielsweise Fluor oder Chlor, als Aryl Phenyl, als Aryloxy Phenoxy und enthalten als Alkyl und Alkoxy bevorzugt 1—12, insbesondere 1—4, C-Atome. Beispiele sind Methyl, Ethyl, n-Propyl, i-Propyl, Butyl, Methoxy und Ethoxy.

Der aromatische Rest $R^6$ ist bevorzugt in mindestens einer, besonders in beiden Orthostellungen zum N-Atom durch Alkyl oder Aralkyl substituiert. Der Substituent ist als Aralkyl besonders Benzyl. Als Alkyl enthält der Substituent bevorzugt 1—12, insbesondere 1—4 C-Atome. Das Alkyl kann linear oder verzweigt sein. Besonders bevorzugt sind Methyl, Ethyl und Isopropyl. Weitere Beispiele sind n-Propyl, n-Butyl, Isobutyl, Pentyl, Hexyl, Octyl, Decyl und Dodecyl.

Die Reste $R^9$, $R^{10}$, $R^{11}$, $R^{12}$, $R^{13}$, $R^{14}$, $R^{15}$, $X_2$ und $Y_1$ der Homo- oder Copolyimidelemente der Strukturen XII, XIII und XIV besitzen bevorzugt die Bedeutungen, wie in der EP—A 138,768 definiert.

Die Reste $Z_2$, $Z_2'$, $R^{17}$ bis $R^{27}$ in den Strukturelementen XVII, XVIII und XIX, sowie die organischen chromophoren Polyazide, besitzen die Bedeutungen, wie in der EP—A 141,781 beispielhaft erwähnt.

Die Rest $R^{41}$ und $R^{42}$ der Haloniumsalze XXXIII können durch einen oder mehr einwertige Reste substituiert sein, z.B . Alkyl oder Alkoxy mit 1 bis 8 C-Atomen, Halogen wie F, Cl oder Br, Nitro oder Cyano. Beispiele für Reste $R^{41}$ und $R^{42}$ sind Phenyl, Toluyl, Xylyl, Chlorphenyl, Nitrophenyl, Methoxyphenyl und Pyridyl. $R^{41}$ und $R^{42}$ zusammen kann, z.B. 2,2′-Biphenylen oder 2,2′-Bipyridyl sein, $X^a$ steht besonders für Iod und $q_4$ besonders für 1. $Q^a$ ist bevorzugt Cl und besonders F. $L_2$ ist bevorzugt Bor, Phosphor oder Antimon.

Die Reste $R^{43}$ und $R^{44}$ der Iodosylsalze XXXIV sind bevorzugt Phenyl oder Naphthyl, die ein- oder mehrfach substituiert sein können, z.B. mit $C_1$—$C_4$-Alkyl oder -Alkoxy, Phenyl, Nitro oder Halogen. $Q^b$ ist bevorzugt Cl und besonders F und $q_5$ steht bevorzugt für 1. $L_3$ ist bevorzugt Bor, Phosphor oder Antimon. Ein Beispiel für diese Salze ist Diphenyliodosylhexafluorphosphat oder -antimonat.

Die Reste $R^{45}$, $R^{46}$ und $R^{47}$ der Sulfoniumsalze XXXV sind bevorzugt carbocyclische aromatische Reste wie Phenyl oder Naphthyl. Die Können ein- oder mehrfach substituiert sein, z.B. durch $C_1$—$C_4$-Alkyl, $C_1$—$C_4$-Alkoxy, Phenyl, Nitro oder Halogen. $Q^c$ steht bevorzugt für Cl und besonders F und $q_6$ ist bevorzugt 1. $L_4$ ist bevorzugt Bor, Phosphor oder Antimon. Ein Beispiel ist Triphenylsulfoniumhexafluorphosphat oder -antimonat.

Die Gruppen $Y_3$, Q, M und $X_4$ in den Metallcarbonylkomplexen der Formel XXVIII besitzen diejenigen beispielhaften Bedeutungen und Bevorzugungen, wie in der EP—A 94,914 erwähnt. Die Reste $R^{48}$, $R^{49}$, Me,

Q' und L der Komplexsalze der Formel XXIX besitzen diejenigen beispielhaften Bedeutungen und Bevorzugungen, wie in der EP—A 94,915 erwähnt.

Ganz besonders bevorzugte Beispiele für geeignete Gruppen $R^{48}$ sind Benzol, Toluol, Xylole, Ethylbenzol, Isopropylbenzol, Methoxybenzol, Ethoxybenzol, Dimethoxybenzol, Trimethylbenzol, Naphthalin, 1,2-Dihydronaphthalin, 1,2,3,4-Tetrahydronaphthalin, Methylnaphthaline, Methoxynaphthaline, Ethoxynaphthaline, Biphenyl, Terphenyl, Stilben, Inden, Indan, Hydroxyindane, Methoxyindane, Biphenylen, Fluoren, Phenanthren, Anthracen, 9,10-Dihydroanthracen, Triphenylen, Thiophen, Furan, Benzothiophen, Benzofuran, Chromen, Xanthen, Thioxanthen, Naphthothiophen, Thianthren, Diphenylenoxid und Diphenylensulfid.

Ganz besonders bevorzugte Beispiele für geeignete Gruppen $R^{49}$ sind das Cyclopentadienylanion oder das Indenylanion, wobei diese Anionen durch gleiche oder verschiedene Reste wie $C_1$—$C_8$Alkyl oder $C_1$—$C_8$Alkoxy substituiert sein können.

Beispiele für Substituenten am Cyclopentadienyl- oder Idenylanion sind Methyl, Ethyl, n-Propyl, Isopropyl, n-Butyl, sek.-Butyl, tert.-Butyl, n-Pentyl, n-Hexyl und n-Octyl, Methoxy, Ethoxy, n-Propoxy, Isopropoxy, n-Butoxy, n-Hexyloxy und n-Octyloxy.

Die Gruppen $R^{32}$, $R^{33}$, Q'' und $L_1$ besitzen diejenigen beispielhaften Bedeutungen und Bevorzugungen, wie in den EP—A 126,712 und 152,377 erwähnt.

Das erfindungsgemäss beschichtete Material kann durch Aufbringen einer Klebschicht auf ein Substrat und nachfolgender Kontaktierung mit einem Polyimidfilm erfolgen (Verfahren I). Es kann aber auch eine einseitig klebstoffbeschichtete Polyimidfolie auf ein Substrat aufgeklebt werden (Verfahren II). Bei dieser Folie aus Verfahren II handelt es sich somit um eine selbstklebende, freitragende und photostrukturierbare Polyimidfolie.

Das Aufbringen des Klebers bei Verfahren I erfolgt zweckmässigerweise durch Beschichtung des Substrates mit einer Klebstofflösung oder mit einem flüssigen Klebstoff(gemisch).

Die klebstoffbeschichtete Polyimidfolie des Verfahrens II ist vorzugsweise auf der Klebstoffseite mit einer zusätzlichen Deckfolie versehen, so dass eine völlige trockene aufwickelbare Folie entsteht.

Durch Abziehen dieser Schutzschicht kann dann die klebstoffbeschichtete Polyimidfolie direkt auf das Substrat auflaminiert werden. Gegebenenfalls erfolgt dieses Auflaminieren unter Erhitzen auf einen Temperaturbereich von 30—230°C, wobei die Klebeschicht entsprechend erweicht und sich dadurch mit dem Substrat verbindet.

Gegebenenfalls kann die Polyimidfolie auch auf der dem Klebstoff abgewandten Seite durch eine weitere nur temporär aufgebrachte Kunststofolie mechanisch verstärkt werden oder gegen Diffusion chemischer Substanzen wie Luftsauerstoff oder Lösungsmittel geschützt werden; dabei sollte diese zusätzliche Kunststoffolie leicht entfernbar sein; z.B. durch Abziehen oder, wenn möglich auch durch Abwaschen. Kunststoffverstärkte Polimidfolien können auch bei Verfahren I eingesetzt werden.

Die Dicke der Klebschicht ist im allgemeinen gering im Vergleich zur später aufzubringenden Polyimidfolie. Gegebenenfalls lässt man das Lösungsmittel nach dem Beschichtungsvorgang verdunsten. Dies kann bei erhöhter Temperatur erfolgen.

In der Regel wählt man eine solche Klebstoffkomposition, dass das gegebenenfalls verwendete Lösungsmittel die darüber aufgebrachte Polyimidfolie, die selbst in organischen Lösungsmitteln löslich ist, nicht auflösen, sondern allenfalls anlösen kann.

Verwendet man zur Herstellung des Klebers ein Lösungsmittel und gegebenenfalls weitere Zusätze, so eignen sich dafür beispielsweise folgende Lösungsmittel, die allein oder in Mischungen aus mindestens zwei Komponenten verwendet werden können:

Aliphatische Ketone, wie Cyclopentanon, Cyclohexanon, Cycloheptanon, Cyclooctanon, 4-Methylcyclohexanon, 3-Methylcyclohexanon oder 2-Methylcyclohexanon; aromatisch-aliphatische Ketone, wie Acetophenon, Propiophenon oder Butyrophenon; chlorierte Kohlenwasserstoffe, wie Methylenchlorid, Chloroform, Tetrachlorethylen, Chlorbenzol oder o-Dichlorbenzol; Ether, wie Ethylenglykoldimethylether, Diethylenglykoldimethylether, Tetrahydrofuran oder Dioxan; Etheracetale, wie Methylglykolacetat oder Ethylglykolacetat; sowie andere polare aprotische Lösungsmittel, wie Propylencarbonat oder Isophoron, die eine etwas schwächere Lösekraft als die stark lösenden polar aprotischen Lösungsmittel, wie N-Methylpyrrolidon, γ-Butyrolacton, oder N,N-Dimethylacetamid, haben.

Es können auch thermostabile, photostrukturierbare Kleber eingesetzt werden, die frei von Lösungsmitteln sind, oder die Kleber können in Kombination mit sogenannten Reaktivverdünnern eingesetzt werden, die photochemisch oder thermisch in nichtflüchtige Substanzen umgewandelt werden. Solche Reaktivverdünner, die gleichzeitig die darüberliegende Polyimidfolie anlösen können, sind beispielsweise 1-Vinylpyrrolidon für ethylenisch-ungesättigt vernetzende Systeme oder o-Kresylglycidylether für epoxidisch vernetzende Systeme.

Bevorzugt wählt man die Komposition des thermostabilen photovernetzbaren Klebers unterschiedlich von der Komposition des selbsttragenden, photovernetzbaren Polyimidfilms.

Bei der Herstellung des photostrukturierbaren Klebers können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammhemmer, Antioxidantien, Stabilisatoren, Farbstoffe, Pigmente, Haftvermittler und Antihalofarbstoffe, wie sie z.B. in der US—PS 4 349 619 beschrieben sind.

Beim erstgenannten Verfahren I kann der photostrukturierbare, thermostabile Kleber mittels üblicher

Methoden wie Tauch-, Streich- und Sprühverfahren, Schleuder-, Kaskadenguss- und Vorhanggussbeschichtung, auf geeignete Substrate bzw. Trägermaterialien, aufgebracht werden.

Geeignete Substrate sind z.B. Kunststoffe, beispielsweise flexible Kunststoffolien, Metalle, beispielsweise Al, Cu, Sn, Ag und Au, Metallegierungen, Halbmetalle, Halbleiter, beispielsweise Si, Ge oder III—V Halbleiter, beispielsweise Galliumarsenid, oder Materialien wie Glas, Keramik oder andere anorganische Materialien, wie z.B. $SiO_2$ oder $Si_3N_4$.

Auf die klebende Oberfläche wird anschliessend die Polyimidfolie aufgebracht. Diese kann beispielsweise dadurch erfolgen, dass man ein passendes Folienstück zurechtschneidet und auf die Oberfläche bringt, gegebenenfalls unter Anpressen. Die Beschichtung kann aber auch automatisch erfolgen, beispielsweise nach einem in der Laminiertechnik üblichen Verfahren zum Aufbringen von Folien.

Das Verfahren II führt ebenfalls zu den erfindungsgemässen Beschichtungen. Die klebstoffbeschichtete Polyimidfolie dieses Verfahrens wird nach einer in der Technik üblichen Methode zur Herstellung solcher Anordnungen erhalten. Gegebenenfalls besitzt diese Folie auf der Klebstoffseite noch eine Schutzfolie, die vor der Anwendung abgezogen werden muss. Die Klebfolie wird, wie oben beschrieben, manuell oder automatisch auf ein Substrat aufgebracht.

Das Substrat kann, ebenso wie in Verfahren I, vor dem Beschichtungsvorgang noch oberflächenbehandelt werden. Beispielsweise kann man es mit einem Haftvermittler vorbehandeln.

Das erfindungsgemäss beschichtete Substrat wird anschliessend durch Strahlung bildmässig belichtet und die unvernetzten Anteile beider Teile der Doppelbeschichtung werden darauf mit einem geeigneten Entwickler herausgelöst.

Die Photostrukturierung bzw. Photovernetzung kann durch energiereiche Strahlung verschiedener Art hervorgerufen werden, z.B. durch Licht, insbesondere im UV-Bereich, durch Röntgenstrahlen, Synchrotronstrahlung, Laserlicht oder Elektronenstrahlen.

Die bildmässige Belichtung erfolgt in an sich bekannter Weise, beispielsweise durch eine Photomaske. Die Belichtung erfolgt vorzugsweise von der Seite des Polyimidfilms her; sie kann aber auch, bei transparenten Substraten, von der Substratseite her erfolgen.

Geeignete Entwickler sind organische Lösungsmittel oder Lösungsmittelgemische, die nur die nicht photovernetzten Anteile auflösen können.

Nach dem Entwickeln kann das Bild gegebenenfalls durch eine thermische oder photochemische Nachbehandlung stabilisiert werden.

Der Entwickler wird so gewählt, dass sowohl die aufgebrachte Polyimidfolie aus auch der darunterliegende thermostabile, photostrukturierbare Kleber gleichermassen gut herausentwickelt werden.

Eine besondere Ausführungsform der Erfindung betrifft ein beschichtetes Material enthaltend in aufeinanderfolgender Reihenfolge:

a) ein Substrat mit einer streuenden Oberfläche, das gegebenenfalls durchbrochen ist,

b) eine Schicht eins photostrukturierbaren negativ arbeitenden thermostabilen Klebers und

c) einen selbsttragenden photovernetzbaren Polyimidfilm,

wobei die Klebschicht b) strahlungsabsorbierende Zusätze in einer solchen Menge aufweist, dass an der Substratoberfläche lateral gestreutes Licht nicht in die Klebschicht b) und in die Polyimidschicht c) vordringen kann.

Unter einer streuenden Oberfläche wird eine Oberfläche verstanden, von der mindestens 5% des auf sie auftreffenden Lichtes lateral gestreut werden. Als strahlungsabsorbierende Zusätze werden im allgemeinen solche Farbstoffe oder Kombinationen von Farbstoffen der Klebschicht b) zugesetzt, die diejenige Strahlung zu absorbieren vermögen, die einerseits durch die Polyimidfolie dringt und die andererseits die Photovernetzung des Polyimids und des Klebers auslösen kann. Die absorbierenden Farbstoffe können zusätzlich als Sensibilisatoren oder als Photoinitiatoren der Härtung des Klebers b) wirden.

Das erfindungsgemässe Material eignet sich hervorragend zur Herstellung von Schutzfilmen, Passivierlacken, und als photographisches Aufzeichungsmaterial für thermostabile Reliefabbildungen.

Die Schutzschichten und Abbildungen zeichnen sich durch ihre hohe Thermostabilität aus sowie durch keinen oder nur einen geringen Schwund bei thermischer Belastung, was in der Anwendung erhebliche Vorteile hat, weil praktisch keine Verzerrung der abgebildeten Strukturen beobachtet wird.

Die Schutzfilme und Reliefabbildungen zeichnen sich weiterhin durch hohe Haftfestigkeit und thermische, mechanische und chemische Widerstandsfähigkeit aus. Das erfindungsgemäss beschichtete Material ist lagerstabil, aber vor Lichteinwirkung zu schützen.

Die Erfindung betrifft daher auch ein Verfahren zur Herstellung von Reliefabbildungen mittels eines photolithographischen Prozesses, umfassend folgende Arbeitsschritte:

i) Beschichtung einer Substratoberfläche mit einem photostrukturierbaren negativ arbeitenden thermostabilen Klebmittel und gegebenenfalls Verdunsten des Lösungsmittels,

ii) Aufbringen eines selbsttragenden photostrukturierbaren Polyimidfilmes auf die klebmittelbeschichtete Oberfläche, gegebenenfalls unter Anwendung von Druck und/oder Wärme,

iii) bildmässige Belichtung der Anordnung mit aktinischer Strahlung von der Seite des Polyimidfilms oder des Substrats, und

iv) Entwickeln des Systems mit einem geeigneten Entwickler, der an den unbelichteten Stellen sowohl den Polyimidfilm als auch den Klebmittelfilm entfernt.

Ferner betrifft die Erfindung ein Verfahren zur Herstellung von Reliefabbildungen mittels eines photolithographischen Prozesses, umfassend folgende Arbeitsschritte:

i) Beschichtung einer Substratoberfläche mit der Klebseite eines aus Photostrukturierbarem negativ arbeitendem thermostabilem Klebmittel und selbsttragendem photostrukturierbarem Polyimidfilm bestehenden Zweischichtsystems, gegebenenfalls unter Anwendung von Druck und/oder Wärme,

ii) bildmässige Belichtung der Anordnung mit aktinischer Strahlung von der Seite des Polyimidfilms oder des Substrates und

iii) Entwickeln des Systems mit einem geeigneten Entwickler, um an den unbelichteten Stellen sowohl den Polyimidfilm als auch den Klebmittelfilm zu entfernen.

Des weiteren betrifft die Erfindung die nach einem der oben beschriebenenen Verfahren erhaltenen Reliefabbildungen.

Diese Abbildungen lassen sich als Schutz-, Isolier- oder Passivierschichten, als Dielektrika, als Lötstopmasken oder als Zwischenlagen (interlayers) in Halbleiterbausteinen (diskret oder integriert), Hybridschaltungen, Leiterplatten oder Multilayers verwenden. Auch beitet sich die Verwendung auf keramischen Substraten an (als Schutz von Speicherbausteinen gegen α-Strahlung) oder der Einsatz beim Tape Automated Bonding Verfahren.

Weitere Anwendungsgebiete sind Photomasken für den Textildruck und das graphische Gewerbe, Aetzresist oder Galvanoresist zur Herstellung gedruckter Schaltungen, Druckplatten und integrierter Schaltkreise, Relais für die Herstellung von Röntgenmasken oder Strukturelement für Flüssigkristallanzeiger.

Die Erfindung betrifft daher auch die Verwendung der Reliefabbildungen für einen der oben genannten Zwecke.

Die folgenden Beispiele dienen zur Illustration der Erfindung:

I. Allgemeine experimentelle Bedingungen

Als Substrate dienen Blättchen der Grösse 63 × 63 mm, bestehend aus Kupfer, kupferkaschiertem Epoxidlaminat oder Keramik. Ausserdem werden 3-Zoll-Silizium-Wafer mit einer oberflächlichen 0.1 µm starken $SiO_2$-Schicht verwendet.

Sowohl die Herstellung des photostrukturierbaren selbsttragenden Polyimidfilmes vor der Verklebung als auch das Auftragen des thermostabilen photostrukturierbaren Klebers erfolgen mittels der Schleudertechnik. Der Kleber wird dabei in der gewünschten Stärke entweder direkt auf das Substrat oder auf die Polyimidfolie aufgeschleudert, und die Folie wird danach manuell aufgebracht. Das Trocknen, b.z.w. das Erwärmen der beschichteten Substrate wird mittels der sog. "Hot-plate-Technik" durchgeführt, d.h. durch gleichmässiges kontrolliertes Erhitzen von der Unterseite des Substrats. Zur Belichtung verwendet man je nach Substrat und benötigter Auflösung eine Metall-Halogenid-Kopierlampe (Modell Ultralux, 5000 W der Firma Staub) bei einem Abstand von 25 cm zwischen Lampe und Substrat oder eine Masken Justier- und Belichtungsmaschine der Firma Carl Süss. Diese erzeugt eine Lichtleistung von 22—25 $mW/cm^2$, bezogen auf die Messsonde von 400 nm der Firma Optical Associates Inc.

Entwickelt wird in einem Sprühentwickler durch Aufsprühen der Entwicklerlösung, bzw. der Waschlösung mittels Sprühdüsen bei einem Sprühdruck von 1,5 bar.

Als Testmuster dienen für die beschichteten Kupfer-kaschierten Substrate der 1-T Resolution Guide der Firma Stouffer Graphic Arts Equipment Co. Für die beschichteten Wafer und keramischen Substrate nimmt man das USAF 1951 Testmuster der Firma Itek Optical Systems Division, wobei durch Verwendung von Masken entgegengesetzter Tönung sowohl freistehende Stege als auch isolierende Gräben erzeugt werden können.

Zur Ueberprüfung der Haftung wird eine Chrommaske benutzt, die Reihen freistehender Felder der Grösse 2.9 × 7.3 mm entstehen lässt.

Die Inspektion der erhaltenen Reliefbilder erfolgt im optischen Mikroskop als auch durch Rasterelektronenmikroskopische Aufnahmen. Die Schichtdicken bestimmt man mit einem Profilometer "Alphastep" der Firma Tencor.

II. Herstellungsbeispiele

Herstellungsbeispiel 1

Aus einem zyklisierten Copolyimid, erhalten aus 75 Mol-% 1,4-Diaminotetramethylbenzol und 25 Mol-% 4,4'-Diamino-3,3',5,5'-tetramethyldiphenylmethan polymerisiert mit 3,3',4,4'-Benzophenontetracarbonsäuredianhydrid, das eine inhärente Viskosität von 0,93 (0,5% in NMP bei 25°C) besitzt, wird eine 13%ige Lösung in Gammabutyrolacton hergestellt. Diese filtriert man auf 0,8 µm und schleudert sie bei 900 U/min für 12 sec. auf Siliziumwafer, die nicht mit einem Haftvermittler versehen worden sind. Man trocknet von einer Temperatur von 40°C bis 80°C im Verlauf einer Stunde, danach belässt man 25 min bei 80°C. Man erhält gleichmässige formstabile Filme A der Stärke 26,0 µm, die sich durch Anritzen und Abziehen auf ein beliebiges Substrat übertragen lassen.

Herstellungsbeispiel 2

Man verfährt wie in Herstellungsbeispiel 1, wobei das Polymere aus 55 Mol-% 1,4-Diaminotetramethylbenzol und 45 Mol-% 4,4'-Diamino-3,3'-dimethyl-5,5'-diethyldiphenylmethan polymerisiert mit 3,3',4,4'-Benzophenontetracarbonsäuredianhydrid und Zyklisieren hergestellt wurde und eine inhärente Viskosität von 1,0 besitzt.

Eine 12,0%-ige Lösung dieses Polymeren wird 12 sec lang bei 1050 U/min auf Wafer aufgeschleudert, die nicht mit einem Haftvermittler versehen sind. Nach dem Trocknen wie in Herstellungsbeispiel 1 erhält man gleichmässige und formstabile Polyimid-Filme B der Stärke 23 µm, die sich nach Anritzen und Abziehen auf ein beliebiges Substrat übertragen lassen. Schleudert man 12 sec lang bei 2000 U/min auf, so erhält man gleich gleichmässige und formstabile Polyimidfilme B-2 der Stärke 10 µm.

Herstellungsbeispiel 3

Wie in Herstellungsbeispiel 1 wird ein zyklisiertes lösliches Polyimid aus

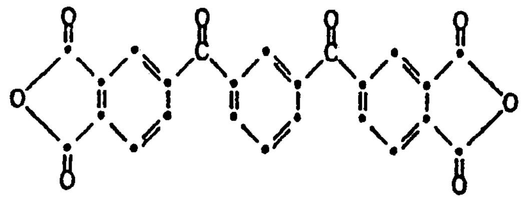

und 4,4'-Diamino-3,3',5,5'-tetramethyldiphenylmethan hergestellt. Von dem Polymeren, das eine inhärente Viskosität von 0.52 besitzt, wird eine 15%-ige Lösung in 4-Butyrolacton hergestellt und auf 1.2 µm filtriert. Nach dem Aufschleudern auf Wafer, die nicht mit einem Haftvermittler versehen sind (10 sec, 900 U/min) und nach Trocknen bei 80°C (60 min) erhält man gleichmässige und formstabile Polyimid-Filme C der Stärke 10 µm, die sich nach Anritzen und Abziehen auf ein beliebiges Substrat übertragen lassen.

Herstellungsbeispiel 4

Aus dem Polymeren der Herstellungsbeispiels 2 wird eine 4.5%ige Lösung in Cyclohexanon hergestellt, die man auf 0,65 µm filtriert. Diese Lösung verwendet man als "Kleberlösung 1".

Herstellungsbeispiel 5

Aus einem zyklisierten Copolyimid erhalten aus 55 Mol-% 1,4-Diaminotetramethylbenzol, 42 Mol-% 4,4'-Diamino-3,3'-dimethyl-5,5'-diethyldiphenylmethan und 3 Mol-% 1,3-Bis-(3-Aminopropyl)-1,1,3,3-tetramethyldisiloxan durch Polymerisation mit 3,3',4,4'-Benzophenontetracarbonsäuredianhydrid stellt man eine 5,0%-ige Lösung in Cyclohexanon her und erhält so nach der Filtration auf 0.65 µm "Kleberlösung 2".

Herstellungsbeispiel 6

Die Kleberlösung 2 aus Herstellungsbeispiel 5 wird, bezogen auf das Polymere, mit 6.0% 2,6-Bis-(4-azidobenzyliden)-4-methylcyclohexanon versetzt und erneut filtriert. Man erhält "Kleberlösung 3".

Herstellungsbeispiel 7

Einer Lösung, bestehend aus

— 75 Gew-% Cyclohexanon

— 17,5 Gew-% halbfestem Bisphenol-A-Epoxidharz mit einem Epoxidgehalt von 4,1 Mol/1000 g

— 7,5 Gew-% flüssigem Bisphenol-A-Epoxidharz mit einem Epoxidgehalt von 5,25 Mol/1000 g und einer Viskosität von 11'000 mPas bei 25°C werden, bezogen auf die gesamte Epoxidharzmenge zugesetzt

— 6,0 Gew-% des Komplexes

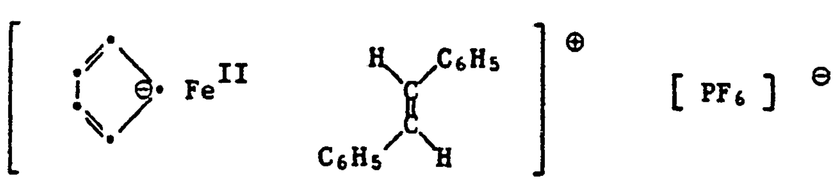

— 0,2 Gew-% Modaflow® (Verlaufsmittel der Firma Monsanto).

Nach dem Filtrieren auf 0,2 µm erhält man "Kleberlösung 4".

Herstellungsbeispiel 8

Einer Lösung, bestehend aus

— 72 Gew-% Cyclohexanon

— 25,5 Gew-% halbfestem Biphenol-A-Epoxidharz mit einem Epoxidgehalt von 4,1 Mol/1000 g

— 2,5 Gew-% flüssigem Bisphenol-A-Epoxidharz mit einem Epoxidgehalt von 5,25 Mol/1000 g und einer Viskosität von 11'000 mPas bei 25°C werden, bezogen auf die gesamte Epoxidharzmenge zugesetzt
— 6,0 Gew-% des Komplexes

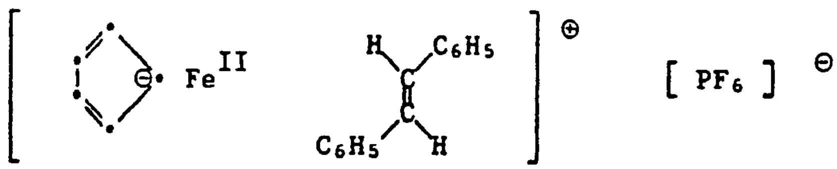

— 0,2 Gew-% Modaflow® (Verlaufsmittel der Firma Monsanto)
— 2,5 Gew-% Cumolhydroperoxid
— 3,5 Gew-% 2,6-Bis(4-azidobenzyliden)-4-methylcyclohexanon
— 0,7 Gew-% CI Solvent Yellow 145

Nach dem Filtrieren auf 0,2 µm erhält man "Klebelösung 5".

Herstellungsbeispiel 9

Entsprechend der Europ. Pat. Appl. 0'076'656, Beispiele 1 und 3, wird aus $CH_3SiCl_3$ (0.151 Mol), $C_6H_5SiCl_3$ (0.008 Mol) und $CH_2{=}CHSiCl_3$ (0.041 Mol) ein Organopolysilsequioxan hergestellt und in Substanz isoliert. Daraus wird nach der Formel

| | |
|---|---|
| Cyclohexanon | 44.78% |
| Cyclopentanon | 30.46% |
| N-Vinylpyrrolidon | 16.40% |
| 2,6-Bis(4-azidobenzyliden)-4-methylcyclohexanon | 0.40% |
| Organopolysilsesquioxan | 7.96% |

und Filtrieren auf 0,8 µm "Kleberlösung 6" hergestellt.

Herstellungsbeispiel 10

Die photoempfindliche Schicht einer kommerziell erhältlichen Trockenfilm-Lötstopmaske (Vacrel® 930, Fa. Dupont, 75 µm stark) wird mechanisch von der Trägerschicht entfernt und folgendermassen formuliert

| | |
|---|---|
| Cyclohexanon | 53.28% |
| Cyclopentanon | 36.27% |
| Di-π-methylcyclopentadienyl-Ti-bis(2,3,4,5,6-pentafluorphen-1-yl) | 0.50% |
| Trockenfilm-Substanz | 9.95% |

Nach dem Filtrieren durch einen Filter aus regenerierter Cellulose von 0.8 µm Porenweite erhält man "Kleberlösung 7".

Herstellungsbeispiel 11 (selbstklebende Folien)

Auf Wafer, die auf der Oberfläche Polyimidfilme des Herstellungsbeispiels 2 tragen, schleudert man bei 2'000 U/min für 25 sec. lang die Kleberlösung 4 aus Herstellungsbeispiel 7. Man trocknet 5 min lang von 45 bis 65°C und belässt dann 5 min bei 65°C. Man erhält selbstklebende photostrukturierbare Polyimidfolien, die man durch Anritzen und Abziehen vom Herstellungssubstrat trennen kann und die in ihrer freitragenden und selbstklebenden Form auf ein beliebiges Substrat aufgebracht werden können.

Herstellungsbeispiel 12 (selbstklebende Folie)

Auf einen Wafer, der auf der Oberfläche einen Polyimidfilm B-1 des Herstellungsbeispiels 2 trägt schleudert man bei 1'000 U/min für 25 sec. lang die Kleberlösung 5 aus Herstellungsbeispiel 8. Man trocknet 5 min lang von 45 bis 65°C und belässt dann 5 min bei 65°C. Man erhält eine selbstklebende photostrukturierbare Polyimidfolie, die man durch Anritzen und Abziehen vom Herstellungssubstrat trennen

kann und die in ihrer freitragenden und selbstklebenden Form auf ein beliebiges Substrat aufgebracht werden kann.

III. Applikationsbeispiele

Applikationsbeispiel 1

Auf ein Kupfer-kaschiertes Epoxid-Laminat schleudert man bei 3000 U/min 15 sec lang die Kleberlösung 1 aus Herstellungsbeispiel 4. Auf die teilweise angetrocknete, aber noch feuchte Oberfläche bringt man manuell die Polyimidfolie A aus Herstellungsbeispiel 1 auf, drückt an und erwärmt dann zuerst leicht bei 40°C für 15 min, sodann für 15 min bei 60°C. Man bedeckt mit einem 1-T Resolution Guide der Firma Stouffer Graphic Arts Equipment Co. und belichtet unter einer 5000 W Kopierlampe für 2 min. Danach wird im Sprühentwickler entwickelt, wobei man 300 sec lang eine Mischung aus Gammabutyrolacton und Toluol (1,00:0,95, Gewicht) und dann kurz reines Toluol aufsprüht. Man erhält scharfe hochaufgelöste Reliefbilder, die sehr gut auf dem Substrat haften.

Applikationsbeispiel 2

Auf ein Kupfer-kaschiertes Epoxid-Laminat bringt man manuell die selbstklebende Polyimidfolie aus Herstellungsbeispiel 11 auf. Man drückt den Film gut an, bedeckt mit einem 1-T Resolution Guide der Firma Stouffer Graphic Arts Equipment Co. und belichtet dann unter einer 5000 W Kopierlampe für 90 sec. Anschliessend bringt man das Substrat auf eine vorgeheizte Heizplatte und erhitzt die Beschichtung innert ca. 1 min auf 100°C, wobei die Polyimidfolie durch eine aufgelegte flache Abdeckung leicht an das Substrat gepresst wird. Man belässt die Anordnung für weitere 5 min zwischen 100 und 110°C und lässt abkühlen. Anschliessend entwickelt man in einem Sprühentwickler für 6,5 min mittels einem Gemisch von Cyclopentanon und Toluol (1,00 zu 0,65, Gewicht). Man erhält scharfe Bilder mit steilen Kanten, die sehr gut auf dem Substrat haften.

Applikationsbeispiel 3

Auf einen mit 0,1 µm $SiO_2$ beschichteten 3-Zoll-Wafer schleudert man zuerst bei 5'000 U/min und 20 sec lang eine Lösung des Haftvermittlers γ-Aminopropyltriethoxysilan, sodann 12 sec. lang bei 3'000 U/min die Kleberlösung 2 aus Herstellungsbeispiel 5. Sodann wird die Polyimidfolie A aus Herstellungsbeispiel 1 aufgebracht und zuerst 5 min bei 40°C, dann 20 min bei 60°C getrocknet. Man bedeckt mit der USAF 1951 Testmaske und belichtet mit einer Masken Justier- und Belichtungsmaschine 5 min im Vakuumkontakt bei einer Lichtleistung von 25 $mW/cm^2$.

Danach entwickelt man 300 sec lang durch Aufsprühen einer Mischung von Gammabutyrolacton und Toluol (1,00:0,95, Gewicht). Man erhält hochaufgelöste Strukturen der Stärke 26,5 µm.

Der Wafer wird sodann in einen Temperofen gebracht und unter Luftatmosphäre langsam auf 350°C erhitzt, bei dieser Temperatur 0,5 h belassen und dann abgekühlt. Unter dem Mikroskop sind keinerlei Veränderungen der Strukturen erkenntlich und die Schichtstärke beträgt nun 23,6 µm (89.1% der Ausgangsschichtstärke). Die Klebeschicht besitzt eine Stärke von 0,32 µm.

Applikationsbeispiel 4

Analog zu Applikationsbeispiel 3 wird ein mit 0.1 µm $SiO_2$ beschichteter 3-Zoll-Siliziumwafer erst mit dem Haftvermittler γ-Aminopropyltriethoxysilan und dann 12 sec lang bei 300 U/min mit der Kleberlösung 2 aus Herstellungsbeispiel 5 beschichtet. Unmittelbar danach wird die Polyimidfolie B-2 aus Herstellungsbeispiel 2 aufgebracht und die Beschichtung wird sodann nach folgendem Programm erwärmt:

| | |
|---|---|
| 40°C | 5 min |
| 60°C | 5 min |
| 80°C | 3 min |
| Aufheizen 80—150°C | 10 min |
| 150°C | 5 min |

Dann wird analog zu Applikationsbeispiel 3 5 min lang durch eine USAF 1951 Testmaske belichtet. Man entwickelt 10 min lang mit einer Mischung von Cyclopentanon und Toluol (1.00:0.65, Gewicht) und erhält hochaufgelöste Strukturen (element 5.6, 8.8 µm aufgelöst, die sich auch nach einer Behandlung bei 350°C (15 min, $N_2$) in keiner Weise verändern, und die sehr gut auf dem Substrat haften.

Applikationsbeispiel 5

Der Versuch aus Applikationsbeispiel 4 wird in allen Einzelheiten wiederholt, wobei jedoch der Polyimid Film C aus Herstellungsbeispiel 3 aufgeklebt wird. Man belichtet 8 min lang und entwickelt dann für 14 min mit einer Mischung aus 4 Butyrolacton und Xylol (1:1, Vol.). Obwohl Spannungsrisse in den Schichten zu beobachten sind, entstehen extrem hochaufgelöste guthaftende Polyimid-Bilder, sodass die

freistehenden Strukturen des USAF 1951 Testmusters bis ins letzte Detail erhalten sind und auch das Element 6.2 (7.0 µm) noch gut auf gelöst ist. Die gesamte Schichtstärke beträgt 12.4 µm.

Applikationsbeispiel 6

Auf ein weisses Keramikblättchen mit poröser Oberfläche bringt man manuell die selbstklebende Polyimidfolie aus Herstellungsbeispiel 12 auf. Man drückt den Film gut an, bedeckt ihn mit USAF 1951 Testmasken der Firma Itek Optical Systems Division und belichtet 5 min lang mit einer Masken Justier- und Belichtungsmaschine der Firma Carl Süss bei einer Lichtleistung von 22 mW/cm$^2$, bezogen auf die Messonde von 400 nm der Firma Optical Associates Inc.

Danach erhitzt man die beschichtete Keramik auf vorgeheizten Heizplatten nach folgendem Programm, wobei die aufgebrachte Polyimidfolie durch eine aufgelegte flache Abdeckung leicht in das Substrat gepresst wird

1. 15 min 65°C
2. 5 min 90°C
3. 5 min 100°C

Man lässt abkühlen und entwickelt dann in einem Sprühentwickler 14 min lang mit einem Gemisch aus Cyclopentanon und Toluol (1,00 zu 0,65, Gewicht) und Nachwaschen mit Toluol.

Man erhält Reliefbilder die sehr gut auf dem Substrat haften und steile Kanten zeigen, wobei bei den freistehenden Strukturen das Element 2,6 mit einer Strukturbreite von 70 µm und bei den isolierten Gräben das Element 1,2 mit einer Strukturbreite von 223 µm noch gut aufgelöst sind. Die gesamte Schichtstärke beträgt 25 µm.

Applikationsbeispiel 7

Analog zu Applikationsbeispiel 3 wird die Polyimidfolie B-2 mit der Kleberlösung 6 auf einen 3-Zoll Siliziumwafer aufgeklebt. Nach 5 minütigem Belichten und 10 minütigem Entwickeln mit Cyclopentanon/Toluol (1.00:0.65, Gewicht) erhält man ebenfalls hochaufgelöste Strukturen.

Applikationsbeispiel 8

Auf einen mit 0.1 µm $SiO_2$ beschichteten 3-Zoll-Wafer schleudert man zuerst bei 4'000 U/min 10 sec lang eine Lösung des Haftvermittlers γ-Aminopropyltriethoxysilan auf, sodann 5 sec lang bei 2000 U/min die Kleberlösung aus Herstellungsbeispiel 9. Sodann wird der Polyimidfilm B-2 aus Herstellungsbeispiel 2 aufgebracht. Man trocknet erste 23 min bei 50°C und belichtet dann 10 min lang bei einer Lichtleistung von 26.0 mW/cm$^2$ durch eine Maske, die freistehende Felder der Grösse 2.9 × 7.5 mm entstehen lässt. Nach dem Ausentwickeln dieser Felder (7 min mit Cyclopentanon/Toluol, 1.00:0.60, Gewicht), werden die Strukturen in einen Ofen gebracht und unter Stickstoff auf 350°C aufgeheizt und dort 15 min lang belassen. Nach dem Abkühlen wird die Haftung dieser Strukturen auf dem Substrat dadurch überprüft, dass man ein Klebeband fest auf die Felder aufdrückt und dann das Band abzieht. Bis auf einige wenige durch eingeschlossene Luftblasen erzeugte Defekte sind nach dieser Behandlung ganzflächig keinerlei Ablösungen zu beobachten.

Applikationsbeispiel 9

Auf ein poliertes, gereinigtes und entfettetes Kupferblättchen schleudert man 8 sec lang bei 1500 U/min die Kleberlösung 7 aus Herstellungsbeispiel 10. Man trocknet 45 sec lang bei 45°C und 30 sec bei 100°C, lässt abkühlen, bringt die Polyimid-Folie B-2 aus Herstellungsbeispiel 2 auf, und erwärmt nochmals 30 sec bei 50°C. Durch die Maske, die Felder 2.9 × 7.3 mm entstehen lässt, wird dann 10 min lang mit 26.0 mW/cm belichtet. Sodann entwickelt man die Strukturen 18 min lang durch Aufsprühen einer Mischung Cyclopentanon/1,1,1-Trichlorethan (1.0:0.80, Gewicht) und unterwirft die entstandenen Strukturen 10 min einer ganzflächigen Nachbelichtung mittels einer Metallhalogenid-Kopierlampe im Abstand von 25 cm.

Bei dem darauffolgenden Klebebandtest werden keinerlei Ablösungen beobachtet, und auch nach stufenweisem, zyklischen Aufheizen und Abkühlen auf 200, 250, 300, 350°C (jeweils unter $N_2$, 15 minütiges Halten bei Endtemperatur) werden bei jeweils durchgeführtem Haftungstest keinerlei Ablösungen beobachtet.

Applikationsbeispiel 10 (Haftungstest)

Der Versuch des Applikationsbeispieles 4 wird wiederholt mit der oben beschriebenen Maske für den Haftungstest. Nach dem Aufheizen der Felder auf 350°C ($N_2$, 15 min) und Abkühlen kann keines der Felder mittels Klebeband abgezogen werden. Auch bei der Anwendung des Klebebandtestes auf die freistehenden Feinstrukturen des USAF 1951 Testmusters aus Applikationsbeispiel 4 können keinerlei Ablösungen beobachtet werden.

Applikationsbeispiel 11 (Haftungstest)

Eine 10 µm starke selbstklebende Polyimid-Folie aus Herstellungsbeispiel 11 wird, ohne Verwendung eines Haftvermittlers auf eine mit 0.1 µm $SiO_2$ beschichteten 3-Zoll-Siliziumwafer aufgeklebt. Sodann belichtet man 5 min lang bei 26 mW/cm$^2$ durch die für den Haftungstest verwendete Maske. Man erhitzt kurzzeitig auf 115°C, wobei der Film leicht an das Substrat angepresst wird. Nach 6 Minuten langem Aufsprühen einer Mischung von Cyclopentanon und Toluol (1.00:0.65, Gewicht) werden die erhaltenen Strukturen auf 350°C erhitzt, abgekühlt und dem Klebebandtest unterworfen. Es werden keinerlei Ablösungen beobachtet.

## Patentansprüche

1. Beschichtetes Material enthaltend in aufeinanderfolgender Reihenfolge

a) ein Substrat, das gegebenenfalls ein Reliefbild auf der Oberfläche trägt und/oder gegebenenfalls durchbrochen ist,

b) einen photostrukturierbaren negativ arbeitenden thermostabilen Kleber und

c) einen selbsttragenden photovernetzbaren Polyimidfilm, der eine Dicke von 3—300 µm besitzt und im wesentlichen aus einem Homo- oder Copolyimid besteht, das 5 bis 100 Mol%, bezogen auf das Gesamtmolekül, mindestens eines Strukturelementes der Formel (Ia) und 95—0 Mol% mindestens eines Strukturelementes der Formel (Ib) aufweist, wobei die einzelnen Strukturelemente (Ia) und (Ib) innerhalb eines gegebenen Polymermoleküls unterschiedlich sein können

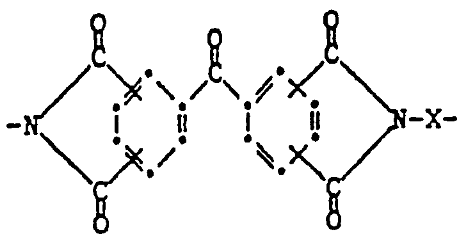 (Ia), 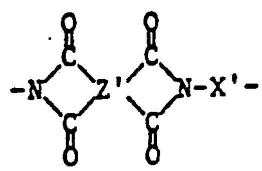 (Ib),

wobei die Carbonylgruppen in der Formel (Ia) jeweils paarweise in Orthostellung zueinander stehen,

X den zweiwertigen Rest eines aromatischen Diamines darstellt,

Z' ein vierwertiger Benzophenonrest oder ein anderer unsubstituierter oder substituierter vierwertiger aromatischer Rest ist, an den je zwei Carbonylgruppen in Ortho- oder Peristellung gebunden sind, und

X' die gleiche Bedeutung wie X besitzt, oder der zweiwertige, von X verschiedene Rest eines organischen Diamines ist, dadurch gekennzeichnet, dass der aromatische Rest von X in beiden Orthostellungen zu mindestens einem N-Atom oder in mindestens einer Orthostellung zu beiden N-Atomen durch Aklyl, Alkoxy, Alkoxyalkyl oder Aralkyl substituiert ist, oder dass zwei benachbarte C-Atome des aromatischen Restes X durch Alkylen substituiert sind, wobei, wenn Z' ein vierwertiger Benzophenonrest ist, X und X' verschieden sind.

2. Beschichtetes Material gemäss Anspruch 1, worin mindestens 50 Mol% des Polymeren, bezogen auf das Gesamtmolekül, aus Strukturelementen der Formel (Ia) bestehen, der Rest Z' des Strukturelementes der Formel (Ib) ausgewählt wird aus der Gruppe bestehend aus

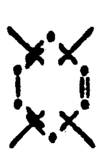 , 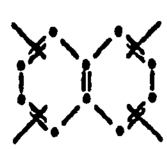 , 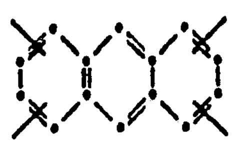

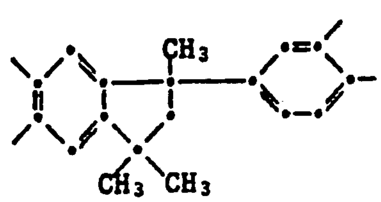 , 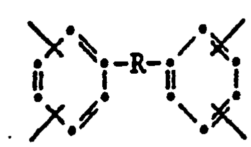

wobei die Reste Z' innerhalb eines gegebenen Moleküls unterschiedliche Bedeutung annehmen können, worin R eine direkte Bindung oder eine Brückengruppe der Formeln

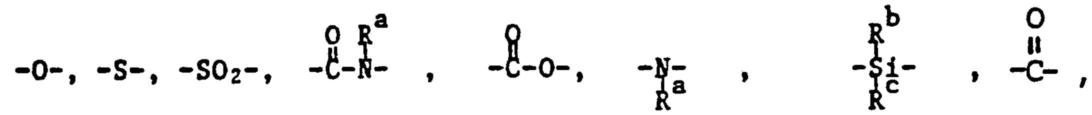

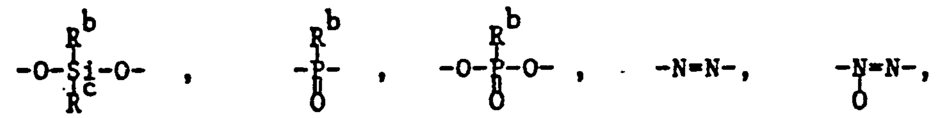

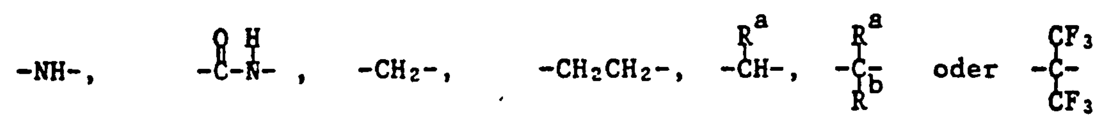

oder

ist, worin $R^a$, $R^b$ und $R^c$ Alkyl mit 1 bis 6 C-Atomen, Phenyl oder Benzyl und $R^b$ und $R^c$ auch Alkoxy mit 1 bis 6 C-Atomen, Phenyloxy oder Benzyloxy sind, worin der Rest X des Strukturelementes (Ia) ausgewählt wird aus der Gruppe folgender Strukturen, die innerhalb eines gegebenen Moleküls auch unterschiedlich sein können

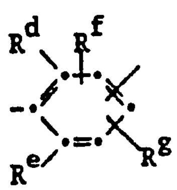 (Ic) 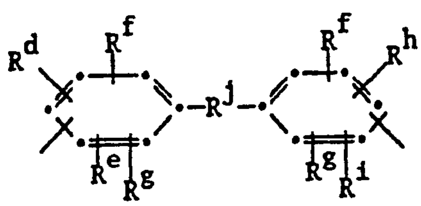 (Id)

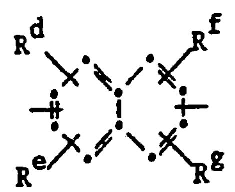 (Ie)

worin in Formel (Ic) die freien Bindungen in Meta- oder Parastellung zueinander stehen, in Formel (Id) die freien Bindungen bevorzugt in Meta- oder Parastellung zur $R^j$-Gruppe stehen und $R^d$ und $R^e$ in den beiden Orthostellungen der freien Bindung gebunden sind, und in Formel Ie die freien Bindungen in 2-, 3-, 6- und 7-Stellung gebunden sind und $R^d$ und $R^e$ sich in den beiden Orthostellungen der freien Bindungen befinden, $R^j$ für eine direkte Bindung, —O—, —S—, —SS—, —SO—, —$SO_2$—, —CO—, —COO—, —NH—, —N-Alkyl mit 1 bis 6 C-Atomen im Alkyl,

—N-Phenyl, —N-Benzyl,

—CONH—, —CON-Alkyl- mit 1 bis 6 C-Atomen im Alkyl, —CON-Phenyl-, —CON-Benzyl,

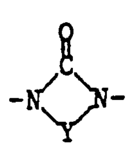 , worin Y für 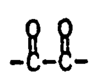 , 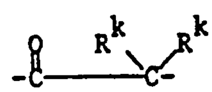 oder 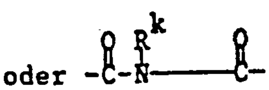 steht,

$R^k$ ein Wasserstoffatom, $C_1$—$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe

$R^1SiR^m$,

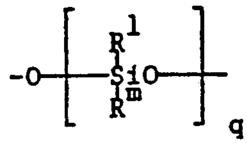 oder 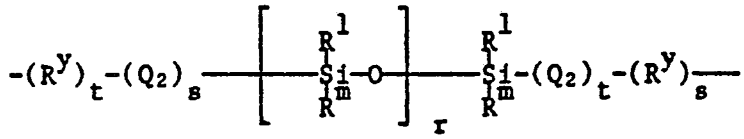

steht, worin $R^l$ und $R^m$ Alkyl oder Alkoxy mit 1 bis 6 C-Atomen, Phenyl, Benzyl, Phenyloxy oder Benzyloxy sind, r eine Zahl von 1 bis 10, t 0 oder 1 und s = 0 oder 1 ist, und $R^y$ —O— oder —S— und $Q_2$ $C_1$—$C_6$-Alkylen bedeuten, und q für eine Zahl von 1 bis 100 steht, $R^d$ und $R^e$ Alkyl oder Alkoxy, mit 1 bis 12 C-Atomen, Alkoxyalkyl mit 2 bis 12 C-Atomen, Cyclopentyl, Cyclohexyl oder Benzyl sind oder in den Formeln Ic oder Id, $R^d$ und $R^f$ in Nachbarstellung sind und zusammen Trimethylen oder Tetramethylen bedeuten, wobei $R^e$ auch ein Wasserstoffatom sein kann, $R^f$ und $R^g$ ein Wasserstoffatom sind oder unabhängig die Bedeutung von $R^d$ und $R^e$ haben, und $R^h$ und $R^i$ ein Wasserstoffatom sind, unabhängig die Bedeutung von $R^d$ und $R^e$ haben oder $R^f$ und $R^h$ in Formel Id zusammen Trimethylen oder Tetramethylen sind, und worin der Rest X' des Strukturelements (Ib) die Bedeutung von X besitzt oder ausgewählt wird aus der Gruppe der Strukturen, $C_2$—$C_{30}$Alkylen, $C_5$—$C_8$Cycloalkylen, $C_7$—$C_{30}$Aralkylen, $C_6$—$C_{22}$Arylen oder Polysiloxan.

3. Beschichtetes Material gemäss Anspruch 2, worin Z' ein Rest der Formel

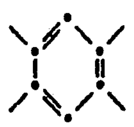 oder 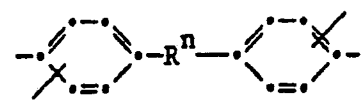

ist, der innerhalb eines gegebenen Moleküls auch unterschiedlich sein kann, worin $R^n$ eine direkte Bindung, —O—, —$SO_2$—, —$CH_2$—, —$C(CF_3)_2$ und insbesondere —CO— ist, worin der Rest X ausgewählt wird aus der Gruppe bestehend aus

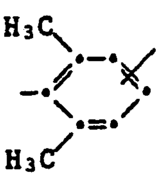 , 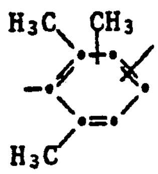 , 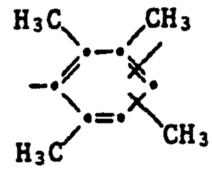

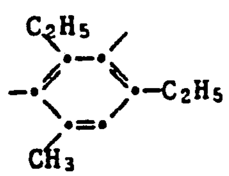 ,

worin die freien Bindungen in Meta- oder Parastellung zueinander stehen, oder der Formel

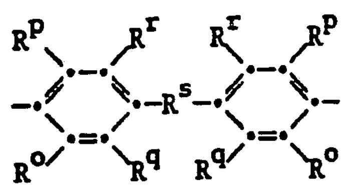 ,

wobei diese Reste innerhalb eines gegebenen Moleküls unterschiedliche Bedeutungen annehmen können, worin $R^o$ und $R^p$ unabhängig Methyl, Ethyl, n-Propyl oder Isopropyl und $R^q$ und $R^r$ ein Wasserstoffatom sind oder die Bedeutung von $R^o$ haben oder $R^o$ und $R^q$ zusammen Tri- oder Tetramethylen bedeuten und $R^p$ und $R^r$ ein Wasserstoffatom sind, und $R^s$ eine direkte Bindung, —$CH_2$—, —$C(CF_3)_2$—, 2,2-Propyliden oder —CO— ist, und worin der Rest X' die Bedeutung von X besitzt oder ausgewählt wird aus der Gruppe bestehend aus

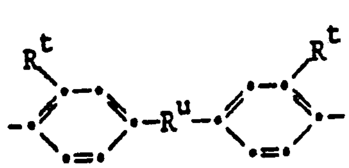 , 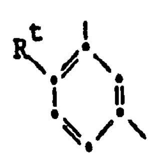 und 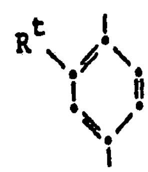 ,

wobei diese Reste innerhalb eines gegebenen Moleküls unterschiedliche Bedeutungen annehmen können, worin $R^u$ für eine direkte Bindung, —O—, —CO—, —$C(CF_3)_2$— oder —$CH_2$-steht und $R^t$ Methyl, Ethyl, Isopropyl, Methoxy, Ethoxy oder ein Wasserstoffatom bedeutet.

4. Beschichtetes Material gemäss Anspruch 1, worin der photovernetzbare selbsttragende Polyimidfilm c) eine Dicke von 3—300 µm besitzt und im wesentlichen aus einem Homo- oder Copolyimid mit einem mittleren Molekulargewicht von mindestens 2000 besteht, das mindestens 5 Mol-%, bezogen auf das Polymer, mindestens eines Strukturelementes der Formeln (IX) oder (X) enthält,

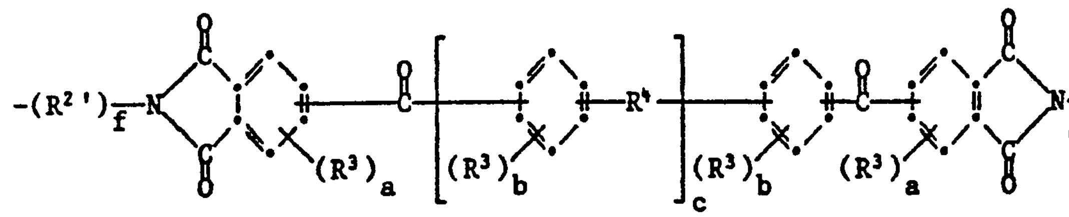
(IX)

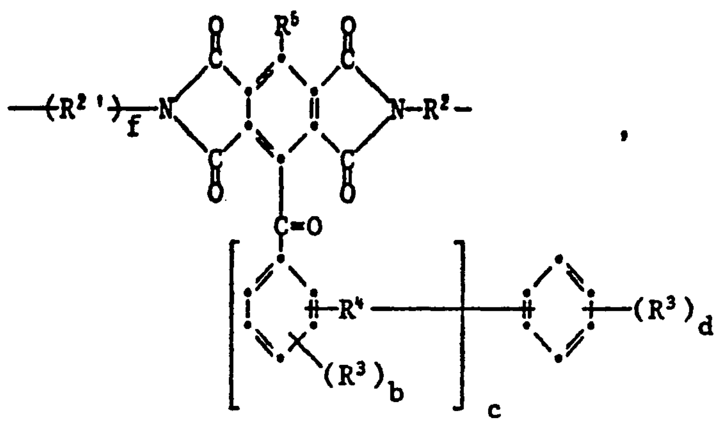
, (X)

worin

$R^3$ für Halogen, Nitro, $C_1$—$C_6$-Alkyl, $C_1$—$C_6$-Alkoxy, $C_1$—$C_6$-Alkylthio, das durch Phenyl substituiert sein kann, Phenyl, Phenoxy oder Phenylthio steht,

$R^4$ eine direkte Bindung oder eine Brückengruppe bedeutet,

$R^5$ für ein Wasserstoffatom oder Aroyl steht oder die gleiche Bedeutung wie $R^3$ hat,

a für 0, 1, 2 oder 3, b für 0, 1, 2, 3 oder 4, c und d für 0, 1, 2, 3, 4 oder 5 stehen, f für 0 oder 1 steht, wobei, wenn a, b und d 2 sind, beide $R^3$ zusammen auch in o-Stellung gebundenes —CH=CH—CH=CH— bedeuten können, und

$R^2$ und $R^{2'}$ ein unsubstituierter oder substituierter cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkylthiogruppe, Alkylthioalkylgruppe, Aralkylgruppe oder an zwei benachbarten C-Atomen des aromatischen Restes durch eine Alkylengruppe substituierter aromatischer Rest sind, wobei $R^2$ ein aromatischer Rest ist, der in beiden Orthostellungen mindestens eines N-Atoms substituiert ist, wenn f = 0 ist.

5. Beschichtetes Material gemäss Anspruch 1, worin der photovernetzbare selbsttragende Polyimidfilm c) um eine Dicke von 3—100 µm besitzt und im wesentlichen aus Homo- oder Copolyimiden besteht, die Strukturelemente von aromatischen Aminodicarbonsäuren enthalten, mit einer inhärenten Viskosität von mindestens 0,1 dl/g, gemessen bei 25°C in einer lösung von 0,5 Gew.% Polyimid in N-Methylpyrrolidon,

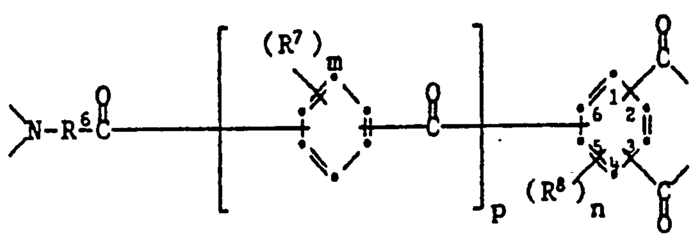
(XI)

worin $R^7$ und $R^8$ für Halogen, Nitro, Aryl, Aryloxy, Alkyl oder Alkoxy stehen, m = 0 oder eine Zahl von 1—4, n = 0 oder eine Zahl von 1 bis 3 und p = 0, 1 oder 2 bedeuten, die freien Carbonylgruppen in Orthostellung

zueinander gebunden sind und $R^6$ einen zweiwertigen aromatischen Rest bedeutet, der durch mindestens eine Alkylgruppe oder Aralkylgruppe substituiert ist.

6. Beschichtetes Material gemäss Anspruch 1, worin als photostrukturierbarer negativ arbeitender thermostabiler Kleber b) eine Verbindung oder eine Mischung von Verbindungen eingesetzt wird ausgewählt aus der Gruppe bestehend aus

b1) in organischen Lösungsmitteln löslichen photovernetzbaren Polyimiden, die gegebenenfalls in Kombination mit organischen chromphoren Polyaziden vorliegen können; und/oder

b2) photovernetzbaren Polyamidsäuren oder deren Estern; und/oder

b3) photovernetzbaren Organopolysilsesquioxanen; und/oder

b4) photovernetzbaren Polyamidimiden; und/oder

b5) photovernetzbaren Epoxidsystemen; und/oder

b6) photovernetzbaren Systemen enthaltend Verbindungen mit radikalisch polymerisierbaren ethylenisch ungesättigten Gruppen.

7. Beschichtetes Material gemäss Anspruch 6, worin als photostrukturierbarer negativ arbeitender thermostabiler Kleber b1) eine Lösung von Polyimiden oder eine Mischung von Polyimiden gemäss Ansprüchen 2 bis 6 eingesetzt wird.

8. Beschichtetes Material gemäss Anspruch 1, worin als photostrukturierbarer negativ arbeitender thermostabiler Kleber b1) Polyimide eingesetzt werden, die im wesentlichen aus einem Homo- oder Copolymer bestehen, das sich von mindestens einer aromatischen Tetracarbonsäure und mindestens einem Diamin ableitet und im wesentlichen 0,1 bis 100 Mol-% mindestens eines Strukturelementes der Formel (II)

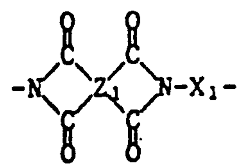 (II)

und 99,9 bis 0 Mol-% mindestens eines Strukturelementes der Formeln (III) und/oder (IV) enthält

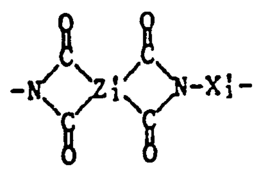 (III)

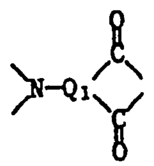 (IV),

worin

$Z_1$ für mindestens einen vierwertigen Rest der Formeln (V), (VI), (VII) oder (VIII)

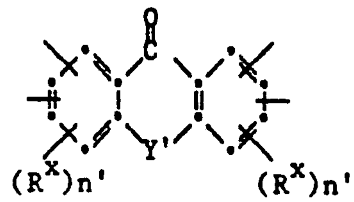 (V) 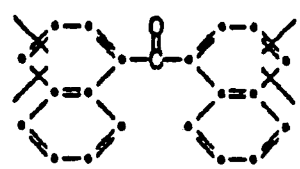 (VI)

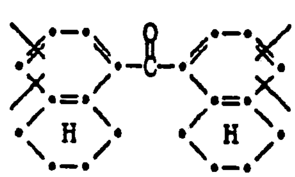 (VII) 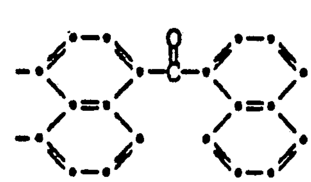 (VIII)

steht, in denen die freien Bindungen in Orthostellung zueinander gebunden sind und Y' eine direkte Bindung, $-CH_2-$, $-(CH_2)_2-$, $-O-$, $-S-$, $-SO-$, $-SO_2-$, $-CO-$, $-NR^v-$ oder $-CR^vR^w-$ bedeutet,

wobei $R^v$ ein Wasserstoffatom, $C_1$—$C_{10}$-Alkyl, Phenyl, Naphthyl oder Phenyl($C_eH_{2e}$)- mit e = 1 bis 4 ist und $R^w$ die Bedeutung von $R^v$ mit Ausnahme der Bedeutung eines Wasserstoffatomes hat, $R^x$ für $C_1$—$C_{10}$-Alkyl, Halogen, —CN, —$NO_2$, $C_1$—$C_{12}$-Alkoxy, Phenoxy, Naphthoxy oder Phenyl-($C_eH_{2e}$)— mit e = 1—4 steht, n' = 0, 1 oder 2 ist,

$X_1$ ein unsubstituierter oder substituierter heterocyclischer, cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkythiogruppe, Alkylthioalkylgruppe, Hydroxyalkylgruppe, Hydroxyalkoxygruppe, Hydroxyalkylthiogruppe, Aralkylgruppe, oder an zwei benachbarten C-Atomen des aromatischen Restes durch eine Alkylengruppe substituierter aromatischer Rest ist, $Q_1$ ein dreiwertiger aromatischer Rest ist,

$Z_1'$ die gleiche Bedeutung wie $Z_1$ hat, oder ein von $Z_1$ verschiedener vierwertiger organischer Rest ist, und

$X_1'$ der zweiwertige, von $X_1$ verschiedene Rest eines organischen Diamines ist,

wobei $Z_1$ in Formel (II) auch vierwertige Benzophenonreste darstellen kann, wenn Strukturelemente der Formel (IV) enthalten sind.

9. Beschichtetes Material gemäss Anspruch 1, worin der photovernetzbare thermostabile Kleber b1) eine Mischung ist, die neben gegebenenfalls anwesenden üblichen Zusätzen enthält

a) ein in organischen Lösungsmitteln lösliches Homo- oder Copolyimid aus aromatischen Tetracarbonsäuren und aromatischen Diaminen oder aromatischen und aliphatischen Diaminen, wobei an mindestens einen Teil der Tetracarbonsäurereste, der aromatischen Diaminreste oder beider Reste mindestens eine aliphatische Gruppe direkt oder über eine Brückengruppe gebunden ist und/oder mindestens ein Teil dieser Reste als aliphatische Brückengruppe Alkylen, Alkyliden, Cycloalkyliden oder $Si(Alkyl)_2$ enthält, und

b) mindestens 0,1 Gew.%, bezogen auf die Polyimidkomponente, mindestens eines organischen chromophoren Polyazids, in dem die Azidgruppen direkt oder über eine $SO_2$-Gruppe an aromatische Kohlenwasserstoffreste gebunden sind.

10. Beschichtetes Material gemäss Anspruch 9, worin das Homo- oder Copolyimid im wesentliches aus 50 bis 100 Mol.% wiederkehrenden Strukturelementen der Formeln (XVII) und/oder (XVIII)

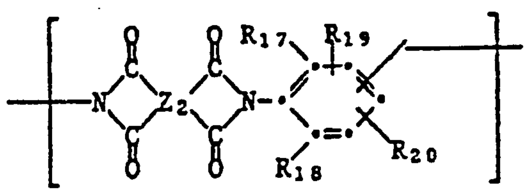

(XVII),

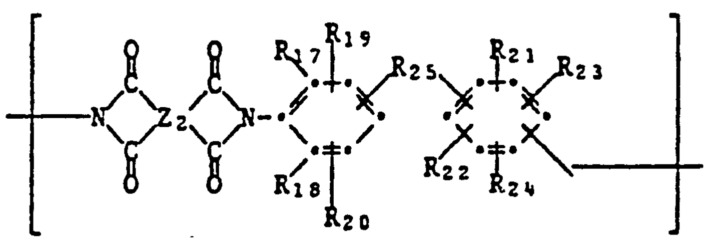

(XVIII)

und 50 bis 0 Mol.% wiederkehrenden Strukturelementen der Formel (XIX)

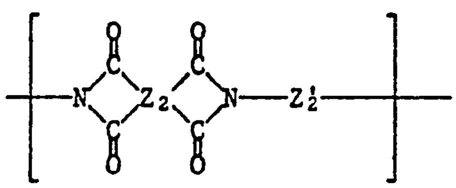

(XIX)

besteht, wobei in den Formeln (XVII), (XVIII) und (XIX) die vier Carbonylgruppen an verschiedene Kohlenstoffatome gebunden sind und je zwei Carbonylgruppen in ortho- oder peri-Stellung zueinander stehen,

$Z_2$ einen vierwertigen Rest bedeutet, der mindestens einen aromatischen Ring enthält,

$Z_2'$ einen von den Gruppen

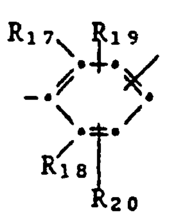

oder

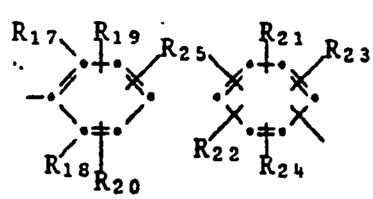

verschiedenen zweiwertigen organischen Rest darstellt, ausgewählt unter aromatischen, alkylaromatischen, aliphatischen, cycloaliphatischen und heterocyclischen Resten, Kombinationen davon und Resten mit Sauerstoff, Schwefel, Stickstoff, Silicium oder Phosphor enthaltenden Brückengruppen,

$R_{17}$ und $R_{18}$ unabhängig voneinander Alkyl mit 1—4 C-Atomen,

$R_{19}$, $R_{20}$, $R_{21}$, $R_{22}$, $R_{23}$ und $R_{24}$ unabhängig voneinander Wasserstoff oder Alkyl mit 1—4 C-Atomen und

$R_{25}$ die direkte Bindung, —O—, —S—, —$SO_2$—, —CO—, —$CH_2$—, —$C(CF_3)_2$—, Cycloalkyliden mit 5—6 Ringkohlenstoffatomen, Phenylen,

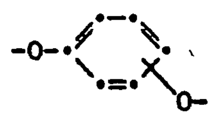 oder ein Gruppe

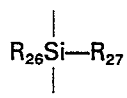

bedeuten, worin $R_{26}$ und $R_{27}$ Alkyl oder Alkoxy mit je 1—6 C-Atomen, Phenyl, Benzyl, Phenyloxy oder Benzyloxy darstellen.

11. Beschichtetes Material gemäss Anspruch 6, worin die Dicke der Klebschicht im ausgehärteten Zustand weniger als 5 µm beträgt und als photostrukturierbarer negativ arbeitender thermostabiler Kleber ein Organopolysilsesquioxan der Formel (XXXI) eingesetzt wird

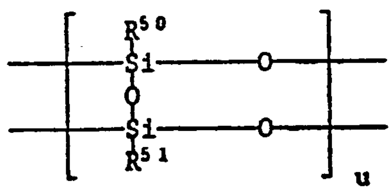 (XXXI),

worin $R^{50}$ und $R^{51}$ unabhängig voneinander einwertige Kohlenwasserstoffreste darstellen und u eine ganze Zahl grösser als 30 ist.

12. Beschichtetes Material gemäss Anspruch 6, worin als photostrukturierbarer negativ arbeitender thermostabiler Kleber b4) lineare gesättigte Homo- oder Copolykondensate aus der Gruppe der Polyamidimide mit Benzophenontricarbonsäureresten mit mindestens einem wiederkehrenden Strukturelement der Formel (XII)

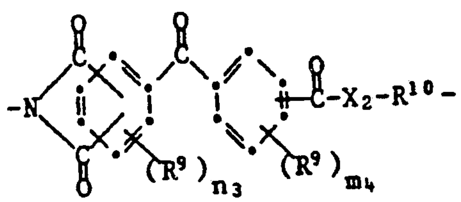 (XII)

und im Fall von Copolykondensaten zusätzlich wiederkehrenden Strukturelementen der Formeln (XIII) und/oder (XIV)

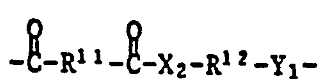 (XIII) 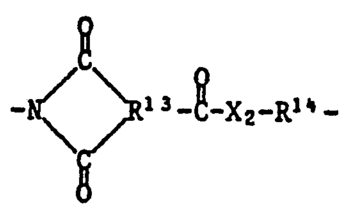 (XIV),

eingesetzt werden, worin die Imidgruppe im Strukturelement (XII) an zwei benachbarte C-Atome gebunden ist, $m_4$ für 0 oder eine Zahl von 1 bis 4 und $n_3$ für 0 oder eine Zahl von 1 bis 3 steht, $X_2$ für —S—, —O— oder —$NR^{15}$-steht und $Y_1$ unabhängig die gleiche Bedeutung wie $X_2$ hat,

$R^9$ Alkyl oder Alkoxy mit weniger als 6 C-Atomen, Aryl mit 6 bis 10 C-Atomen, Aralkyl mit 7 bis 10 C-Atomen oder Halogen bedeutet,

$R^{12}$ einen unsubstituierten oder substituierten zweiwertigen aliphatischen, cycloaliphatischen, aralyphatischen oder aromatischen Rest bedeutet, und falls $X_2$ und $Y_1$ die Gruppe —$NR^{15}$— sind, $R^{12}$ und eines der $R^{15}$ zusammen Alkylen mit 5 bis 7 C-Atomen, an das die zweite —$NR^{15}$-Gruppe gebunden ist, oder $R^{12}$ Methylen, Ethylen oder Propylen und die beiden

$R^{15}$ der $NR^{15}$-Gruppen zusammen Ethylen oder Propylen oder $X_2$ oder $Y_1$ —S— oder —O— und das andere —$NR^{15}$— sind, $R^{12}$ und $R^{15}$ zusammen Alkylen mit 5—7 C-Atomen bedeuten, an das die Gruppe —O— oder —S-gebunden ist,

$R^{10}$ einen unsubstituierten oder substituierten zweiwertigen aliphatischen oder aromatischen Kohlenwasserstoffrest bedeutet,

$R^{14}$ unabhängig die gleiche Bedeutung wie $R^{10}$ hat,

$R^{11}$ ein zweiwertiger gesättigter aliphatischer oder aromatischer Rest ist,

$R^{13}$ für einen dreiwertigen gesättigten aliphatischen oder aromatischen Rest steht, in dem die Imidgruppe an zwei benachbarte C-Atome gebunden ist, und

$R^{15}$ ein Wasserstoffatom, Alkyl Cycloalkyl, Aryl, Aralkyl oder Alkaralkyl bedeutet,

wobei die Copolykondensatom die Strukturelemente der Formel (XII) zu mindestens 10 Mol.% enthalten, bezogen auf das Copolykondensat.

13. Beschichtetes Material gemäss Anspruch 6, worin als photostrukturierbarer negativ arbeitender thermostabiler Kleber b5) photovernetzbare Epoxidharze oder Mischungen solcher Harze eingesetzt werden enthaltend,

(a) eine mindestens eine 1,2-Epoxidgruppe enthaltende aromatische, cycloaliphatische oder araliphatische Verbindung,

(b) mindestens einen für die Photovernetzung von Epoxidharzen geeigneten Photoinitiator, gegebenenfalls in Kombination mit einem Photobeschleuniger und gegebenenfalls

(c) mindestens eine als latenten Heisshärter verwendbare aromatische, cycloaliphatische oder araliphatische Verbindung.

14. Beschichtetes Material gemäss Anspruch 13, worin als Photoinitiator (b) ein Haloniumsalz der Formel (XXXIII) eingesetzt wird

$$\left[ R^{41}R^{42}X^{a} \right]^{+}_{q_4} \quad \left[ L_2Q^{a}_{m_4} \right]^{-q_4} \qquad \text{(XXXIII)}$$

worin $R^{41}$ und $R^{42}$ unabhängig voneinander ein carbocyclischer oder heterocyclischer aromatischer Rest mit 6 bis 20 C-Atomen oder $R^{41}$ und $R^{42}$ zusammen ein zweiwertiger carbocyclischer oder heterocyclischer aromatischer Rest sind, $X^a$ für ein Halogenatom steht, $m_4$ eine Zahl ist, die der Summe der Wertigkeit von $L_2$ und $q_4$ entspricht, $L_2$ ein zweiwertiges bis siebenwertiges Metall oder Nichtmetall und $Q^a$ ein Halogenatom darstellen, und $q_4$ eine Zahl von 1 bis 3 bedeutet.

15. Beschichtetes Material gemäss Anspruch 13, worin als Photoinitiator (b) ein Iodosylsalz der Formel (XXXIV) eingesetzt wird

$$\left[ R^{43}R^{44}I{=}O \right]^{+}_{q_5} \quad \left[ L_3Q^{b}_{m_5} \right]^{-q_5} \qquad \text{(XXXIV)},$$

worin $R^{43}$ und $R^{44}$ ein carbocyclischer oder heterocyclischer aromatischer Rest mit 6 bis 20 C-Atomen sind, $m_5$ eine Zahl ist, die der Summe der Wertigkeit von $L_3$ und $q_5$ entspricht, $L_3$ ein zweiwertiges bis siebenwertiges Metall oder Nichtmetall und $Q^b$ ein Halogenatom darstellen, und $q_5$ eine Zahl von 1 bis 3 bedeutet.

16. Beschichtetes Material gemäss Anspruch 13, worin als Photoinitiator ein Sulfoniumsalz der Formel (XXXV) eingesetzt wird

$$\left[ R^{45}R^{46}R^{47}S \right]^{+}_{q_6} \quad \left[ L_4Q^{c}_{m_6} \right]^{-q_6} \qquad \text{(XXXV)},$$

worin $R^{45}$, $R^{46}$ und $R^{47}$ unabhängig voneinander einen carbocyclischen oder heterocyclischen aromatischen Rest mit 6 bis 20 C-Atomen oder eines von $R^{45}$, $R^{46}$ und $R^{47}$ diesen aromatischen Rest und die beiden anderen zusammen einen zweiwertigen carbocyclischen oder heterocyclischen aromatischen Rest bedeuten, $m_6$ eine Zahl ist, die der Summe der Wertigkeit von $L_4$ und $q_6$ entspricht, $L_4$ ein zweiwertiges bis siebenwertiges Metall oder Nichtmetall und $Q^c$ ein Halogenatom darstellen, und $q_6$ eine Zahl von 1 bis 3 bedeutet.

17. Beschichtetes Material gemäss Anspruch 13, worin als Photoinitiator (b) eingesetzt wird

I) eine wirksame Menge eines Salzes der Formel (XXVIII)

$$\left[ Y_3 - Q - (CO)_{a_1} \right]^{+} \quad MX_{4\,n_1}^{-} \qquad \text{(XXVIII)},$$

worin $Y_3$ eine Arengruppe oder Dienyliumgruppe bedeutet, Q ein Atom eines unter Titan, Vanadium, Chrom, Mangan, Eisen, Kobalt, Nickel, Kupfer, Niob, Molybdän, Ruthenium, Rhodium, Palladium, Silber,

Tantal, Wolfram, Rhenium, Osmium, Iridium, Platin und Gold ausgewählten Uebergangsmetalls darstellt, $a_1$ eine solche positive ganze Zahl ist, dass das Atom Q eine geschlossene Elektronenschalenkonfiguration aufweist, M ein Atom eines Metalls oder Nichtmetalls darstellt, $n_1 = 4$, 5 oder 6 und um eines grösser als die Wertigkeit von M ist und $X_4$ für ein Fluor- oder Chloratom steht, mit der Massgabe, dass, wenn M Antimon darstellt, $n_1 = 6$ ist und fünf der Symbole $X_4$ für Fluor stehen, eines auch eine Hydroxogruppe bedeuten kann; oder

II) eine wirksame Menge eines Salzes der Formel (XXIX)

$$\left[(R^{48})(R^{49}Me)_{a_2}\right]^{+a_2n_2} \quad \frac{a_2n_2}{q_2} \quad \left[LQ'_{m_2}\right]^{-q_2} \qquad (XXIX),$$

worin $a_2 = 1$ oder 2 sowie $n_2$ und $q_2$ unabhängig voneinander je eine ganze Zahl von 1 bis 3 sind, Me das Kation eines einwertigen bis dreiwertigen Metalls aus der Gruppe (IVb) bis (VIIb), (VIII) oder (Ib) des Periodensystems darstellt, $m_2$ eine der Wertigkeit von L und $q_2$ entsprechende ganze Zahl ist und Q' ein Halogenatom, L ein zweiwertiges bis siebenwertiges Metall oder Nichtmetall, $R^{48}$ ein π-Aren und $R^{49}$ ein π-Aren oder das Anion eines π-Arens bedeuten.

18. Beschichtetes Material gemäss Anspruch 17, worin als Photoinitiator (b) mindestens eine Eisenverbindung der Formel (XXX) eingesetzt wird

$$\left[(R^{32})(R^{33}Fe^{II})_{a_3}\right]^{+a_3} \quad \frac{a_3}{q_3} \quad (L_1Q''_{m_3})^{-q_3} \qquad (XXX)$$

worin

$a_3 = 1$ oder 2 und $q_3 = 1$, 2 oder 3 sind,

$L_1$ ein zweiwertiges bis siebenwertiges Metall oder Nichtmetall bedeutet,

Q'' für ein Halogenatom steht,

$m_3$ eine ganze Zahl ist, die der Summe der Wertigkeit von $L_1$ und $q_3$ entspricht,

$R^{32}$ ein π-Aren und $R^{33}$ das Anion eines π-Arens bedeuten, wobei die Verbindung der Formel (XXX) vorzugsweise zusammen mit mindestens einem Elektronenacceptor als Oxidationsmittel, und/oder mit einem Sensibilisator für die Verbindung der Formel (XXX) eingesetzt wird.

19. Beschichtetes Material gemäss Anspruch 6, worin als Kleber b5) ein photovernetzbares und anschliessend noch wärmehärtbares Epoxidharz auf der Basis von Bisphenoldiglycidylethern verwendet wird, das neben freien Epoxidgruppen noch photovernetzbare Reste

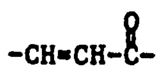 , 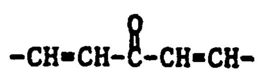 oder 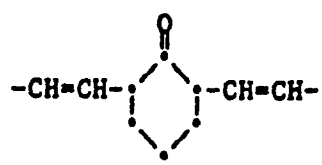

enthält, die zu mindestens 10 Mol%, bezogen auf die Bisphenoleinheiten, als Brücken zwischen den aromatischen Kernen des Bisphenols anwesend sind.

20. Beschichtetes Material gemäss Anspruch 6, worin als Kleber b6) aus der Gruppe der Verbindungen mit radikalisch polymerisierbaren ethylenisch ungesättigten Gruppen Gemische eingesetzt werden ausgewählt aus der Gruppe bestehend aus

A) Gemischen enthaltend

a) mindestens eine ethylenisch ungesättigte radikalisch polymerisierbare Verbindung mit einem bei Normaldruck über 100°C liegenden Siedepunkt,

b) mindestens einen organischen, anorganischen oder metallorganischen Photoinitiator, der bei Bestrahlung Radikale bildet, und

c) ein polymeres Bindemittel; oder

B) Gemische enthaltend

a) Verbindungen oder Mischungen von Verbindungen mit sowohl mindestens einer mittelständigen Epoxidgruppe und/oder mindestens einem Strukturelement der Formel (XXXII)

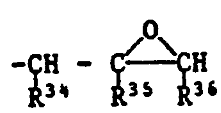 (XXXII),

das endständig direkt an ein Sauerstoffatom oder Stickstoffatom gebunden ist, worin $R^{34}$ und $R^{36}$ je ein Wasserstoffatom bedeuten, wobei $R^{35}$ dann ein Wasserstoffatom oder eine Methylgruppe ist, oder $R^{34}$ und $R^{36}$ zusammen $—CH_2—CH_2—$ darstellen, wobei $R^{35}$ dann ein Wasserstoffatom bedeutet, als auch mit

mindestens einer ethylenisch ungesättigten Doppelbindung in einem Molekül,

b) mindestens einen Photoinitiator, der bei Bestrahlung Radikale bildet, und

c) gegebenenfalls polymere Bindemittel und/oder ein hitzeaktivierbares Polymerisationsmittel für 1,2-Epoxidharze und/oder Photosensibilisatoren oder -initiatoren für die Epoxidpolymerisation; oder

C) Gemische enthaltend

a) ein Epoxidharz mit mindestens einer mittelständigen Epoxidgruppe und/oder mindestens einer Epoxidgruppe der Formel (XXXII), wie oben definiert,

b) eine radikalisch photopolymerisierbare Verbindung, und gegebenenfalls

c) einen hitzeaktivierbaren Härter für das Epoxidharz.

21. Beschichtetes Material gemäss Anspruch 1, worin ein Substrat a) mit einer streuenden Oberfläche eingesetzt wird und worin die Klebschicht b) strahlungsabsorbierende Zusätze in einer solchen Menge enthält, dass an der Substratoberfläche lateral gestreutes Licht nicht in die Klebschicht b) und in die Polyimidschicht c) vordringen kann.

22. Verfahren zur Herstellung von Reliefabbildungen mittels eines photolithographischen Prozesses, umfassend folgende Arbeitsschritte:

i) Beschichtung einer Substratoberfläche mit einem photostrukturierbaren negativ arbeitenden thermostabilen Klebmittel nach Anspruch 6 und gegebenenfalls Verdunsten des Lösungsmittels,

ii) Aufbringen eines selbsttragenden photostrukturierbaren Polyimidfilmes nach Anspruch 1 auf die klebmittelbeschichtete Oberfläche, gegebenenfalls unter Anwendung von Druck und/oder Wärme

iii) bildmässige Belichtung der Anordnung mit aktinischer Strahlung von der Seite des Polyimidfilms oder des Substrates, und

iv) Entwickeln des Systems mit einem geeigneten Entwickler, um an den unbelichteten Stellen sowohl den Polyimidfilm als auch den Klebmittelfilm zu entfernen.

23. Verfahren zur Herstellung von Reliefabbildungen mittels eines photolithographischen Prozesses, umfassend folgende Arbeitsschritte:

i) Beschichtung einer Substratoberfläche mit der Klebseite eines aus photostrukturierbarem negativ arbeitendem thermostabilem Klebmittel nach Anspruch 6 und selbsttragendem photostrukturierbarem Polyimidfilm nach Anspruch 1 bestehenden Zweischichtsystems, gegebenenfalls unter Anwendung von Druck und/oder Wärme,

ii) bildmässige Belichtung der Anordnung mit aktinischer Strahlung von der Seite des Polyimidfilms oder des Substrates und

iii) Entwickeln des Systems mit einem geeigneten Entwickler, um an den unbelichteten Stellen den Polyimidfilm und den Klebmittelfilm zu entfernen.

24. Verwendung der nach den Ansprüchen 22 oder 23 erhaltenen Reliefabbildungen als Schutz-, Isolier- und Passivierschichten, als Dielektrika, als Lötstopmasken oder als Zwischenlagen (interlayers) in Halbleiterbausteinen (diskret oder integriert), Hybridschaltungen, Leiterplatten oder Multilayers.

**Revendications**

1. Matière revêtue contenant, dans l'ordre indiqué:

a) un substrat qui porte éventuellement une image en relief à sa surface et/ou est éventuellement perforé,

b) une colle thermostable photostructurable travaillant en négatif, et

c) une pellicule en polyimide photoréticulable non soutenue qui a une épaisseur de 3 à 300 µm, et qui est essentiellement constituée d'un homopolyimide ou d'un copolyimide renfermant de 5 à 100% en moles, par rapport à la molécule totale, d'au moins une unité structurale de formule Ia et de 0 à 95% en moles d'au moins une unité structurale de formule Ib, les diverses unités structurales Ia et Ib pouvant être différentes les unes des autres à l'intérieur d'une molécule polymère donnée:

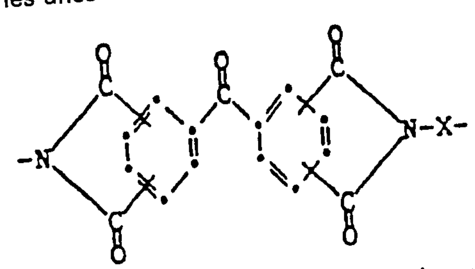 (Ia), 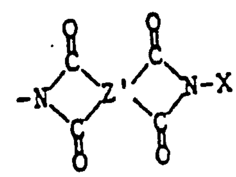 (Ib),

formules dans lesquelles les radicaux carbonyles, pour ce qui est de la formule Ia, se trouvent, pour chacun des deux couples, en des positions ortho l'un par rapport à l'autre, X représente le radical bivalent d'une diamine aromatique, Z' représente un radical quadrivalent de la benzophénone ou un autre radical aromatique quadrivalent substitué ou non sur lequel les deux radicaux carbonyles de chacun des couples sont en ortho ou en péri, et X' a la même signification que X ou représente le radical bivalent, différent de X, d'une diamine organique, matière caractérisée en ce que le radical aromatique X porte, en les deux positions ortho par rapport à au moins un atome d'azote ou en au moins une position ortho par rapport aux

deux atomes d'azote, un radical alkyle, alcoxy, alcoxyalkyle ou aralkyle, ou en ce que deux atomes de carbone voisins appartenant au radical aromatique X portent un radical alkylène, les symboles X et X', dans le cas où Z' représente un radical quadrivalent de benzophénone, ayant des significations différentes.

2. Matière revêtue selon la revendication 1 dans laquelle au moins 50% en moles du polymère, par rapport à la molécule totale, sont constitués d'unités structurales de formule Ia, Z' représente, dans l'unité structurale de formule Ib, un radical pris dans l'ensemble constitué par les radicaux suivants:

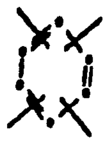 , 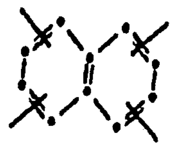 , 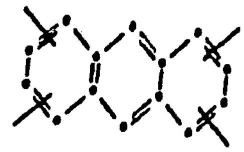

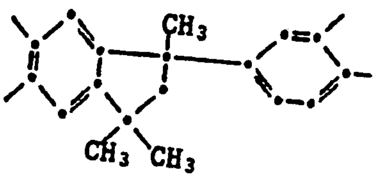 , 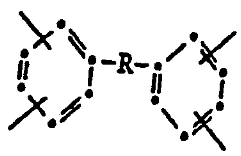 ,

(les symboles Z' pouvant prendre des significations différentes à l'intérieur d'une molécule donnée) dans lesquels R représente une liaison directe ou un radical pont répondant à l'une des formules suivantes:

—O—, —S—, —$SO_2$—, 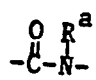 , 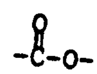 , 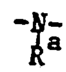 , 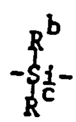 , 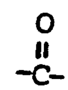 ,

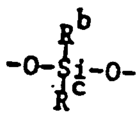 , 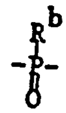 , 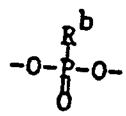 , —N=N—, 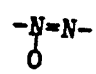 ,

—NH—, 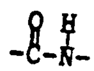 , —$CH_2$—, —$CH_2CH_2$—, 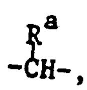 , 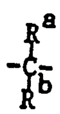 et 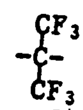

dans lesquelles $R^a$, $R^b$ et $R^c$ représentent chacun un alkyle en $C_1$—$C_6$, un phényle ou un benzyle, et $R^b$ et $R^c$ peuvent également représenter un alcoxy en $C_1$—$C_6$, un phénoxy ou un benzyloxy, X représente, dans l'unité structurale Ia, un radical pris dans l'ensemble constitué par les radicaux suivants (à l'intérieur d'une molécule donnée les symboles X peuvent avoir des significations différentes):

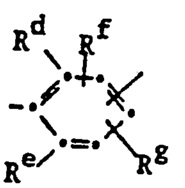 (Ic) 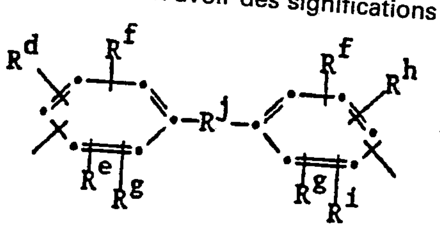 (Id) 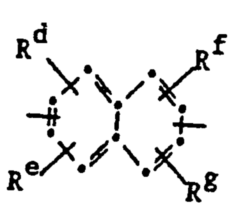 (Ie)

où, dans la formule Ic, les liaisons libres sont en position méta ou en position para l'une par rapport à l'autre, dans la formule Id les liaisons libres sont de préférence chacune en méta ou en para relativement au radical $R^j$, et $R^d$ et $R^e$ sont en les deux positions ortho par rapport à la liaison libre, et, dans la formule Ie, les liaisons libres se trouvent aux positions 2, 3, 6 et 7 et $R^d$ et $R^e$ aux deux positions ortho par rapport à la liaison libre, $R^j$ représente une liaison directe, —O—, —S—, —SS—, —SO—, —$SO_2$—, —CO—, —COO—, —NH—, —N—(alkyl)— à alkyle en $C_1$—$C_6$, —N—(phényl)—, —N—(benzyle)—, —CONH—, —CON(alkyl)— à alkyle en $C_1$—$C_6$, —CON(phényl)—, —CON(benzyle)—, un radical

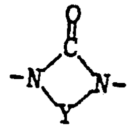 (dans lequel Y représente 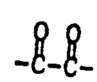 , 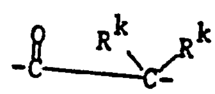 or 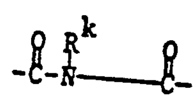 ,

et $R^k$ un atome d'hydrogène, un alkyle en $C_1$—$C_6$ ou un phényle), un alkylène linéaire ou ramifié contenant de 1 à 3 atomes de carbone, un alkylidène contenant de 2 à 12 atomes de carbone et éventuellement porteur de Cl ou F, un cycloalkylidène contenant 5 ou 6 atomes de carbone dans son cycle, un phénylène, un phénylène-dioxy ou un radical répondant à l'une des formules:

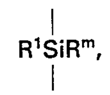

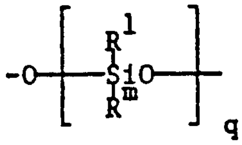 et 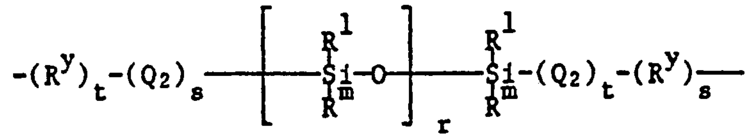 et

dans lesquelles $R^l$ et $R^m$ représentent chacun un radical alkyle ou alcoxy contenant de 1 à 6 atomes de carbone, un phényle, un benzyle, un phénoxy ou un benzyloxy, r représente un nombre de 1 à 10, t représente un nombre égal à 0 ou à 1, s représente un nombre égal à 0 ou à 1, $R^y$ représente —O— ou —S—, $Q_2$ représente un alkylène en $C_1$—$C_6$ et q désigne un nombre de 1 à 100, $R^d$ et $R^e$ représentent chacun un radical alkyle ou alcoxy contenant de 1 à 12 atomes de carbone, un alcoxyalkyle contenant de 2 à 12 atomes de carbone, un cyclopentyle, un cyclohexyle ou un benzyle, ou, dans les formules Ic et Id, $R^d$ et $R^f$ sont voisins l'un de l'autre et forment ensemble un radical triméthylène ou tétraméthylène, $R^e$ pouvant alors être aussi un atome d'hydrogène, $R^f$ et $R^g$ représentent chacun un atome d'hydrogène ou ont chacun, indépendamment l'un de l'autre, l'une des significations qui ont été données pour $R^d$ et $R^e$, et $R^h$ et $R^i$ représentent chacun un atome d'hydrogène ou ont chacun, indépendamment l'un de l'autre, l'une des significations qui ont été données pour $R^d$ et $R^e$, ou $R^f$ et $R^h$, dans la formule Id, forment ensemble un radical triméthylène ou tétraméthylène, et X' dans l'unité structurale Ib, a l'une des significations qui ont été données pour X ou est choisi dans l'ensemble constitué par les radicaux alkylènes en $C_2$—$C_{30}$, cycloalkylènes en $C_5$—$C_8$, aralkylènes en $C_7$—$C_{30}$, arylènes en $C_6$—$C_{22}$ et polysiloxaniques.

3. Matière revêtue selon la revendication 2, dans laquelle: Z' peut prendre des significations différentes au sein d'une même molécule et représente un radical répondant à l'une des formules:

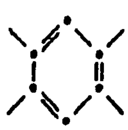 et 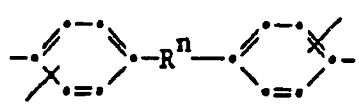

où $R^n$ représente une liaison directe, —O—, —$SO_2$—, —$CH_2$—, —$C(CF_3)_2$— ou, plus particulièrement, —CO—, X peut avoir des significations différentes à l'intérieur d'une molécule donnée et représente un radical répondant à l'une des formules suivantes:

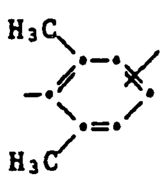, 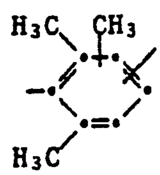, 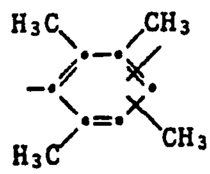 et

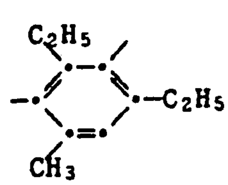,

dans lesquelles les liaisons libres sont en position méta ou para l'une par rapport à l'autre, ou à la formule:

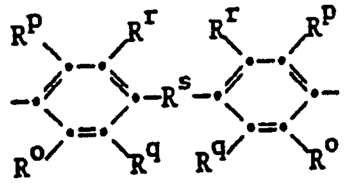,

dans laquelle $R^o$ et $R^p$ représentent chacun, indépendamment l'un de l'autre, un radical méthyle, éthyle, n-propyle ou isopropyle, $R^q$ et $R^r$ représentent chacun un atome d'hydrogène ou ont la signification de $R^o$ ou encore $R^o$ et $R^q$ forment ensemble un radical triméthylène ou tétraméthylène tandis que $R^p$ et $R^r$ représentent chacun un atome d'hydrogène, et $R^s$ représente une liaison directe, $—CH_2—$, $—C(CF_3)_2—$, un radical propylidène-2,2 ou —CO—, et X' a l'une des significations qui ont été données pour X ou représente un radical répondant à l'une des formules:

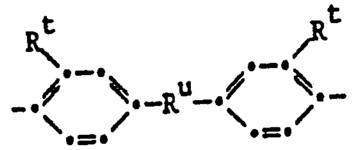 ,

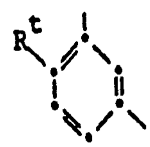 et 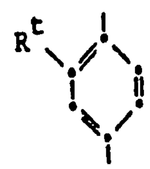 ,

dans lesquelles $R^u$ représente une liaison directe, —O—, —CO—, $—C(CF_3)_2—$ ou $—CH_2—$ et $R^t$ représente un radical méthyle, éthyle, isopropyle, méthoxy ou éthoxy ou un atome d'hydrogène, le symbole X' pouvant avoir des significations différentes à l'intérieur d'une molécule donnée.

4. Matière revêtue selon la revendication 1 dans laquelle la pellicule en polyimide photoréticulable non soutenue c) a une épaisseur de 3 à 300 µm et est essentiellement constituée d'un homopolyimide ou copolyimide qui a une masse moléculaire moyenne d'au moins 2000 et qui contient au moins 5% en moles, par rapport au polymère, d'au moins une unité structurale répondant à l'une des formules IX et X:

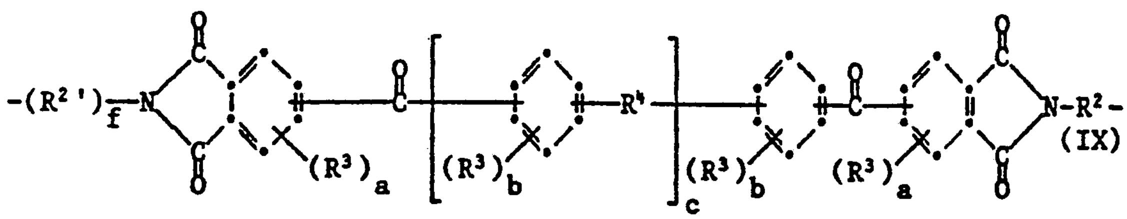

(IX)

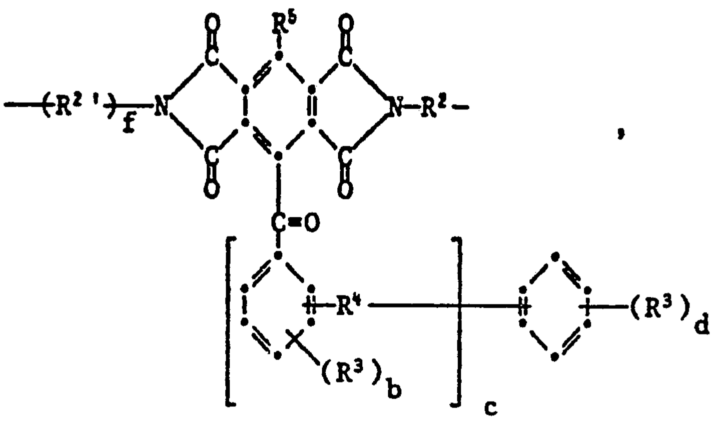 , (X)

dans lesquelles:

$R^3$ représente un halogène, un nitro, un alkyle en $C_1—C_6$, un alcoxy en $C_1—C_6$, un alkylthio en $C_1—C_6$, éventuellement porteur d'un phényle, un phényle, un phénoxy ou un phénylthio,

$R^4$ représente une liaison directe ou un radical formant pont,

$R_2$ représente un atome d'hydrogène ou un radical aroyle ou a la même signification que $R^3$

a représente un nombre égal à 0, à 1, à 2 ou à 3,

b représente un nombre égal à 0, à 1, à 2, à 3 ou à 4,

c et d représentent chacun un nombre égal à 0, à 1, à 2, à 3, à 4 ou à 5,

f représente un nombre égal à 0 ou à 1,

avec la condition que, lorsque a, b et d sont égaux à 2, les deux $R^3$ peuvent également représenter ensemble un radical —CH=CH—CH=CH— lié en ortho, et

$R^2$ et $R^{2'}$ représentent chacun un radical cycloaliphatique ou araliphatique substitué ou non, un radical aromatique dans lequel deux noyaux aryles sont reliés par un radical aliphatique, ou un radical aromatique porteur d'au moins un radical alkyle, cycloalkyle, alcoxy, alcoxyalkyle, alkylthio, alkylthio-alkyle ou aralkyle ou d'un radical alkylène lié à deux atomes de carbone voisins appartenant au radical aromatique, le symbole $R^2$, dans le cas où f est égal à 0, représentant un radical aromatique substitué en les deux positions ortho par rapport à au moins un atome d'azote.

5. Matière revêtue selon la revendication 1 dans laquelle la pellicule en polyimide photoréticulable non soutenue c) a une épaisseur de 3 à 100 µm et est essentiellement constituée d'homopolyimides ou copolyimides qui contiennent des unités structurales d'acides amino-dicarboxyliques aromatiques et qui ont une viscosité inhérente, mesurée à 25°C sur une solution à 0,5% en poids du polyimide dans de la N-méthyl-pyrrolidone, d'au moins 0,1 dl/g, matière caractérisée en ce que lesdits polyimides contiennent des unités structurales répétées répondant à la formule XI:

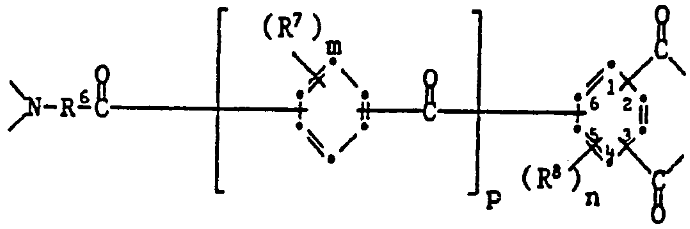
(XI)

dans laquelle $R^7$ et $R^8$ représentent chacun un halogène ou un radical nitro, aryle, aryloxy, alkyle ou alcoxy, m représente un nombre de 0 à 4, n représente un nombre de 0 à 3, p est égal à 0, à 1 ou à 2, les radicaux carbonyles libres se trouvent en position ortho l'un par rapport à l'autre et $R^6$ représente un radical aromatique bivalent qui porte au moins un radical alkyle ou un radical aralkyle.

6. Matière revêtue selon la revendication 1 dans laquelle on a utilisé, comme colle photostructurable b) thermostable travaillant en négatif, un composé ou un mélange de composés pris dans l'ensemble constitué par:

b1) des polyimides photoréticulables qui sont solubles dans des solvants organiques et qui peuvent éventuellement être associés à des polyazides organiques chromophores,

b2) des polyamide-acides ou leurs esters, photoréticulables,

b3) des poly-organosilsesquioxanes photoréticulables,

b4) des polyamide-imides photoréticulables,

b5) des systèmes époxydiques photoréticulables, et

b6) des systèmes photoréticulables contenant des composés à radicaux éthyléniques polymérisables par voie radicalaire.

7. Matière revêtue selon la revendication 6 dans laquelle on a utilisé, comme colle photostructurable b1) thermostable travaillant en négatif, une solution de polyimides ou un mélange de polyimides selon l'une quelconque des revendications 2 à 6.

8. Matière revêtue selon la revendication 6 dans laquelle on a utilisé, comme colle photostructurable b1) thermostable travaillant en négatif, des polyimides essentiellement constitués d'un homopolymère ou copolymère qui dérive d'au moins un acide tétracarboxylique aromatique et d'au moins une diamine et qui contient essentiellement de 0,1 à 100% en moles d'au moins une unité struc-turale de formule II:

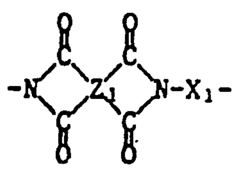
(II)

et de 99,9 à 0% en moles d'au moins une unité structurale de formules III et/ou IV:

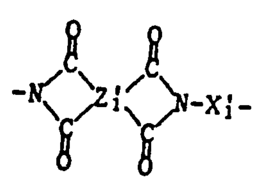
(III)

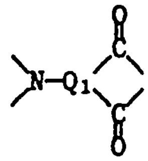
(IV),

formules dans lesquelles:

$Z^1$ représente au moins un radical quadrivalent répondant à l'une des formules V, VI, VII et VIII:

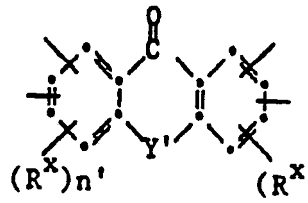 (V)

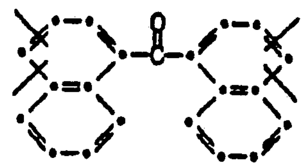 (VI)

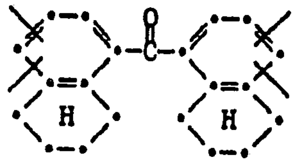 (VII)

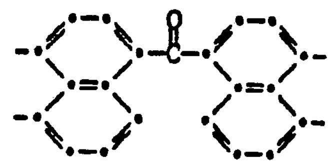 (VIII)

dans lesquelles les liaisons libres sont en ortho l'une par rapport à l'autre, Y' représente une liaison directe, $—CH_2—$, $—(CH_2)_2—$, —O—, —S—, —SO—, $—SO_2—$, —CO—, $—NR^v—$ ou $—CR^vR^W—$, le symbole $R^v$ représentant un atome d'hydrogène, un alkyle en $C_1—C_{10}$, un phényle, un naphtyle ou un radical phényl-$(C_eH_{2e})$— dont l'indice e désigne un nombre de 1 à 4 et $R^W$ ayant la signification de $R^v$ sans toutefois pouvoir représenter un atome d'hydrogène, $R^x$ représente un alkyle en $C_1—C_{10}$, un halogène, —CN, $—NO_2$, un alcoxy en $C_1—C_{12}$, un phénoxy, un naphtoxy ou un radical phényl-$(C_eH_{2e})$— dont l'indice e désigne un nombre de 1 à 4, et n' est égal à 0, à 1 ou à 2,

$X_1$ représente un radical hétérocyclique, cycloaliphatique ou araliphatique, substitué ou non, un radical aromatique dans lequel deux noyaux aryles sont unis par un radical aliphatique, un radical aromatique porteur d'au moins un radical alkyle, cycloalkyle, alcoxy, alcoxyalkyle, alkylthio, alkylthio-alkyle, hydroxyalkyle, hydroxyalcoxy, hydroxyalkylthio ou aralkyle ou un radical aromatique portant un radical alkylène lié à deux atomes de carbone voisins appartenant au radical aromatique,

$Q_1$ représente un radical aromatique trivalent,

$Z'_1$ a la même signification que $Z_1$ ou représente un radical organique quadrivalent différent de $Z_1$, et

$X'_1$ représente un radical bivalent, différent de $X_1$, provenant d'une diamine organique,

le symbole $Z_1$, dans la formule II, pouvant également représenté un radical de benzophénone quadrivalent dans le cas où des unités structurales de formule IV sont contenues.

9. Matière revêtue selon la revendication 6 dans laquelle la colle photoréticulable thermostable b1) est un mélange qui, en plus d'additifs usuels éventuels, contient:

a) un homopolyimide ou copolyimide, soluble dans des solvants organiques, qui dérive d'acides tétracarboxyliques aromatiques et de diamines aromatiques ou de diamines aromatiques et aliphatiques, et dans lequel au moins un radical aliphatique est lié, directement ou par l'intermédiaire d'un radical formant pont, à au moins une partie des radicaux d'acides tétracarboxyliques, des radicaux de diamines aromatiques ou des deux types de radicaux et/ou au moins une partie de ces radicaux contiennent, comme radical aliphatique formant pont, un radical alkylène, alkylidène, cycloalkylidène ou $Si(alkyl)_2$, et

b) au moins 0,1% en poids, par rapport à la composante polyimide, d'au moins un polyazide organique chromophore dans lequel les radicaux azido sont liés, directement ou par un radical $—SO_2—$, à des radicaux hydrocarbonés aromatiques.

10. Matière revêtue selon la revendication 9 dans laquelle l'homopolyimide ou le copolyimide est essentiellement constitué de 50 à 100% en moles d'unités structurales répétées répondant aux formules XVII et/ou XVIII:

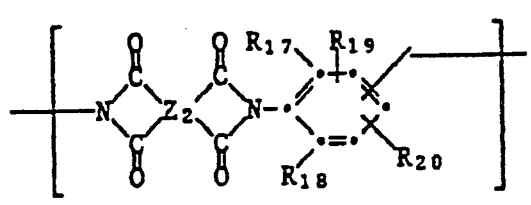 (XVII),

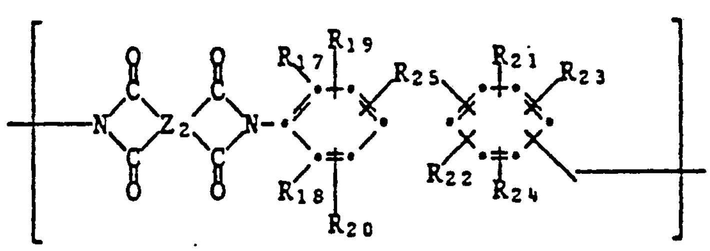 (XVIII)

et de 50 à 0% en moles d'unités structurales répétées répondant à la formule XIX:

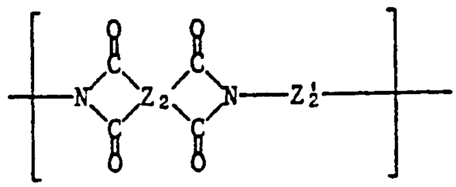

(XIX)

formules (XVII, XVIII et XIX) dans lesquelles les quatre radicaux carbonyles sont liés à des atomes de carbone différents et chacun des deux radicaux carbonyles de chacun des deux couples se trouvent en des positions ortho ou péri,

$Z_2$ représente un radical quadrivalent contenant au moins un cycle aromatique,

$Z'_2$ représente un radical organique bivalent qui est différent des radicaux:

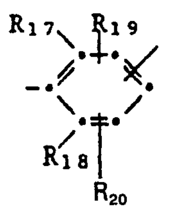

et

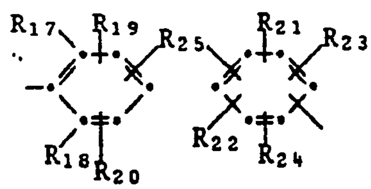

et qui est choisi parmi les radicaux aromatiques, alkylaromatiques, aliphatiques, cycloaliphatiques et hétérocycliques, les associations de ces radicaux et les radicaux comportant des ponts renfermant de l'oxygène, du soufre, de l'azote, du silicium ou du phosphore, $R^{17}$ et $R^{18}$ représentent chacun, indépendamment l'un de l'autre, un alkyle en $C_1$—$C_4$, $R_{19}$, $R_{20}$, $R_{21}$, $R_{22}$, $R_{23}$ et $R_{24}$ représentent chacun, indépendamment les uns des autres, l'hydrogène ou un alkyle en $C_1$—$C_4$, et $R_{25}$ représente la liaison directe, —O—, —S—, —$SO_2$—, —CO—, —$CH_2$—, —$C(CF_3)_2$—, un cycloalkylidène à 5 ou 6 atomes de carbone dans son cycle, un phénylène, un radical

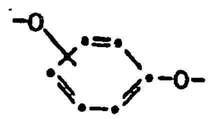

ou un radical

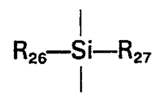

dans lequel $R_{26}$ et $R_{27}$ représentent chacun un radical alkyle ou alcoxy en $C_1$—$C_6$, un phényle, un benzyle, un phénoxy ou un benzyloxy.

11. Matière revêtue selon la revendication 6 dans laquelle l'épaisseur de la couche de colle, à l'état durci, est inférieure à 5 µm, et dans laquelle on a utilisé, comme colle photostructurable thermostable travaillant en négatif, un poly-organosilsesquioxane répondant à la formule XXXI:

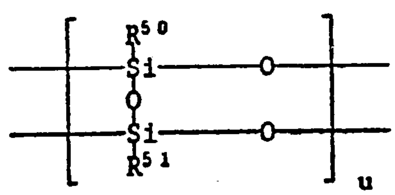

(XXXI),

dans laquelle $R^{50}$ et $R^{51}$ représentent chacun, indépendamment l'un de l'autre, un radical hydrocarboné univalent et u désigne un nombre entier supérieur à 30.

12. Matière revêtue selon la revendication 6 dans laquelle on a utilisé, comme colle photostructurable b4) thermostable travaillant en négatif, des homopolycondensats et copolycondensats linéaires saturés du

groupe des polyamideimides contenant des radicaux d'acides benzophénone-tricarboxyliques et au moins une unité structurale répétée de formule XII:

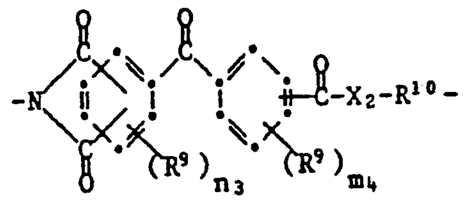

(XII)

et, dans le cas de copolycondensats, également des unités structurales de formule XIII et/ou de formule XIV:

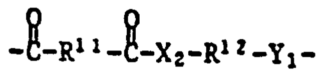

(XIII)

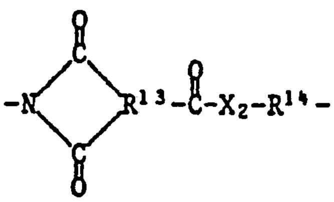

(XIV),

formules dans lesquelles:

le radical imide, dans l'unité structurale XII, est lié à deux atomes de carbone voisins,

$m_4$ désigne un nombre de 0 à 4,

$n_3$ désigne un nombre de 0 à 3,

$X_2$ représente —S—, —O— ou —$NR^{15}$—,

$Y_1$ a la même signification que $X_2$ mais indépendamment de lui,

$R^9$ représente un radical alkyle ou alcoxy contenant moins de six atomes de carbone, un aryle en $C_6$—$C_{10}$, un aralkyle en $C_7$—$C_{10}$ ou un halogène,

$R^{12}$ représente un radical aliphatique, cycloaliphatique, araliphatique ou aromatique bivalent, substitué ou non, et, dans le cas où $X_2$ et $Y_1$ représentent chacun un radical —$NR^{15}$—, le symbole $R^{12}$ et l'un des symboles $R^{15}$ représentent ensemble un alkylène en $C_5$—$C_7$ auquel le second radical —$NR^{15}$— est lié, ou $R^{12}$ représente un radical méthylène, éthylène ou propylène et les deux radicaux $R^{15}$ des radicaux —$NR^{15}$— forment ensemble un radical éthylène ou propylène, ou

$X_2$ ou $Y_1$ représente —S— ou —O— et l'autre représente un radical —$NR^{15}$—, $R^{12}$ et $R^{15}$ formant ensemble un alkylène en $C_5$—$C_7$ auquel le radical —O— ou —S— est lié,

$R^{10}$ représente un radical hydrocarboné aliphatique ou aromatique bivalent, substitué ou non,

$R^{14}$ a la même signification que $R^{10}$ mais indépendamment de lui,

$R^{11}$ représente un radical bivalent aromatique ou aliphatique saturé,

$R^{13}$ représente un radical trivalent aromatique ou aliphatique saturé sur lequel le radical imide est lié à deux atomes de carbone voisins,

$R^{15}$ représente un atome d'hydrogène ou un radical alkyle, cycloalkyle, aryle, aralkyle ou alkylaralkyle, les copolycondensats contenant les unités structurales de formule XII en une proportion d'au moins 10% en moles par rapport au copolycondensat.

13. Matière revêtue selon la revendication 6 dans laquelle on a utilisé, comme colle photostructurable b5) thermostable travaillant en négatif, des résines époxydiques photoréticulables ou des mélanges de telles résines qui contiennent:

(a) un composé aromatique, cycloaliphatique ou araliphatique contenant au moins un radical époxy-1,2, ou un mélange de tels composés,

(b) au moins un photo-amorceur convenant pour la photoréticulation de résines époxydiques, éventuellement en association avec un photo-accélérateur, et éventuellement

(c) au moins un composé aromatique, cycloaliphatique ou araliphatique utilisable comme thermodurcisseur latent.

14. Matière revêtue selon la revendication 13 dans laquelle on a utilisé, comme photo-amorceur (b), un sel d'halogénonium répondant à la formule XXXIII:

$$\left[ R^{41}R^{42}X^{a} \right]^{+}_{q_4} \quad \left[ L_2Q^{a}_{m_4} \right]^{-q_4} \qquad \text{(XXXIII)}$$

dans laquelle $R^{41}$ et $R^{42}$ représentent chacun, indépendamment l'un de l'autre, un radical aromatique carbocyclique ou hétérocyclique contenant de 6 à 20 atomes de carbone, ou $R^{41}$ et $R^{42}$ forment ensemble un radical bivalent aromatique carbocyclique ou hétérocyclique, $X^a$ représente un atome d'halogène, $m_4$ représente un nombre égal à la somme de $q_4$ et de la valence de $L_2$, $L_2$ représente un métal ou un non-métal dont la valence peut aller de 2 à 7, $Q^a$ représente un atome d'halogène et $q_4$ représente un nombre de 1 à 3.

15. Matière revêtue selon la revendication 13 dans laquelle on a utilisé, comme photo-amorceur (b), un sel d'iodosyle répondant à la formule XXXIV:

$$\left[ R^{43}R^{44}I{=}O \right]^{+}_{q_5} \left[ L_3Q^{b}_{m_5} \right]^{-q_5} \qquad \text{(XXXIV)},$$

dans laquelle $R^{43}$ et $R^{44}$ représentent chacun un radical aromatique carbocyclique ou hétérocyclique contenant de 6 à 20 atomes de carbone, $m_5$ représente un nombre égal à la somme de $q_5$ et de la valence de $L_3$, $L_3$ représente un métal ou un non-métal dont la valence peut aller de 2 à 7, $Q^b$ représente un atome d'halogène et $q_5$ représente un nombre de 1 à 3.

16. Matière revêtue selon la revendication 13 dans laquelle on a utilisé, comme photo-amorceur, un sel de sulfonium répondant à la formule XXXV:

$$\left[ R^{45}R^{46}R^{47}S \right]^{+}_{q_6} \left[ L_4Q^{c}_{m_6} \right]^{-q_6} \qquad \text{(XXXV)},$$

dans laquelle $R^{45}$, $R^{46}$ et $R^{47}$ représentent chacun, indépendamment les uns des autres, un radical aromatique carbocyclique ou hétérocyclique contenant de 6 à 20 atomes de carbone, ou l'un des symboles $R^{45}$, $R^{46}$ et $R^{47}$ représente un tel radical aromatique et les deux autres forment ensemble un radical aromatique carbocyclique ou hétérocyclique bivalent, $m_6$ représente un nombre égal à la somme de $q_6$ et de la valence de $L_4$, $L_4$ représente un métal ou un non-métal dont la valence peut aller de 2 à 7, $Q^c$ représente un atome d'halogène et $q_6$ représente un nombre de 1 à 3.

17. Matière revêtue selon la revendication 13 dans laquelle on a utilisé, comme photo-amorceur b),

I) une quantité efficace d'un sel répondant à la formule XXVIII:

$$\left[ Y_3 - Q - (CO)_{a_1} \right]^{+} MX_{4\,n_1}^{-} \qquad \text{(XXXIII)},$$

dans laquelle $Y_3$ représente un radical arène ou un radical diénylium, Q représente un atome d'un métal de transition pris dans l'ensemble constitué par le titane, le vanadium, le chrome, le manganèse, le fer, le cobalt, le nickel, le cuivre, le niobium, le molybdène, le ruthénium, le rhodium, le palladium, l'argent, le tantale, le tungstène, le rhénium, l'osmium, l'iridium, le platine et l'or, $a_1$ représente un nombre entier positif tel que l'atome Q ait une configuration de couche électronique fermée, M représente un atome d'un métal ou d'un non-métal, $n_1$ représente un nombre égal à 4, à 5 ou à 6 qui est supérieur d'une unité à la valence de M, et $X_4$ représente un atome de fluor ou de chlore, avec la condition que, lorsque M représente l'antimoine, que $n_1$ est égal à 6 et que cinq des symboles $X_4$ représentent le fluor, l'un d'eux puisse également représenter un radical hydroxo; ou

II) une quantité efficace d'un sel répondant à la formule XXIX:

$$\left[ (R^{48})\ (R^{49}Me)_{a_2} \right]^{+a_2n_2} \frac{a_2n_2}{q_2} \left[ LQ'_{m_2} \right]^{-q_2} \qquad \text{(XXIX)},$$

dans laquelle $a_2$ est égal à 1 ou à 2, $n_2$ et $q_2$ représentent chacun, indépendamment l'un de l'autre, un nombre entier de 1 à 3, Me représente le cation d'un métal bivalent ou trivalent appartenant à l'un des groupes IVb à VIIb, VIII et Ib de la classification périodique, $m_2$ représente un nombre entier égal à la somme de $q_2$ et de la valence de L, Q' représente un atome d'halogène, L représente un métal ou un non-métal dont la valence peut aller de 2 à 7, $R^{48}$ représente un arène π et $R^{49}$ représente un arène π ou l'anion d'un arène π.

18. Matière revêtue selon la revendication 17 dans laquelle on a utilisé, comme photo-amorceur b), au moins un composé du fer répondant à la formule XXX:

$$\left[ (R^{32})(R^{33}Fe^{II})_{a_3} \right]^{+a_3} \frac{a_3}{q_3} (L_1Q''_{m_3})^{-q_3} \qquad \text{(XXX)}$$

dans laquelle

$a_3$ est égal à 1 ou à 2,

$q_3$ est égal à 1, à 2 ou à 3,

$L_1$ représente un métal ou un non-métal dont la valence peut aller de 2 à 7,

Q'' représente un atome d'halogène,

$m_3$ désigne un nombre entier égal à la somme de $q_3$ et de la valence de $L_1$,

$R^{32}$ représente un arène π et

$R^{33}$ représente l'anion d'un arène π.

le composé de formule XXX étant de préférence mis en jeu en association avec au moins un accepteur d'électrons en tant qu'agent oxydant, et/ou avec un sensibilisateur pour le composé de formule XXX.

19. Matière revêtue selon la revendication 6 dans laquelle on a utilisé, comme colle b5), une résine époxydique photoréticulable et ensuite encore thermodurcissable, à base d'éthers diglycidyliques de bis-phénols, résine qui contient, en plus de radicaux époxy libres, des radicaux photoréticulables répondant à l'une des formules:

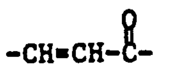 , 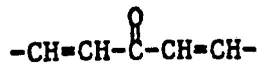 et 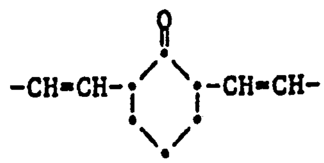

qui sont présents, en une proportion d'au moins 10% en moles par rapport aux motifs du bis-phénol, en tant que ponts entre les noyaux aromatiques du bis-phénol.

20. Matière revêtue selon la revendication 6 dans laquelle on a utilisé, comme colles b6) du groupe des composés à radicaux éthyléniques polymérisables par voie radicalaire, des mélanges pris dans l'ensemble constitué par:

A) les mélanges qui contiennent:

a) au moins un composé éthylénique polymérisable par voie radicalaire et ayant un point d'ébullition supérieur à 100°C sous la pression normale,

b) au moins un photo-amorceur organique, inorganique ou organométallique engendrant des radicaux sous l'action d'un rayonnement et

c) un liant polymère;

B) les mélanges qui contiennent:

a) des composés ou des mélanges de composés renfermant à la fois, dans une même molécule, au moins un radical époxy en position médiane et/ou au moins une unité structurale de formule XXXII:

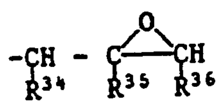 (XXXII),

dans laquelle ou bien $R^{34}$ et $R^{36}$ représentent chacun un atome d'hydrogène et $R^{35}$ représente un atome d'hydrogène ou un radical méthyle, ou bien $R^{34}$ et $R^{36}$ forment ensemble un radical $—CH_2CH_2—$ et $R^{35}$ représente un atome d'hydrogène,
qui est lié, à l'extrémité de la chaîne, directement à un atome d'oxygène ou à un atome d'azote, et au moins une double liaison éthylénique,

b) au moins un photo-amorceur engendrant des radicaux lors de l'irradiation, et

c) éventuellement des liants polymères et/ou un agent de polymérisation thermo-activable pour des résines à radicaux époxy-1,2 et/ou des photosensibilisateurs ou photo-amorceurs pour la polymérisation époxydique; et

C) les mélanges qui contiennent:

a) une résine époxydique renfermant au moins un radical époxy en position médiane et/ou au moins un radical époxy de formule XXXII tel que défini ci-dessus,

b) un composé photopolymérisable par voie radicalaire, et éventuellement

c) un durcisseur thermo-activable pour la résine époxydique.

21. Matière revêtue selon la revendication 1 dans laquelle on a utilisé un substrat a) présentant une surface diffusante et dans laquelle la couche de colle b) contient des additifs absorbant le rayonnement en une quantité telle que de la lumière diffusée latéralement à la surface du substrat ne puisse pénétrer ni dans la couche de colle b), ni dans la couche en polyimide c).

22. Procédé pour réaliser des images en relief par une méthode photolithographique, procédé qui comprend les étapes suivantes:

i) on enduit la surface d'un substrat avec une colle photostructurable thermostable travaillant en négatif, selon la revendication 6, et éventuellement on chasse le solvant par évaporation,

ii) on applique, sur la surface enduite de colle, une pellicule en polyimide photostructurable non soutenue, selon la revendication 1, éventuellement en appliquant une pression et/ou de la chaleur,

iii) on irradie l'assemblage conformément à une image au moyen d'un rayonnement actinique, du côté de la pellicule en polyimide ou du côté du substrat, et

iv) on développe le système au moyen d'un révélateur approprié pour éliminer, aux endroits non touchés par le rayonnement, aussi bien la pellicule en polyimide que la pellicule de colle.

23. Procédé pour réaliser des images en relief par une méthode photolithographie, procédé qui comprend les étapes opératoires suivantes:

i) on applique sur la surface d'un substrat le côté colle d'un système à deux couches constitué d'une colle selon la revendication 6, c'est-à-dire d'une colle photo-structurable thermostable travaillant en négatif, et d'une pellicule en polyimide photostructurable non soutenue selon la revendication 1, éventuellement en appliquant une pression et/ou de la chaleur,

ii) on irradie l'assemblage avec un rayonnement actinique, conformément à une image, du côté de la pellicule en polyimide ou du côté du substrat, et

iii) on développe le système avec un révélateur approprié pour éliminer, aux endroits qui n'ont pas été touchés par le rayonnement, aussi bien la pellicule en polyimide que la pellicule de colle.

24. Application des images en relief obtenues selon l'une des revendications 22 et 23 comme couches protectrices, isolantes et passivantes, comme diélectriques, comme masques d'arrêt de soudure ou comme couches intermédiaires (intercouches) dans des éléments semiconducteurs (discrets ou intégrés), des circuits hybrides, des plaques de conducteurs ou des multicouches.

## Claims

1. A coated material containing in successive order

a) a substrate which can carry a relief image on the surface and/or can be perforated,

b) a photostructurable negative-working thermostable adhesive and

c) a self-supporting photocrosslinkable polyimide film which has a thickness of 3—300 µm and essentially comprises a homopolyimide or copolyimide which has 5 to 100 mol%, based on the total molecule, of at least one structural element of the formula (Ia) and 95—0 mol% of at least one structural element of the formula (Ib), it being possible for the individual structural elements (Ia) and (Ib) within a given polymer molecule to be different

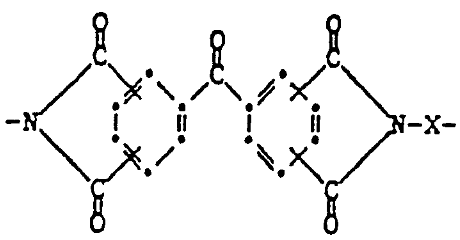 (Ia), 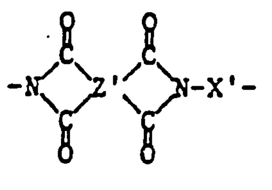 (Ib),

where the carbonyl groups in the formula (Ia) are in each case pairwise in the ortho-position relative to each other, X is the divalent radical of an aromatic diamine, Z' is a tetravalent benzophenone radical or another unsubstituted or substituted tetravalent aromatic radical to which in each case two carbonyl groups are bonded in the ortho- or periposition, and X' is defined in the same way as X, or is the divalent radical, different from X, of an organic diamine, wherein the aromatic radical of X is substituted by alkyl, alkoxy, alkoxyalkyl or aralkyl in both ortho-positions relative to at least one N atom or in at least one ortho-position relative to both N atoms, or two adjacent C atoms of the aromatic radical X are substituted by alkylene, X and X' being different when Z' is a tetravalent benzophenone radical.

2. A coated material according to claim 1, in which at least 50 mol% of the polymer, based on the total molecule, comprise structural elements of the formula (Ia), the radical Z' of the structural element of the formula (Ib) is selected from the group consisting of

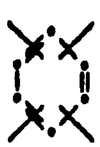 , 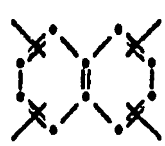 , 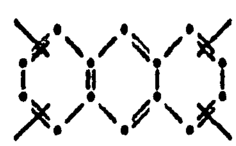

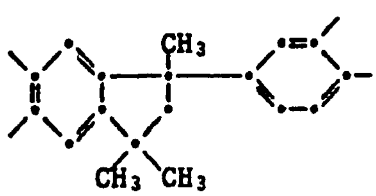 , 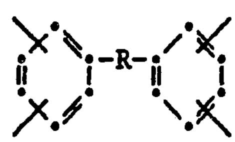 ,

where the radicals Z′ within a given molecule can be differently defined, in which R is a direct bond or a bridge group of the formulae

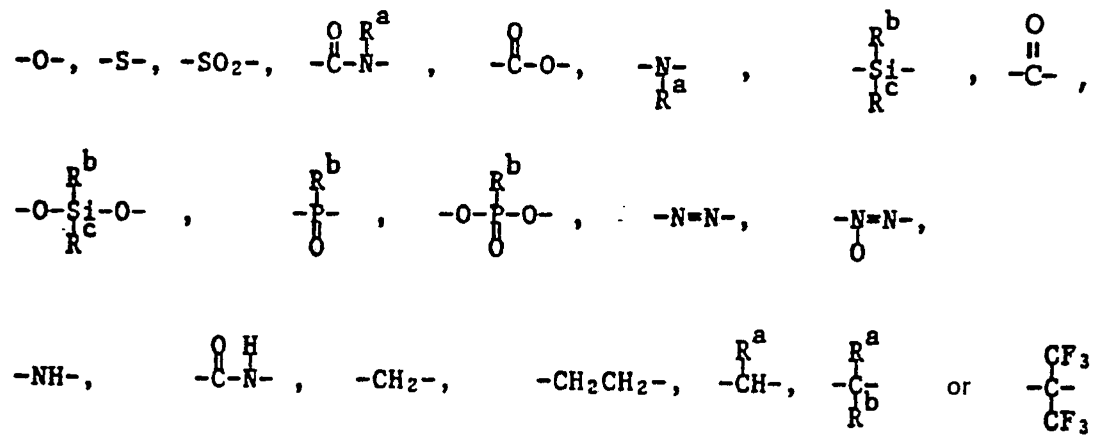

or

in which $R^a$, $R^b$ and $R^c$ are alkyl having 1 to 6 C atoms, phenyl or benzyl and $R^b$ and $R^c$ are also alkoxy having 1 to 6 C atoms, phenyloxy or benzyloxy, in which the radical X of structural element (Ia) is selected from the group of the following structures which can also be different within a given molecule

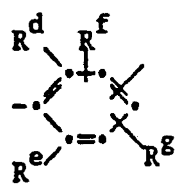 (Ic) 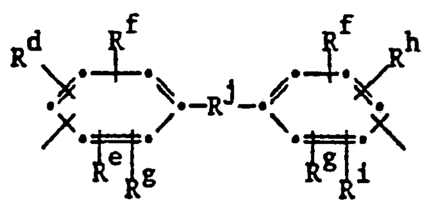 (Id)

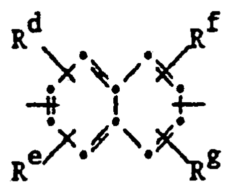 (Ie)

in which, in the formula (Ic), the free bonds are in the meta- or para-position relative to each other, in the formula (Id) the free bonds are preferably in the meta- or para-position relative to the $R^j$ group and $R^d$ and $R^e$ are bonded in the two ortho-positions relative to the free bond, and in the formula Ie the free bonds are bonded in the 2-, 3-, 6- and 7-position and $R^d$ and $R^e$ are situated in the two ortho-positions relative to the free bonds, $R^j$ is a direct bond, —O—, —S—, —SS—, —SO—, —$SO_2$—, —CO—, —COO—, —NH—, —N-alkyl having 1 to 6 C atoms in the alkyl,

|
—N-phenyl,

|
—N-benzyl,

—CONH—, —CON-alkyl having 1 to 6 C atoms in the alkyl, —CON-phenyl—, —CON-benzyl,

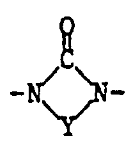 , in which Y is 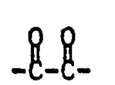 , 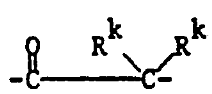 or 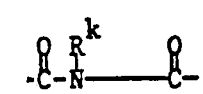 ,

$R^k$ is a hydrogen atom, $C_1$—$C_6$alkyl or phenyl, or $R^j$ is linear or branched alkylene having 1 to 3 C atoms, alkylidene which has 2 to 12 C atoms and can be substituted by Cl or F, cycloalkylidene having 5 or 6 ring carbon atoms, phenylene, phenylenedioxy, or the group

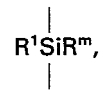

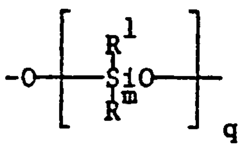 or 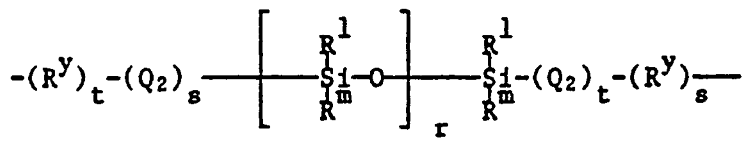 or

in which $R^1$ and $R^m$ are alkyl or alkoxy having 1 to 6 C atoms, phenyl, benzyl, phenyloxy or benzyloxy, r is a number from 1 to 10, t is 0 or 1 and s is 0 or 1, and $R^y$ is —O— or —S— and $Q_2$ is $C_1$—$C_6$alkylene, and q is a number from 1 to 100, $R^d$ and $R^e$ are alkyl or alkoxy having 1 to 12 C atoms, alkoxyalkyl having 2 to 12 C atoms, cyclopentyl, cyclohexyl or benzyl or in the formula Ic or Id $R^d$ and $R^f$ are in adjacent positions and together are trimethylene or tetramethylene, and $R^e$ can also be a hydrogen atom, $R^f$ and $R^g$ are a hydrogen atom or independently are defined in the same way as $R^d$ and $R^e$, and $R^h$ and $R^i$ are a hydrogen atom, independently are defined as $R^d$ and $R^e$ or $R^f$ and $R^h$ in the formula Id together are trimethylene or tetramethylene, and in which the radical X′ of the structural element (Ib) is defined in the same way as X or is selected from the group of structures, $C_2$—$C_{30}$alkylene, $C_5$—$C_8$cycloalkylene, $C_7$—$C_{30}$aralkylene, $C_6$—$C_{22}$arylene or polysiloxane.

3. A coated material according to claim 2, in which Z′ is a radical of the formula

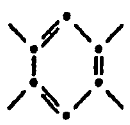 or 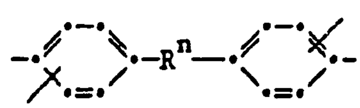 or

which can also be different within a given molecule, in which $R^n$ is a direct bond, —O—, —$SO_2$—, —$CH_2$—, —$C(CF_3)_2$ and in particular —CO—, in which the radical X is selected from the group consisting of

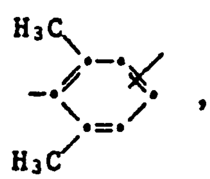 , 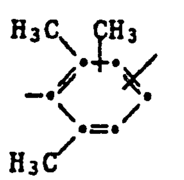 , 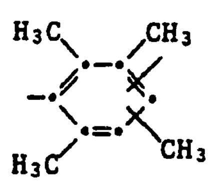

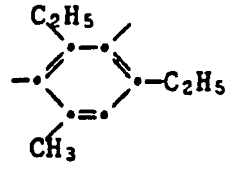 ,

in which the free bonds are in the meta- or para-position relative to each other, or of the formula

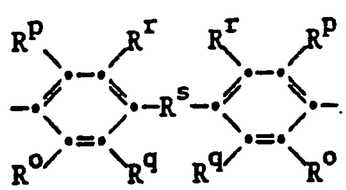 ,

where these radicals can be differently defined within a given molecule, in which $R^o$ and $R^p$ are independently methyl, ethyl, n-propyl or isopropyl and $R^q$ or $R^r$ are a hydrogen atom or are defined in the same way as $R^o$ or $R^o$ and $R^q$ are together trimethylene or tetramethylene and $R^p$ and $R^r$ are a hydrogen

atom, and $R^s$ is a direct bond, $—CH_2—$, $—C(CF_3)_2—$, 2,2-propylidene or —CO—, and in which the radical X' is defined in the same way as X or is selected from the group consisting of

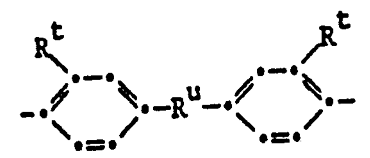

,

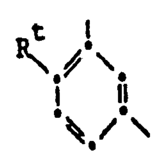

and

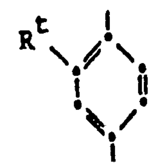

,

where these radicals can also take on different meanings within a given molecule, in which $R^u$ is a direct bond, —O—, —CO—, $—C(CF_3)_2—$ or $—CH_2—$, and $R^t$ is methyl, ethyl, isopropyl, methoxy, ethoxy or a hydrogen atom.

4. A coated material according to claim 1, in which the photocrosslinkable self-supporting polyimide film c) has a thickness of 3—300 µm and essentially comprises a homopolyimide or copolyimide having an average molecular weight of at least 2,000, which contains at least 5 mol%, based on the polymer, of at least one structural element of the formulae (IX) or (X)

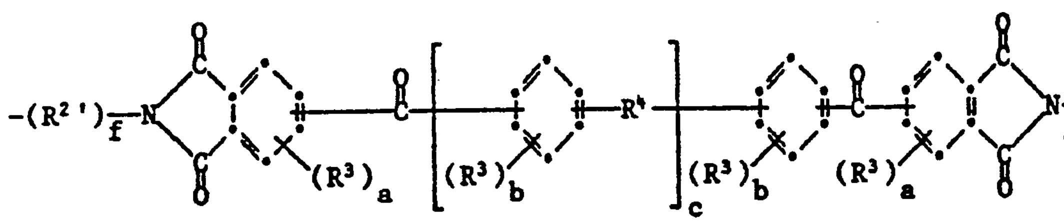

(IX)

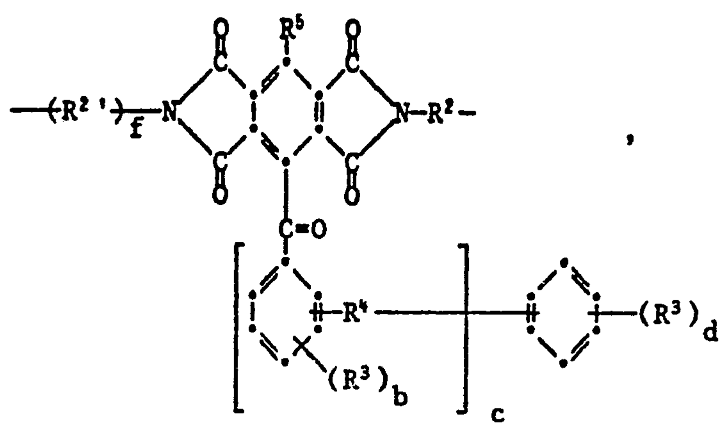

, (X)

in which

$R^3$ is halogen, nitro, $C_1$—$C_6$alkyl, $C_1$—$C_6$alkoxy, $C_1$—$C_6$alkylthio, which can be substituted by phenyl, or is phenyl, phenoxy or phenylthio,

$R^4$ is a direct bond or a bridge group,

$R^5$ is a hydrogen atom or aroyl or is defined in the same way as $R^3$,

a is 0, 1, 2 or 3, b is 0, 1, 2, 3 or 4, c and d are 0, 1, 2, 3, 4 or 5,

f is 0 or 1, and, when a, b and d are 2, the two $R^3$ together can also be —CH=CH—CH=CH— bonded in the o-position, and

$R^2$ and $R^{2'}$ are an unsubstituted or substituted cycloaliphatic or araliphatic radical, an aromatic radical where two aryl nuclei are linked via an aliphatic group, or an aromatic radical which is substituted by at least one alkyl group, cycloalkyl group, alkoxy group, alkoxyalkyl group, alkylthio group, alkylthioalkyl group, aralkyl group or, on two adjacent C atoms of the aromatic radical, by an alkylene group, $R^2$ being an aromatic radical which is substituted in the two ortho-positions relative to at least one N atom, when f is 0.

5. A coated material according to claim 1, in which the photocrosslinkable self-supporting polyimide film c) has a thickness of 3—100 µm and essentially comprises homopolyimides or copolyimides which contain structural elements of aromatic aminodicarboxylic acids, having an inherent viscosity of at least

0.1 dl/g, measured at 25°C in a solution of 0.5% by weight of polyimide in N-methylpyrrolidone, which contain recurring structural elements of the formula (XI)

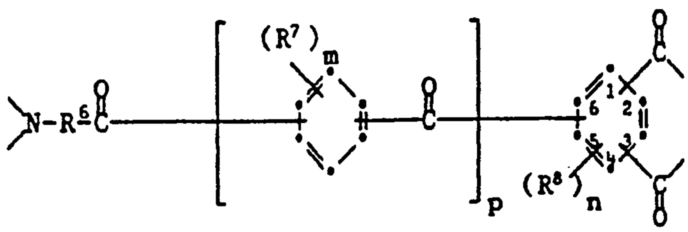

(XI)

in which $R^7$ and $R^8$ are halogen, nitro, aryl, aryloxy, alkyl or alkoxy, m is 0 or a number from 1—4, n is 0 or a number from 1 to 3 and p is 0, 1 or 2, the free carbonyl groups are bonded in ortho-position relative to each other and $R^6$ is a divalent aromatic radical which is substituted by at least one alkyl group or aralkyl group.

6. A coated material according to claim 1, in which the photostructurable negative-working thermostable adhesive b) used is a compound or a mixture of compounds selected from the group consisting of b1) photocrosslinkable polyimides which are soluble in organic solvents and which can, if desired, be present in combination with organic chromophoric polyazides; and/or b2) photocrosslinkable polyamidic acids or their esters; and/or b3) photocrosslinkable organopolysilsesquioxanes; and/or b4) photocrosslinkable polyamide-imides; and/or b5) photocrosslinkable epoxy systems; and/or b6) photocrosslinkable systems which contain compounds having ethylenically unsaturated groups which can undergo free radical polymerization.

7. A coated material according to claim 6, in which the photostructurable negative-working thermostable adhesive b1) used is a solution of polyimides or a mixture of polyimides according to claims 2 to 6.

8. A coated material according to claim 1, in which the photostructurable negative-working thermostable adhesive b1) used comprises polyimides which essentially comprise a homopolymer or copolymer which is derived from at least one aromatic tetracarboxylic acid and at least one diamine and essentially contains 0.1 to 100 mol% of at least one structural element of the formula (II)

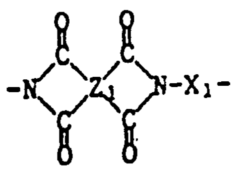

(II)

and 99.9 to 0 mol% of at least one structural element of the formula (III) and/or (IV)

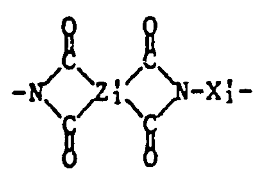

(III)

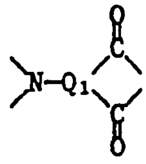

(IV),

in which

$Z_1$ is at least one tetravalent radical of the formulae (V), (VI), (VII) or (VIII)

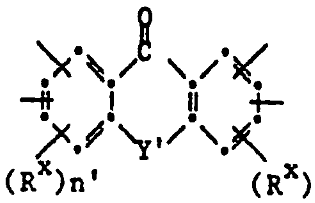 (V)

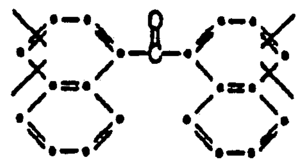 (VI)

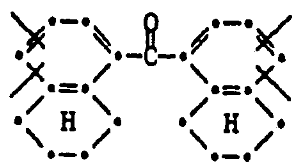 (VII)

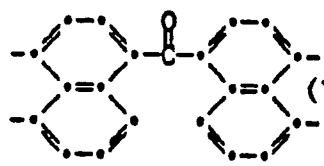 (VIII)

in which the free bonds are bonded in the ortho-position relative to each other and Y' is a direct bond, $-CH_2-$, $-(CH_2)_2-$, —O—, —S—, —SO—, $-SO_2-$, —CO—, $-NR^v-$ or $-CR^vR^w-$ where $R^v$ is a hydrogen atom, $C_1$—$C_{10}$alkyl, phenyl, naphthyl or phenyl $(C_eH_{2e})$— where e is 1 to 4 and $R^w$ is defined in the same way as $R^v$ except that it is not a hydrogen atom, $R^x$ is $C_1$—$C_{10}$alkyl, halogen, —CN, $-NO_2$, $C_1$—$C_{12}$alkoxy, phenoxy, naphthoxy, or phenyl-$(C_eH_{2e})$— where e is 1—4, n' is 0, 1 or 2,

$X_1$ is an unsubstituted or substituted heterocyclic, cycloaliphatic or araliphatic radical, an aromatic radical where two aryl nuclei are linked via an aliphatic group, or an aromatic radical which is substituted by at least one alkyl group, cycloalkyl group, alkoxy group, alkoxyalkyl group, alkylthio group, alkylthioalkyl group, hydroxyalkyl group, hydroxyalkoxy group, hydroxyalkylthio group, aralkyl group or, on two adjacent C atoms of the aromatic radical, by an alkylene group,

$Q_1$ is a trivalent aromatic radical,

$Z'_1$ is defined in the same way as $Z_1$ or is a tetravalent organic radical different from $Z_1$, and

$X'_1$ is the divalent radical, different from $X_1$, of an organic diamine,

where $Z_1$ in formula (II) can also be tetravalent benzophenone radicals if structural elements of the formula (IV) are present.

9. A coated material according to claim 1, in which the photocrosslinkable thermostable adhesive b1) is a mixture which, in addition to customary additives which can, if desired, be present, contains

a) a homopolyimide or copolyimide of aromatic tetracarboxylic acids and aromatic diamines or aromatic and aliphatic diamines which is soluble in organic solvents, at least one aliphatic group being bonded directly or via a bridge group to at least a portion of the tetracarboxylic acid radicals, of the aromatic diamine radicals or of the two radicals, and/or at least a portion of these radicals containing, as an aliphatic bridge group, alkylene, alkylidene, cycloalkylidene or $Si(alkyl)_2$, and

b) at least 0.1% by weight, based on the polyimide component, of at least one organic chromophoric polyazide in which the azide groups are bonded directly or via an $SO_2$ group to aromatic hydrocarbon radicals.

10. A coated material according to claim 9, in which the homopolyimide or copolyimide essentially comprises 50 to 100 mol% of recurring structural elements of the formulae (XVII) and/or (XVIII)

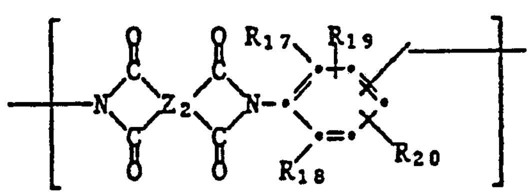 (XVII),

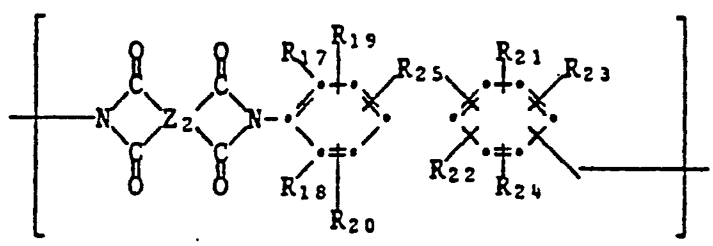 (XVIII)

and 50 to 0 mol% of recurring structural elements of the formula (XIX)

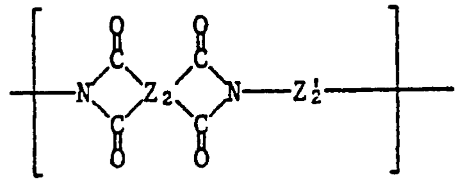 (XIX)

where in the formulae (XVII), (XVIII) and (XIX) the four carbonyl groups are bonded to different carbon atoms and two carbonyl groups each are in ortho- or peri-position relative to each other, $Z_2$ is a tetravalent radical which contains at least one aromatic ring, $Z'_2$ is a divalent organic radical which differs from the groups

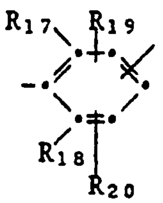 or 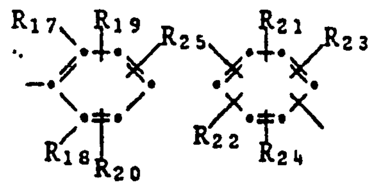

and is selected from among aromatic, alkylaromatic, aliphatic, cycloaliphatic and heterocyclic radicals, combinations thereof and radicals with oxygen-, sulfide-, nitrogen-, silicon- or phosphorus-containing bridge groups, $R_{17}$ and $R_{18}$ independently of each other are alkyl with 1—4 C atoms, $R_{19}$, $R_{20}$, $R_{21}$, $R_{22}$, $R_{23}$ and $R_{24}$ independently of one another are hydrogen or alkyl having 1—4 C atoms and $R_{25}$ is a direct bond, —O—, —S—, —$SO_2$—, —CO—, —$CH_2$—, —$C(CF_3)_2$—, cycloalkylidene having 5—6 ring carbon atoms, phenylene

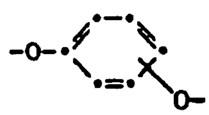 or a group

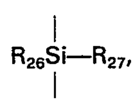

in which $R_{26}$ and $R_{27}$ are alkyl or alkoxy each having 1—6 C atoms, phenyl, benzyl, phenyloxy or benzyloxy.

11. A coated material according to claim 6, in which the thickness of the adhesive layer in the fully cured state is less than 5 µm and the photostructurable negative-working thermostable adhesive used is an organopolysilsesquioxane of the formula (XXXI)

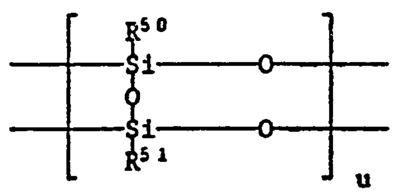 (XXXI),

in which $R^{50}$ and $R^{51}$ are independently of each other monovalent hydrocarbon radicals and u is a whole number greater than 30.

12. A coated material according to claim 6, in which the photostructurable negative-working thermostable adhesive b4) comprises linear saturated homopolycondensates or copolycondensates from the group of the polyamide-imides having benzophenonetricarboxylic acid radicals with at least one recurring structural element of the formula (XII)

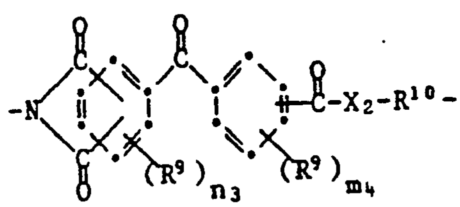 (XII)

and in the case of copolycondensates additionally recurring structural elements of the formula (XIII) and/or (XIV)

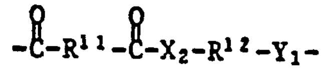 (XIII) 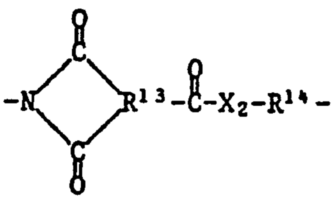 (XIV),

in which

the imide group in structural element (XII) is bonded to two adjacent C atoms,

$m_4$ is 0 or a number from 1 to 4 and

$n_3$ is 0 or a number from 1 to 3,

$X_2$ is —S—, —O— or —$NR^{15}$— and

$Y_1$ independently is defined in the same way as $X_2$,

$R^9$ is alkyl or alkoxy having fewer than 6 C atoms, aryl having 6 to 10 C atoms, aralkyl having 7 to 10 C atoms or halogen,

$R^{12}$ is an unsubstituted or substituted divalent aliphatic, cycloaliphatic, araliphatic or aromatic radical, and

if $X_2$ and $Y_1$ are the group —$NR^{15}$—, $R^{12}$ and one of the $R^{15}$ are together alkylene having 5 to 7 C atoms to which the second —$NR^{15}$— group is bonded, or $R^{12}$ is methylene, ethylene or propylene and the two $R^{15}$ of the $NR^{15}$ groups are together ethylene or propylene or $X_2$ or $Y_1$ are —S— or —O— and the other —$NR^{15}$— or $R^{12}$ and $R^{15}$ together are alkylene having 5—7 C atoms to which the group —O— or —S— is bonded,

$R^{10}$ is an unsubstituted or substituted divalent aliphatic or aromatic hydrocarbon radical,

$R^{14}$ is independently defined in the same way as $R^{10}$,

$R^{11}$ is a divalent saturated aliphatic or aromatic radical,

$R^{13}$ is a trivalent saturated aliphatic or aromatic radical in which the imide group is bonded to two adjacent C atoms and

$R^{15}$ is a hydrogen atom, alkyl, cycloalkyl, aryl, aralkyl or alkaralkyl,

the copolycondensates containing the structural elements of the formula (XII) in an amount of at least 10 mol%, based on the copolycondensate.

13. A coated material according to claim 6, in which the photostructurable negative-working thermostable adhesive b5) comprises photocrosslinkable epoxy resins or mixtures of such resins containing

(a) an aromatic, cycloaliphatic or araliphatic compound which contains at least one 1,2-epoxy group,

(b) at least one photoinitiator suitable for the photocrosslinking of epoxy resins, if desired in combination with a photoaccelerant and, if desired,

(c) at least one aromatic, cycloaliphatic or araliphatic compound usable as latent hot-curing agent.

14. A coated material according to claim 13, in which photoinitiator (b) is a halonium salt of the formula (XXXIII)

$$\left[ R^{41}R^{42}X^{a} \right]^{+}_{q_4} \quad \left[ L_2Q^{a}_{m_4} \right]^{-q_4} \qquad \text{XXXIII}$$

in which $R^{41}$ and $R^{42}$ independently of each other are a carbocyclic or heterocyclic aromatic radical having 6 to 20 C atoms or $R^{41}$ and $R^{42}$ together are a divalent carbocyclic or heterocyclic aromatic radical, $X^a$ is a halogen atom, $m_4$ is a number which is equal to the total of the valencies of $L_2$ and $q_4$, $L_2$ is a divalent to heptavalent metal or non-metal and $Q^a$ is a halogen atom, and $q_4$ is a number from 1 to 3.

15. A coated material according to claim 13, in which photoinitiator (b) is an iodosyl salt of the formula (XXXIV)

$$\left[ R^{43}R^{44}I{=}O \right]^{+}_{q_5} \quad \left[ L_3Q^{b}_{m_5} \right]^{-q_5} \qquad \text{(XXXIV)},$$

in which $R^{43}$ and $R^{44}$ are a carbocyclic or heterocyclic aromatic radical having 6 to 20 C atoms, $m_5$ is a number which is equal to the total of the valencies of $L_3$ and $q_5$, $L_3$ is a divalent to heptavalent metal or non-metal and $Q^b$ is a halogen atom, and $q_5$ is a number from 1 to 3.

16. A coated material according to claim 13, in which the photoinitiator used is a sulfonium salt of the formula (XXXV)

$$\left[ R^{45}R^{46}R^{47}S \right]^{+}_{q_6} \quad \left[ L_4Q^{c}_{m_6} \right]^{-q_6} \qquad \text{(XXXV)},$$

in which $R^{45}$, $R^{46}$ and $R^{47}$ independently of one another are a carbocyclic or heterocyclic aromatic radical having 6 to 20 C atoms or one of $R^{45}$, $R^{46}$ and $R^{47}$ is this aromatic radical and the other two together are a divalent carbocyclic or heterocyclic aromatic radical, $m_6$ is a number which is equal to the sum of the valencies of $L_4$ and $q_6$, $L_4$ is a divalent to heptavalent metal or non-metal and $Q^c$ is a halogen atom, and $q_6$ is a number from 1 to 3.

17. A coated material according to claim 13, in which photoinitiator (b) is

I) an active amount of a salt of the formula (XXVIII)

$$\left[ Y_3 - Q - (CO)_{a_1} \right]^{+} \quad MX_{4\,n_1}^{-} \qquad \text{(XXVIII)},$$

in which $Y_3$ is an arene group or dienylium group, Q is an atom of a transition metal selected from among titanium, vanadium, chromium, manganese, iron, cobalt, nickel, copper, niobium, molybdenum, ruthenium, rhodium, palladium, silver, tantalum, tungsten, rhenium, osmium, iridium, platinum and gold, $a_1$ is a positive whole number such that the atom Q has a complete electron shell configuration, M is an atom of a metal or non-metal, $n_1$ is 4, 5 or 6 and larger by unity than the valency of M and $X_4$ is a fluorine or chlorine atom, with the proviso that, when M is antimony, $n_1$ is 6 and five of the symbols $X_4$ are fluorine, and one can also be a hydroxo group; or

II) an active amount of a salt of the formula (XXIX)

$$\left[ (R^{48})\ (R^{49}Me)_{a_2} \right]^{+a_2n_2} \quad \frac{a_2n_2}{q_2} \quad \left[ LQ'_{m_2} \right]^{-q_2} \qquad \text{(XXIX)},$$

in which $a_2$ is 1 or 2 and $n_2$ and $q_2$ independently of each other are each a whole number from 1 to 3, Me is the cation of a monovalent to trivalent metal from the group (IVb) to (VIIb), (VIII) or (Ib) of the Periodic Table of Elements, $m_2$ is a whole number equal to the valency of L and $q_2$ and Q' is a halogen atom, L is a divalent to heptavalent metal or non-metal, $R^{48}$ is a π-arene and $R^{49}$ is a π-arene or the anion of a π-arene.

18. A coated material according to claim 17, in which photoinitiator (b) is at least one iron compound of the formula (XXX)

$$\left[ (R^{32})(R^{33}Fe^{II})_{a_3} \right]^{+a_3} \quad \frac{a_3}{q_3} \quad (L_1Q''_{m_3})^{-q_3} \qquad \text{(XXX)}$$

in which

$a_3$ is 1 or 2 and

$q_3$ is 1, 2 or 3,

$L_1$ is a divalent to heptavalent metal or non-metal,

Q'' is a halogen atom,

$m_3$ is a whole number which is equal to the total of the valencies of $L_1$ and $q_3$,

$R^{32}$ is a π-arene and

$R^{33}$ is the anion of a π-arene,

in which the compound of the formula (XXX) is preferably used together with at least one electron acceptor as oxidizing agent and/or together with a sensitizer for the compound of the formula (XXX).

19. A coated material according to claim 6, in which adhesive b5) is a photocrosslinkable and subsequently still heat-curable epoxy resin based on bisphenol diglycidyl ethers, which in addition to free epoxy groups also contains photocrosslinkable radicals

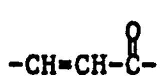 , 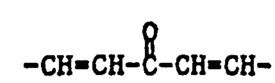 or 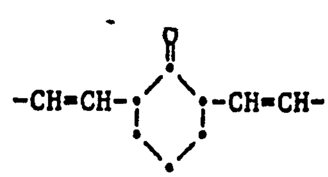

which are present in an amount of at least 10 mol%, based on the bisphenol units, as bridges between the aromatic nuclei of the bisphenol.

20. A coated material according to claim 6, in which adhesive b6) comprises mixtures from the group of compounds having ethylenically unsaturated groups which can undergo free radical polymerization, selected from the group consisting of

A) mixtures which contain

a) at least one ethylenically unsaturated compound which can undergo free radical polymerization and has a boiling point above 100°C under atmospheric pressure,

b) at least one organic, inorganic or organometallic photoinitiator which, on irradiation, forms free radicals, and

c) a polymeric binder; or

B) mixtures which contain

a) compounds or mixtures of compounds having not only at least one medial epoxy group and/or at least one structural element of the formula (XXXII),

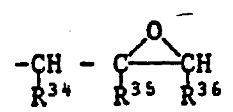

(XXXII),

which is bonded terminally directly to an oxygen atom or nitrogen atom, in which $R^{34}$ and $R^{36}$ are each a hydrogen atom, when $R^{35}$ is then a hydrogen atom or a methyl group, or $R^{34}$ and $R^{36}$ together are $—CH_2—CH_2$, when $R^{35}$ is then a hydrogen atom, but also having at least one ethylenically unsaturated double bond in a molecule,

b) at least one photoinitiator which, on irradiation, forms free radicals, and

c) if desired polymeric binders and/or a heat-activatable polymerizing agent for 1,2-epoxy resins and/or photosensitizers or photoinitiators for epoxy polymerization; or

C) mixtures which contain

a) an epoxy resin having at least one medial epoxy group and/or at least one epoxy group of the formula (XXXII), as defined above,

b) a compound which can undergo free radical photopolymerization, and if desired

c) a heat-activatable curing agent for the epoxy resin.

21. A coated material according to claim 1, in which a substrate a) has a scattering surface and in which adhesive layer b) contains radiation-absorbing additives in such an amount that light scattered laterally at the substrate surface cannot penetrate into adhesive layer b) and into polyimide layer c).

22. A process for preparing relief images by means of a photolithographic process, comprising the following steps:

i) coating a substrate surface with a photostructurable negative-working thermostable adhesive according to claim 6 and, where appropriate, evaporating the solvent,

ii) applying a self-supporting photostructurable polyimide film according to claim 1 to the adhesive-coated surface, if desired by employing pressure and/or heat

iii) image-wise exposure of the arrangement with actinic radiation from the side of the polyimide film or of the substrate, and

iv) developing the system with a suitable developer in order to remove in the unexposed areas both the polyimide film and the adhesive film.

23. A process for preparing relief images by means of a photolithographic process, comprising the following steps:

i) coating a substrate surface with the adhesive side of a two-layer system comprising photostructurable negative-working thermostable adhesive according to claim 6 and self-supporting photostructurable polyimide film according to claim 1, by employing if desired pressure and/or heat,

ii) image-wise exposure of the arrangement with actinic radiation from the side of the polyimide film or of the substrate and

iii) developing the system with a suitable developer in order to remove in the unexposed areas the polyimide film and the adhesive film.

24. Use of the relief images obtained according to claims 22 or 23, as protective, insulating and passivating layers, as dielectrics, as soldering masks or as interlayers in discrete or integrated semiconductor components, hybrid circuits, circuit boards or multilayers.